# EUROPÄISCHE PATENTSCHRIFT

(11) **EP 2 493 906 B1**
(45) Veröffentlichungstag und Bekanntmachung des Hinweises auf die Patenterteilung: **21.10.2015**
(21) Anmeldenummer: 10778919.0
(22) Anmeldetag: 28.10.2010
(51) Int. Cl.: C07F 15/00, H01L 51/00, H01L 51/50

(54) **HETEROLEPTISCHE CARBEN-KOMPLEXE UND DEREN VERWENDUNG IN DER ORGANISCHEN ELEKTRONIK**
HETEROLEPTIC CARBEN COMPLEXES AND THEIR USE IN ORGANIG ELECTRONICS
COMPOSEES COORDINATIVES HETEROLEPTIQUES DU TYPE CARBEN ET LEUR USAGE DANS ELECTRONIQUE ORGANIQUE

(30) Priorität: 28.10.2009 US 255499 P
(43) Veröffentlichungstag der Anmeldung: 05.09.2012
(73) Patentinhaber: BASF SE, 67056 Ludwigshafen (DE); OSRAM Opto Semiconductors GmbH, 93055 Regensburg (DE); Koninklijke Philips N.V., 5656 AE Eindhoven (NL); Philips Intellectual Property & Standards, 20099 Hamburg (DE)
(72) Erfinder: FUCHS, Evelyn, 68199 Mannheim (DE); LANGER, Nicolle, 64646 Heppenheim (DE); MOLT, Oliver, 69469 Weinheim (DE); DORMANN, Korinna, 67098 Bad Dürkheim (DE); GEßNER, Thomas, 69120 Heidelberg (DE); LENNARTZ, Christian, 67105 Schifferstadt (DE); WATANABE, Soichi, 68165 Mannheim (DE); SCHILDKNECHT, Christian, 68307 Mannheim (DE); WAGENBLAST, Gerhard, 67157 Wachenheim (DE); QU, Jianqiang, 200240 Shanghai (CN); MÜNSTER, Ingo, 67459 Böhl-Iggelheim (DE); SCHMID, Günter, 91334 Hemhofen (DE); BOERNER, Herbert Friedrich, 52076 Aachen (DE); VAN ELSBERGEN, Volker, 52080 Aachen (DE)
(74) Vertreter: Hollah, Dorothee
(86) Internationale Anmeldenummer: PCT/EP2010/066400
(87) Internationale Veröffentlichungsnummer: WO 2011/051404

(56) Entgegenhaltungen:
- WO-A1-2006/121811
- WO-A1-2008/054584

## Beschreibung

Die vorliegende Erfindung betrifft heteroleptische Komplexe umfassend eine über eine Carbenbindung an ein Zentralmetallatom gebundene Phenylimidazol- oder Phenyltriazol Einheit, und Phenylimidazol-Liganden, die über eine Stickstoff-Metall-Bindungen an das Zentralatom angebunden sind, OLEDs, die solche heteroleptischen Komplexe enthalten, Licht-emittierende Schichten, enthaltend wenigstens einen solchen heteroleptischen Komplex, eine Vorrichtung ausgewählt aus der Gruppe bestehend aus Beleuchtungselementen, stationären Bildschirmen und mobilen Bildschirmen enthaltend eine solche OLED, die Verwendung eines solchen heteroleptischen Komplexes in OLEDs, beispielsweise als Emitter, Matrixmaterial, Ladungstransportmaterial und/oder Ladungsblocker.

In organischen Leuchtdioden *(Organic Light Emitting Diode, OLED)* wird die Eigenschaft von Materialien ausgenutzt, Licht zu emittieren, wenn sie durch elektrischen Strom angeregt werden. OLEDs sind insbesondere interessant als Alternative zu Kathodenstrahlröhren und Flüssigkristalldisplays zur Herstellung von Flachbildschirmen. Aufgrund der sehr kompakten Bauweise und des intrinsisch niedrigen Stromverbrauchs eignen sich Vorrichtungen enthaltend OLEDs insbesondere für mobile Anwendungen, z. B. für Anwendungen in Handys, Laptops usw. Des Weiteren bieten weiße OLEDs große Vorteile gegenüber den bisher bekannten Beleuchtungstechnologien insbesondere eine besonders hohe Effizienz.

Es werden im Stand der Technik zahlreiche Materialien, beispielsweise auch heteroleptische Komplexe mit Iridium als Zentralmetallatom, vorgeschlagen, die bei Anregung durch elektrischen Strom Licht emittieren.

In WO 2006/121811 A1 werden phosphoreszente heteroleptische Metallkomplexe offenbart, die Carben-Liganden enthalten. Die in WO 2006/121811 A1 genannten Komplexe, beispielsweise Iridium-Komplexe, weisen durchweg Benzimidazolcarbene (Benzimidazolylidene) als Carbenliganden auf. Verbindungen, die Imidazolcarbene (Imidazolylidene) oder Triazolcarbene (Triazolylidene) als Liganden aufweisen, werden in WO 2006/121811 A1 nicht offenbart.

WO 2006/067074 A1 offenbart ebenfalls elektrolumineszente heteroleptische Metallkomplexe mit Carbenliganden. Als Nichtcarbenliganden werden u.a. Arylpyridine, Arylpyrazole und Aryltriazole eingesetzt. Ein Einsatz von 2-Phenyl-1 H-Imidazolen als Nichtcarbenliganden wird in WO 2006/067074 A1 nicht offenbart.

WO 2007/115981 offenbart heteroleptische Metallkomplexe enthaltend sowohl Carbenliganden als auch heterocyclische Nicht-Carbenliganden, ein Verfahren zu deren Herstellung, sowie die Verwendung dieser Verbindungen in OLEDs. Die exemplarisch in WO 2007/115981 offenbarten Verbindungen enthalten keine Kombination eines 2-Phenyl-1 H-Imidazol-Liganden mit einem Imidazolcarben- (Imidazolyliden-)Liganden oder einem Triazolcarben- (Triazolyliden-)Liganden.

JP 2009057505 offenbart optoelektronische Bauteile, die Verbindungen mit einstellbarer Emissionswellenlänge, hoher Lichtemissions-Effizienz und langer Lebensdauer enthalten. Die Bauteile gemäß dieser Schrift enthalten Metallkomplexe, die neben zwei gegebenenfalls miteinander verbundenen Liganden wenigstens einen Liganden enthalten, die zum einen über eine Carbenbindung und zum anderen über eine Nicht-Carbenbindung an das Metallatom angebunden sind. Es ist keine Kombination eines 2-Phenyl-1 H-Imidazol-Liganden mit einem Imidazolcarben- (Imidazolyliden-)Liganden oder einem Triazolcarben- (Triazolyliden-)Liganden offenbart.

Obwohl bereits Verbindungen, beispielsweise Iridium-Komplexe, bekannt sind, die im sichtbaren, insbesondere im roten, grünen und insbesondere blauen Bereich des elektromagnetischen Spektrums Elektrolumineszenz zeigen, ist die Bereitstellung von alternativen Verbindungen, die hohe Quantenausbeuten besitzen und lange Diodenlebensdauern zeigen, wünschenswert. Im Rahmen der vorliegenden Erfindung wird unter Elektrolumineszenz sowohl Elektrofluoreszenz als auch Elektrophosphoreszenz verstanden.

Aufgabe der vorliegenden Erfindung ist daher die Bereitstellung von alternativen Iridium- und Platin-Komplexen, die zur Elektrolumineszenz im sichtbaren, insbesondere im blauen, roten und grünen Bereich des elektromagnetischen Spektrums geeignet sind, wodurch die Herstellung von Vollfarben-Displays und weißen OLEDs ermöglicht wird. Des Weiteren ist es eine Aufgabe der vorliegenden Erfindung, entsprechende Komplexe bereitzustellen, die als Mischung mit einer Wirtverbindung (Matrixmaterial) oder in Substanz, d. h. in Abwesenheit von Wirtsubstanzen, als Licht-emittierende Schicht in OLEDs eingesetzt werden können. Des Weiteren ist es eine Aufgabe entsprechende Komplexe bereitzustellen, die eine hohe Quantenausbeute sowie eine hohe Stabilität in Dioden aufweisen. Die Komplexe sollen als Emitter, Matrixmaterial, Ladungstransportmaterial, insbesondere Lochtransportmaterial, oder Ladungsblocker in OLEDs einsetzbar sein.

Diese Aufgaben werden erfindungsgemäß gelöst durch heteroleptische Komplexe der allgemeinen Formel (I)

Diese Aufgaben werden erfindungsgemäß gelöst durch heteroleptische Komplexe der allgemeinen Formel (I) 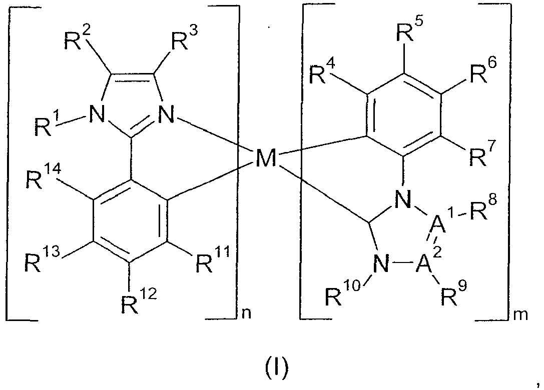 worin M, A¹, A², n, m, R¹, R², R³, R⁴, R⁵, R⁶, R⁷, R⁸, R⁹, R¹⁰ R¹¹, R¹², R¹³ und R¹⁴ die folgenden Bedeutungen aufweisen (Ausführungsform 1):
- M: Ir,
- A¹, A²: C,
- n, m: unabhängig voneinander 1 oder 2, wobei die Summe von n und m 3 beträgt,
- R¹: linearer oder verzweigter Alkylrest mit 1 bis 20 Kohlenstoffatomen, substituierter oder unsubstituierter Arylrest mit 6 bis 30 Kohlenstoffatomen, substituierter oder unsubstituierter Heteroarylrest mit 5 bis 18 Kohlenstoff-und/oder Heteroatomen,
- R², R³: unabhängig voneinander Wasserstoff, linearer oder verzweigter Alkylrest mit 1 bis 20 Kohlenstoffatomen, substituierter oder unsubstituierter Arylrest mit 6 bis 30 Kohlenstoffatomen, substituierter oder unsubstituierter Heteroarylrest mit 5 bis 18 Kohlenstoff- und/oder Heteroatomen,
- R⁴, R⁵,:
- R⁶, R⁷: Wasserstoff,
und
R⁴ und R⁵ oder R⁵ und R⁶ und/oder R⁶ und R⁷ bilden zusammen einen Cyclus der allgemeinen Formel (IIa) oder (IIb) 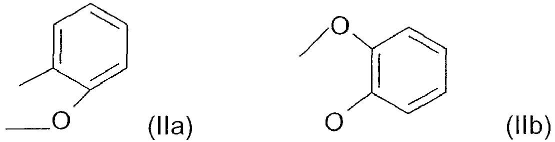
- R⁸, R⁹: Wasserstoff,
- R¹⁰: linearer oder verzweigter Alkylrest mit 1 bis 20 Kohlenstoffatomen oder substituierter oder unsubstituierter Arylrest mit 6 bis 30 Kohlenstoffatomen,
- R¹¹, R¹², R¹³, R¹⁴: unabhängig voneinander Wasserstoff oder linearer oder verzweigter Alkylrest mit 1 bis 20 Kohlenstoffatomen,
und/oder
R¹ und R¹⁴ bilden zusammen eine gesättigte oder ungesättigte, lineare oder verzweigte, gegebenenfalls Heteroatome, aromatische Einheiten, heteroaromatische Einheiten und/oder funktionelle Gruppen enthaltende Verbrückung mit insgesamt 1 bis 30 Kohlenstoff- und/oder Heteroatomen, an die gegebenenfalls ein substituierter oder unsubstituierter, fünf- bis achtgliedriger, Kohlenstoff- und/oder Heteroatome enthaltender Ring, bevorzugt ein sechsgliedriger aromatischer Ring, annelliert ist,
und/oder
R⁷ und R⁸ bilden zusammen eine gesättigte oder ungesättigte, lineare oder verzweigte, gegebenenfalls Heteroatome, aromatische Einheiten, heteroaromatische Einheiten und/oder funktionelle Gruppen enthaltende Verbrückung mit insgesamt 1 bis 30 Kohlenstoff- und/oder Heteroatomen, an die gegebenenfalls ein substituierter oder unsubstituierter, fünf- bis achtgliedriger, Kohlenstoff- und/oder Heteroatome enthaltender Ring, bevorzugt ein sechsgliedriger aromatischer Ring, anelliert ist.

Des Weiteren werden diese Aufgaben erfindungsgemäß gelöst durch heteroleptische Komplexe der allgemeinen Formel (I),
worin M, A¹, A², n, m, R¹, R², R³, R⁴, R⁵, R⁶, R⁷, R⁸, R⁹, R¹⁰, R¹¹, R¹², R¹³, und R¹⁴ die folgenden Bedeutungen aufweisen (Ausführungsform 2):
- M: Ir,
- A¹, A²: N oder C, wobei A¹ = N und A² = C bedeutet,
- n, m: unabhängig voneinander 1 oder 2, wobei die Summe von n und m 3 beträgt,
- R¹: linearer oder verzweigter Alkylrest mit 1 bis 20 Kohlenstoffatomen, substituierter oder unsubstituierter Arylrest mit 6 bis 30 Kohlenstoffatomen, substituierter oder unsubstituierter Heteroarylrest mit 5 bis 18 Kohlenstoff-und/oder Heteroatomen,
- R², R³: unabhängig voneinander Wasserstoff, linearer oder verzweigter Alkylrest mit 1 bis 20 Kohlenstoffatomen, substituierter oder unsubstituierter Arylrest mit 6 bis 30 Kohlenstoffatomen, substituierter oder unsubstituierter Heteroarylrest mit 5 bis 18 Kohlenstoff- und/oder Heteroatomen,
- R⁴, R⁵, R⁶, R⁷: Wasserstoff,
oder
R⁴ und R⁵ oder R⁵ und R⁶ und/oder R⁶ und R⁷ bilden zusammen einen gegebenenfalls von wenigstens einem Heteroatom unterbrochenen gesättigten, ungesättigten oder aromatischen Kohlenstoffring mit insgesamt 5 bis 30 Kohlenstoff- oder Heteroatomen,
- R⁸, R⁹: unabhängig voneinander freies Elektronenpaar, falls A¹ bzw. A² gleich N, oder, falls A¹ bzw. A² gleich C, Wasserstoff, linearer oder verzweigter Alkylrest mit 1 bis 20 Kohlenstoffatomen, substituierter oder unsubstituierter Arylrest mit 6 bis 30 Kohlenstoffatomen, substituierter oder unsubstituierter Heteroarylrest mit 5 bis 18 Kohlenstoff- und/oder Heteroatomen,
- R¹⁰: linearer oder verzweigter Alkylrest mit 1 bis 20 Kohlenstoffatomen, substituierter oder unsubstituierter Arylrest mit 6 bis 30 Kohlenstoffatomen und
- R¹¹, R¹², R¹³, R¹⁴: Wasserstoff oder linearer oder verzweigter Alkylrest mit 1 bis 20 Kohlenstoffatomen,
und/oder
R¹ und R¹⁴ bilden zusammen eine gesättigte oder ungesättigte, lineare oder verzweigte, gegebenenfalls Heteroatome, aromatische Einheiten, heteroaromatische Einheiten und/oder funktionelle Gruppen enthaltende Verbrückung mit insgesamt 1 bis 30 Kohlenstoff- und/oder Heteroatomen, an die gegebenenfalls ein substituierter oder unsubstituierter, fünf- bis achtgliedriger, Kohlenstoff- und/oder Heteroatome enthaltender Ring, bevorzugt ein sechsgliedriger aromatischer Ring, annelliert ist.

Im Sinne der vorliegenden Erfindung haben die Begriffe Arylrest, -einheit oder -gruppe, Heteroarylrest, -einheit oder -gruppe, Alkylrest, -einheit oder -gruppe und Cycloalkylrest, -einheit oder -gruppe die folgenden Bedeutungen- soweit keine anderen Bedeutungen angegeben sind:
Unter einem Arylrest oder -gruppe ist ein Rest mit einem Grundgerüst von 6 bis 30 Kohlenstoffatomen, bevorzugt 6 bis 18 Kohlenstoffatomen zu verstehen, der aus einem aromatischen Ring oder mehreren kondensierten aromatischen Ringen aufgebaut ist. Geeignete Grundgerüste sind zum Beispiel Phenyl, Benzyl, Naphthyl, Anthracenyl oder Phenanthrenyl. Dieses Grundgerüst kann unsubstituiert sein, d. h., dass alle Kohlenstoffatome, die substituierbar sind, Wasserstoffatome tragen, oder an einer, mehreren oder allen substituierbaren Positionen des Grundgerüsts substituiert sein. Geeignete Substituenten sind zum Beispiel Alkylreste, bevorzugt Alkylreste mit 1 bis 8 Kohlenstoffatomen, besonders bevorzugt Methyl, Ethyl, i-Propyl oder t-Butyl, Arylreste, bevorzugt C₆-Arylreste, die wiederum substituiert oder unsubstituiert sein können, Heteroarylreste, bevorzugt Heteroarylreste, die mindestens ein Stickstoffatom enthalten, besonders bevorzugt Pyridylreste, Alkenylreste, bevorzugt Alkenylreste, die eine Doppelbindung tragen, besonders bevorzugt Alkenylreste mit einer Doppelbindung und 1 bis 8 Kohlenstoffatomen, oder Gruppen mit Donor- oder Akzeptorwirkung. Unter Gruppen mit Donorwirkung sind Gruppen zu verstehen, die einen +I- und/oder +M-Effekt aufweisen, und unter Gruppen mit Akzeptorwirkung sind Gruppen zu verstehen, die einen -I-und/oder -M-Effekt aufweisen. Geeignete Gruppen, mit Donor- oder Akzeptorwirkung sind Halogenreste, bevorzugt F, Cl, Br, besonders bevorzugt F, Alkylreste, Alkoxyreste, Aryloxyreste, Carbonylreste, Esterreste, Aminreste, Amidreste, CH₂F-Gruppen, CHF₂-Gruppen, CF₃-Gruppen, CN-Gruppen, Thiogruppen oder SCN-Gruppen. Ganz besonders bevorzugt tragen die Arylreste Substituenten ausgewählt aus der Gruppe bestehend aus Methyl, Ethyl, *iso*-Propyl, *n*-Propyl, *n*-Butyl, *iso*-Butyl, tert-Butyl, Aryloxy, Amin, Thiogruppen und Alkoxy, oder die Arylreste sind unsubstituiert. Bevorzugt ist der Arylrest oder die Arylgruppe ein C₆-Arylrest, der gegebenenfalls mit mindestens einem der vorstehend genannten Substituenten substituiert ist. Besonders bevorzugt weist der C₆-Arylrest keinen, einen, zwei oder drei der vorstehend genannten Substituenten auf.

Unter einem Heteroarylrest oder einer Heteroarylgruppe sind Reste mit 5 bis 30 Kohlenstoff- und/oder Heteroatomen zu verstehen, die sich von den vorstehend genannten Arylresten dadurch unterscheiden, dass in dem Grundgerüst der Arylreste mindestens ein Kohlenstoffatom durch ein Heteroatom ersetzt ist. Bevorzugte Heteroatome sind N, O und S. Ganz besonders bevorzugt sind ein oder zwei Kohlenstoffatome des Grundgerüsts der Arylreste durch Heteroatome ersetzt. Insbesondere bevorzugt ist das Grundgerüst ausgewählt aus elektronenarmen Systemen wie Pyridyl, Pyrimidyl, Pyrazyl und Triazolyl, und fünfgliedrigen Heteroaromaten wie Pyrrol, Furan, Thiophen, Imidazol, Pyrazol, Triazol, Oxazol und Thiazol. Das Grundgerüst kann an einer, mehreren oder allen substituierbaren Positionen des Grundgerüsts substituiert sein. Geeignete Substituenten sind dieselben, die bereits bezüglich der Arylgruppen genannt wurden.

Unter einem Alkylrest oder einer Alkylgruppe ist ein Rest mit 1 bis 20 Kohlenstoffatomen, bevorzugt 1 bis 10 Kohlenstoffatomen, besonders bevorzugt 1 bis 8 Kohlenstoffatomen zu verstehen. Dieser Alkylrest kann verzweigt oder unverzweigt sein und gegebenenfalls mit einem oder mehreren Heteroatomen, bevorzugt N, O oder S unterbrochen sein. Des Weiteren kann dieser Alkylrest mit einem oder mehreren der bezüglich der Arylgruppen genannten Substituenten substituiert sein. Es ist ebenfalls möglich, dass der Alkylrest eine oder mehrere Arylgruppen trägt. Dabei sind alle der vorstehend aufgeführten Arylgruppen geeignet. Besonders bevorzugt sind die Alkylreste ausgewählt aus der Gruppe bestehend aus Methyl, Ethyl, i-Propyl, n-Propyl, i-Butyl, n-Butyl, t-Butyl, sec-Butyl, i-Pentyl, n-Pentyl, sec-Pentyl, neo-Pentyl, n-Hexyl, i-Hexyl und sec-Hexyl. Ganz besonders bevorzugt sind Methyl, i-Propyl, tert-Butyl.

Unter einem Cycloalkylrest oder einer Cycloalkylgruppe ist ein cyclischer Rest mit 3 bis 20 Kohlenstoffatomen, bevorzugt 3 bis 10 Kohlenstoffatomen, besonders bevorzugt 3 bis 8 Kohlenstoffatomen zu verstehen. Dieser Cycloalkylrest kann gegebenenfalls mit einem oder mehreren Heteroatomen, bevorzugt N, O oder S unterbrochen sein. Des Weiteren kann dieser Cycloalkylrest unsubstituiert oder substituiert sein, d. h. mit einem oder mehreren der bezüglich der Arylgruppen genannten Substituenten substitunem oder mehreren der bezüglich der Acrylgruppen genannten Substituenten substituiert sein. Es ist ebenfalls möglich, dass der Cycloalkylrest eine oder mehrere Arylgruppen trägt. Dabei sind alle der vorstehend aufgeführten Arylgruppen geeignet.

Das bezüglich der Aryl-, Heteroaryl Alkylreste und Cycloalkylreste Gesagte trifft erfindungsgemäß unabhängig voneinander auf die in der vorliegenden Anmeldung genannten Reste, insbesondere R¹, R², R³, R⁴, R⁵, R⁶, R⁷, R⁸, R⁹, R¹⁰, R¹¹, R¹², R¹³ und R¹⁴ zu, wobei R⁸ und R⁹ für den Fall, dass A¹ und/oder A² gleich N ist, ein freies Elektronenpaar bedeuten, d. h., dass an diesen Ring-Stickstoffatomen kein Substituent ausgewählt aus der oben genannten Gruppe vorliegt. Für den Fall, dass A¹ und/oder A² gleich C ist, liegen als R⁸ und R⁹ unabhängig voneinander Wasserstoff und/oder die genannten Substituenten vor.

In einer bevorzugten Ausführungsform weisen M, A¹, A², n, m, R¹, R², R³, R⁴, R⁵, R⁶, R⁷, R⁸, R⁹, R¹⁰, R¹¹, R¹², R¹³ und R¹⁴ die folgenden Bedeutungen auf:
M bedeutet erfindungsgemäß Ir. Ir liegt in den erfindungsgemäßen heteroleptischen Komplexen in der Oxidationsstufe +3 vor.

In Ausführungsform 1 bedeuten sowohl A¹ als auch A² C, d. h. die erfindungsgemäßen heteroleptischen Komplexe enthalten wenigstens eine über eine Metall-CarbenBindung angebundene Phenylimidazol-Einheit.

In Ausführungsform 2 bedeuten A¹ und A² N oder C, wobei A¹ = N und A² = C bedeutet. In dieser Ausführungsform enthalten die erfindungsgemäßen heteroleptischen Komplexe wenigstens eine über eine Metall-Carben-Bindung angebundene Phenyltriazol-Einheit.

n und m bedeuten unabhängig voneinander 1 oder 2, wobei die Summe von n und m 3 beträgt. Bevorzugt ist n = 2 und m = 1.

R¹ bedeutet einen linearen oder verzweigten Alkylrest mit 1 bis 20 Kohlenstoffatomen, einen substituierten oder unsubstituierten

Arylrest mit 6 bis 30 Kohlenstoffatomen, einen substituierten oder unsubstituierten Heteroarylrest mit 5 bis 18 Kohlenstoff- und/oder Heteroatomen.

Besonders bevorzugt ist R¹ ein substituierter oder unsubstituierter Arylrest mit 6 bis 30 Kohlenstoffatomen, ganz besonders bevorzugt ein substituierter, insbesondere in ortho,ortho'- oder ortho,ortho',para-Position substituierter, oder unsubstituierter Phenylrest. Die Subsitituenten sind bevorzugt Alkylreste mit 1 bis 10, insbesondere 1 bis 6, Kohlenstoffatomen, beispielsweise Methyl, Ethyl, Propyl, Butyl. Ganz besonders bevorzugte Reste R¹ sind Phenyl, 2,6-Dimethyl-phenyl, 2,6-Di-*iso*-propyl-phenyl oder 2,4,6-Trimethylphenyl, d. h. Mesityl.

Die vorliegende Erfindung betrifft daher insbesondere einen erfindungsgemäßen heteroleptischen Komplex, wobei R¹ ein Arylrest mit 6 bis 30 Kohlenstoffatomen ist, der in ortho,ortho'-Position jeweils mit einem linearen oder verzweigten Alkylrest mit 1 bis 10 Kohlenstoffatomen substituiert ist.

R², R³ bedeuten unabhängig voneinander Wasserstoff, einen linearen oder verzweigten Alkylrest mit 1 bis 20 Kohlenstoffatomen, einen substituierten oder unsubstituierten Arylrest mit 6 bis 30 Kohlenstoffatomen, einen substituierten oder unsubstituierten Heteroarylrest mit 5 bis 18 Kohlenstoff- und/oder Heteroatomen.

In Ausführungsform 2 bedeuten R⁴, R⁵, R⁶, R⁷ Wasserstoff oder R⁴ und R⁵ oder R⁵ und R⁶ oder R⁶ und R⁷, insbesondere R⁵ und R⁶ oder R⁶ und R⁷, bilden zusammen einen gegebenenfalls von wenigstens einem Heteroatom unterbrochenen gesättigten, ungesättigten oder aromatischen Kohlenstoffring mit insgesamt 6 bis 30 Kohlenstoffatomen.

In Ausführungsform 1 des erfindungsgemäßen heteroleptischen Komplexes bedeuten R⁴, R⁵, R⁶, R⁷ Wasserstoff und R⁴ und R⁵ oder R⁵ und R⁶ oder R⁶ und R⁷ bilden zusammen einen Cyclus der allgemeinen Formel (IIa) oder (IIb)

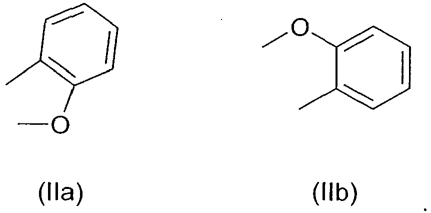

R⁸, R⁹ bedeuten in Ausführungsform 2 unabhängig voneinander freies Elektronenpaar, falls A¹ bzw. A² gleich N, oder, falls A¹ bzw. A² gleich C sind, Wasserstoff oder linearer oder verzweigter Alkylrest mit 1 bis 20 Kohlenstoffatomen, substituierter oder unsubstituierter Arylrest mit 6 bis 30 Kohlenstoffatomen oder substituierter oder unsubstituierter Heteroarylrest mit 5 bis 18 Kohlenstoff- und/oder Heteroatomen, ganz besonders bevorzugt Phenylrest.

In Ausführungsform 1 bedeuten R³, R⁹ Wasserstoff.

R¹⁰ bedeutet einen linearen oder verzweigten Alkylrest mit 1 bis 20 Kohlenstoffatomen, besonders bevorzugt mit 1 bis 6 Kohlenstoffatomen, oder einen substituierten oder unsubstituierter Arylrest mit 6 bis 30 Kohlenstoffatomen, besonders bevorzugt mit 6 bis 10 Kohlenstoffatomen. Beispiele für besonders bevorzugte Alkylreste für R¹⁰ sind Methyl, Ethyl, Propyl, insbesondere iso-Propyl, Butyl, insbesondere tert-Butyl oder Pentyl. Beispiele für besonders bevorzugte Arylreste für R¹⁰ sind unsubstituiertes Phenyl oder substituiertes Phenyl, bevorzugt in ortho-Position, beispielsweise durch Alkylreste mit 1 bis 6 Kohlenstoffatomen, beispielsweise Methyl, Ethyl oder Propyl, insbesondere iso-Propyl.

R¹¹, R¹², R¹³, R¹⁴ bedeuten unabhängig voneinander Wasserstoff oder linearer oder verzweigter Alkylrest mit 1 bis 20 Kohlenstoffatomen, besonders bevorzugt Wasserstoff.

In einer weiteren Ausführungsform der erfindungsgemäßen heteroleptischen Komplexe gemäß Ausführungsform 1 und Ausführungsform 2 bilden R¹ und R¹⁴ zusammen eine gesättigte oder ungesättigte, lineare oder verzweigte, gegebenenfalls Heteroatome, aromatische Einheiten, heteroaromatische Einheiten und/oder funktionelle Gruppen enthaltende Verbrückung mit insgesamt 1 bis 30 Kohlenstoff- und/oder Heteroatomen, an die gegebenenfalls ein substituierter oder unsubstituierter, fünf- bis achtgliedriger, Kohlenstoff- und/oder Heteroatome enthaltender Ring, bevorzugt ein sechsgliedriger aromatischer Ring, annelliert ist. Ganz besonders bevorzugt bilden R¹ und R¹⁴ eine ungesättigte Verbrückung mit zwei Kohlenstoffatomen, an die ein sechsgliedriger aromatischer Ring anelliert ist, der entweder nicht substituiert ist, oder mit einem oder zwei Alkylresten mit 1 bis 6 Kohlenstoffatomen, beispielsweise Methyl oder Ethyl, substituiert ist.

In einer weiteren Ausführungsform der erfindungsgemäßen heteroleptischen Komplexe gemäß Ausführungsform 1 bilden R⁷ und R⁸ zusammen eine gesättigte oder ungesättigte, lineare oder verzweigte, gegebenenfalls Heteroatome, aromatische Einheiten, heteroaromatische Einheiten und/oder funktionelle Gruppen enthaltende Verbrückung mit insgesamt 1 bis 30 Kohlenstoff- und/oder Heteroatomen, an die gegebenenfalls ein substituierter oder unsubstituierter, fünf- bis achtgliedriger, Kohlenstoff- und/oder Heteroatome enthaltender Ring, bevorzugt ein sechsgliedriger aromatischer Ring, anelliert ist. Ganz besonders bevorzugt bilden R⁷ und R⁸ eine ungesättigte Verbrückung mit zwei Kohlenstoffatomen, an die ein sechsgliedriger aromatischer Ring anelliert ist, der entweder nicht substituiert ist, oder mit einem oder zwei Alkylresten mit 1 bis 6 Kohlenstoffatomen, beispielsweise Methyl oder Ethyl, substituiert ist.

Somit betrifft die vorliegende Erfindung (gemäß Ausführungsform 1) erfindungsgemäße heteroleptische Komplexe der allgemeinen Formel (I) wobei M, A¹, A², n, m, R¹, R², R³, R⁴, R⁵, R⁶, R⁷, R⁸, R⁹, R¹⁰, R¹¹, R¹², R¹³ und R¹⁴ die folgenden Bedeutungen aufweisen:
- M: Ir,
- A¹, A²: C,
- n, m: unabhängig voneinander 1 oder 2, wobei die Summe von n und m 3 beträgt, bevorzugt ist n = 2 und m = 1,
- R¹: linearer oder verzweigter Alkylrest mit 1 bis 20 Kohlenstoffatomen, substituierter oder unsubstituierter Arylrest mit 6 bis 30 Kohlenstoffatomen, substituierter oder unsubstituierter Heteroarylrest mit 5 bis 18 Kohlenstoff-und/oder Heteroatomen, bevorzugt ist R¹ ein substituierter oder unsubstituierter Arylrest,
- R², R³: unabhängig voneinander Wasserstoff, linearer oder verzweigter Alkylrest mit 1 bis 20 Kohlenstoffatomen, substituierter oder unsubstituierter Arylrest mit 6 bis 30 Kohlenstoffatomen, substituierter oder unsubstituierter Heteroarylrest mit 5 bis 18 Kohlenstoff- und/oder Heteroatomen, bevorzugt bedeuten R² und R³ Wasserstoff,
- R⁴, R⁵, R⁶, R⁷: Wasserstoff und

R⁴ und R⁵ oder R⁵ und R⁶ oder R⁶ und R⁷ bilden zusammen einen Cyclus der allgemeinen Formel (IIa) oder (IIb) 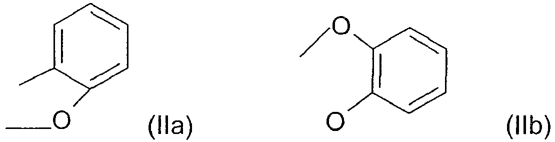
- R⁸, R⁹ R¹⁰: Wasserstoff, linearer oder verzweigter Alkylrest mit 1 bis 20 Kohlenstoffatomen, substituierter oder unsubstituierter Arylrest mit 6 bis 30 Kohlenstoffatomen, und
- R¹¹, R¹², R¹³, R¹⁴: unabhängig voneinander Wasserstoff oder linearer oder verzweigter Alkylrest mit 1 bis 20 Kohlenstoffatomen,
und/oder
R¹ und R¹⁴ bilden zusammen eine gesättigte oder ungesättigte, lineare oder verzweigte, gegebenenfalls Heteroatome, aromatische Einheiten, heteroaromatische Einheiten und/oder funktionelle Gruppen enthaltende Verbrückung mit insgesamt 1 bis 30 Kohlenstoff- und/oder Heteroatomen, an die gegebenenfalls ein substituierter oder unsubstituierter, fünf- bis achtgliedriger, Kohlenstoff- und/oder Heteroatome enthaltender Ring, bevorzugt ein sechsgliedriger aromatischer Ring, annelliert ist,
und/oder
R⁷ und R⁸ bilden zusammen eine gesättigte oder ungesättigte, lineare oder verzweigte, gegebenenfalls Heteroatome, aromatische Einheiten, heteroaromatische Einheiten und/oder funktionelle Gruppen enthaltende Verbrückung mit insgesamt 1 bis 30 Kohlenstoff- und/oder Heteroatomen, an die gegebenenfalls ein substituierter oder unsubstituierter, fünf- bis achtgliedriger, Kohlenstoff- und/oder Heteroatome enthaltender Ring, bevorzugt ein sechsgliedriger aromatischer Ring, anelliert ist.

Die oben genannten bevorzugten und besonders bevorzugten Ausführungsformen gelten entsprechend.

Des Weiteren betrifft die vorliegende Erfindung (gemäß Ausführungsform 2) erfindungsgemäße heteroleptische Komplexe der allgemeinen Formel (I), wobei M, A¹, A², n, m, R¹, R², R³, R⁴, R⁵, R⁶, R⁷, R⁸, R⁹, R¹⁰, R¹¹, R¹², R¹³ und R¹⁴ die folgenden Bedeutungen aufweisen:
- M: Ir,
- A¹, A²: N oder C, wobei A¹ = N, und A² = C bedeutet,
- n, m: unabhängig voneinander 1 oder 2, wobei die Summe von n und m 3 beträgt, bevorzugt ist n = 2 und m = 1,
- R¹: linearer oder verzweigter Alkylrest mit 1 bis 20 Kohlenstoffatomen, substituierter oder unsubstituierter Arylrest mit 6 bis 30 Kohlenstoffatomen, substituierter oder unsubstituierter Heteroarylrest mit 5 bis 18 Kohlenstoff-und/oder Heteroatomen, bevorzugt ist R¹ ein substituierter oder unsubstituierter Arylrest,
- R², R³: unabhängig voneinander Wasserstoff, linearer oder verzweigter Alkylrest mit 1 bis 20 Kohlenstoffatomen, substituierter oder unsubstituierter Arylrest mit 6 bis 30 Kohlenstoffatomen, substituierter oder unsubstituierter Heteroarylrest mit 5 bis 18 Kohlenstoff- und/oder Heteroatomen, bevorzugt bedeuten R² und R³ Wasserstoff,
- R⁴, R⁵, R⁶, R⁷: Wasserstoff
oder
R⁴ und R⁵ oder R⁵ und R⁶ oder R⁶ und R⁷ bilden zusammen einen gegebenenfalls von wenigstens einem Heteroatom unterbrochenen gesättigten, ungesättigten oder aromatischen Ring mit insgesamt 5 bis 30 Kohlenstoff- und/oder Heteroatomen,
- R⁸, R⁹: unabhängig voneinander freies Elektronenpaar, falls A¹ bzw. A² gleich N, oder, falls A¹ bzw. A² gleich C, Wasserstoff, linearer oder verzweigter Alkylrest mit 1 bis 20 Kohlenstoffatomen, substituierter oder unsubstituierter Arylrest mit 6 bis 30 Kohlenstoffatomen, substituierter oder unsubstituierter Heteroarylrest mit 5 bis 18 Kohlenstoff- und/oder Heteroatomen,
- R¹⁰: linearer oder verzweigter Alkylrest mit 1 bis 20 Kohlenstoffatomen, substituierter oder unsubstituierter Arylrest mit 6 bis 30 Kohlenstoffatomen, und
- R¹¹, R¹², R¹³, R¹⁴: Wasserstoff oder linearer oder verzweigter Alkylrest mit 1-20 Kohlenstoffatomen
und/oder
R¹ und R¹⁴ bilden zusammen eine gesättigte oder ungesättigte, lineare oder verzweigte, gegebenenfalls Heteroatome, aromatische Einheiten, heteroaromatische Einheiten und/oder funktionelle Gruppen enthaltende Verbrückung mit insgesamt 1 bis 30 Kohlenstoff- und/oder Heteroatomen, an die gegebenenfalls ein substituierter oder unsubstituierter, fünf- bis achtgliedriger, Kohlenstoff- und/oder Heteroatome enthaltender Ring, bevorzugt ein sechsgliedriger aromatischer Ring, annelliert ist.

Die oben genannten bevorzugten und besonders bevorzugten Ausführungsformen gelten entsprechend.

Die vorliegende Erfindung betrifft auch bevorzugt erfindungsgemäße heteroleptische Komplexe der allgemeinen Formel (I), wobei M, A¹, A², n, m, R¹, R², R³, R⁴, R⁵, R⁶, R⁷, R⁸, R⁹, R¹⁰, R¹¹, R¹², R¹³ und R¹⁴ die folgenden Bedeutungen aufweisen:
- M: Ir,
- A¹: C,
- A²: C,
- n, m: unabhängig voneinander 1 oder 2, wobei die Summe von n und m 3 beträgt, bevorzugt ist n = 2 und m = 1
- R¹: linearer oder verzweigter Alkylrest mit 1 bis 20 Kohlenstoffatomen, substituierter oder unsubstituierter Arylrest mit 6 bis 30 Kohlenstoffatomen, substituierter oder unsubstituierter Heteroarylrest mit 5 bis 18 Kohlenstoff-und/oder Heteroatomen, bevorzugt ist R¹ ein substituierter oder unsubstituierter Arylrest,
- R², R³: unabhängig voneinander Wasserstoff, linearer oder verzweigter Alkylrest mit 1 bis 20 Kohlenstoffatomen, substituierter oder unsubstituierter Arylrest mit 6 bis 30 Kohlenstoffatomen, substituierter oder unsubstituierter Heteroarylrest mit 5 bis 18 Kohlenstoff- und/oder Heteroatomen, bevorzugt bedeuten R² und R³ Wasserstoff,
- R⁴, R⁵, R⁶: Wasserstoff und R⁴ und R⁵ oder R⁵ und R⁶ bilden zusammen einen Cyclus der allgemeinen Formel (IIa) oder (IIb) 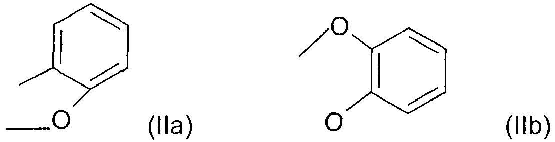
- R⁷, R⁸: bilden gemeinsam eine ungesättigte C₂-Brücke, an die ein substituierter oder unsubstituierter, fünf- bis achtgliedriger, Kohlenstoff- und/oder Heteroatome enthaltender Ring, annelliert sein kann,
- R⁹: Wasserstoff,
- R¹⁰: linearer oder verzweigter Alkylrest mit 1 bis 20 Kohlenstoffatomen, substituierter oder unsubstituierter Arylrest mit 6 bis 30 Kohlenstoffatomen, und
- R¹¹, R¹², R¹³, R¹⁴: unabhängig voneinander Wasserstoff oder linearer oder verzweigter Alkylrest mit 1 bis 20 Kohlenstoffatomen,
und/oder
R¹ und R¹⁴ bilden zusammen eine gesättigte oder ungesättigte, lineare oder verzweigte, gegebenenfalls Heteroatome, aromatische Einheiten, heteroaromatische Einheiten und/oder funktionelle Gruppen enthaltende Verbrückung mit insgesamt 1 bis 30 Kohlenstoff- und/oder Heteroatomen, an die gegebenenfalls ein substituierter oder unsubstituierter, fünf- bis achtgliedriger, Kohlenstoff- und/oder Heteroatome enthaltender Ring, bevorzugt ein sechsgliedriger aromatischer Ring, annelliert ist.

Die letztgenannte Ausführungsform entspricht der folgenden allgemeinen Formel (Ib)

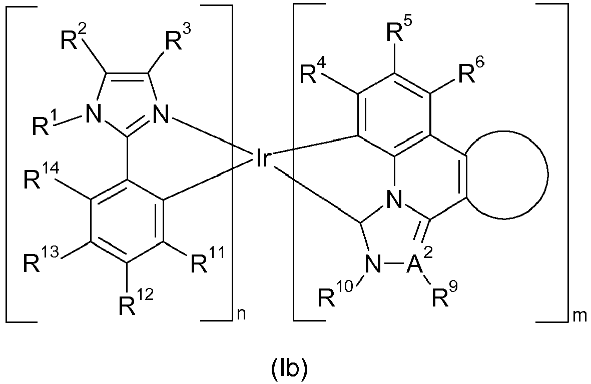

Ganz besonders bevorzugte erfindungsgemäße heteroleptische Komplexe der allgemeinen Formel (I) weisen die in Tabelle 1 abgebildeten Liganden auf, insbesondere bevorzugt in den dargestellten Kombinationen:

**Tabelle 1**

| **Liganden** | 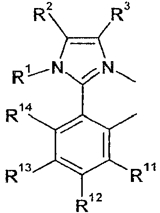 | 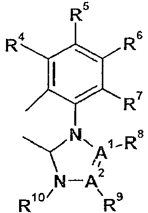 |
|---|---|---|
| **K1** | 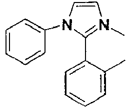 | 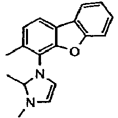 |
| **K2** | 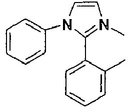 | 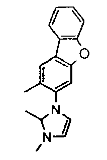 |
| **K3** | 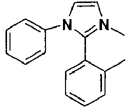 | 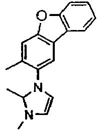 |
| **K4** | 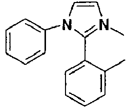 | 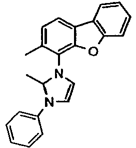 |
| **K5** | 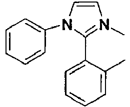 | 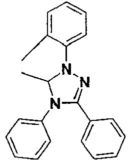 |
| **K10** | 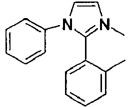 | 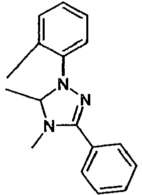 |
| **K13** | 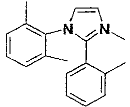 | 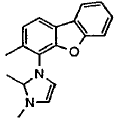 |
| **K14** | 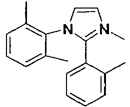 | 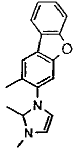 |
| **K15** | 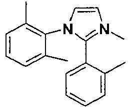 | 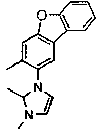 |
| **K16** | 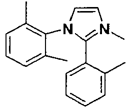 | 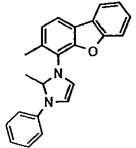 |
| **K17** | 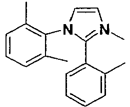 | 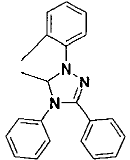 |
| **K22** | 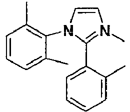 | 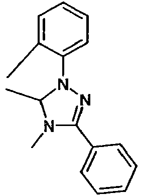 |
| **K25** | 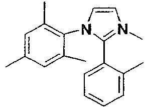 | 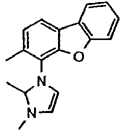 |
| **K26** | 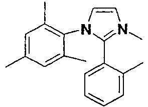 | 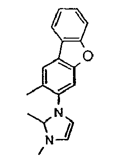 |
| **K27** | 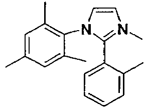 | 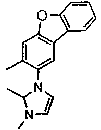 |
| **K28** | 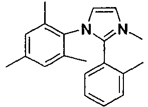 | 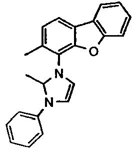 |
| **K29** | 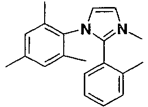 | 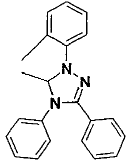 |
| **K34** | 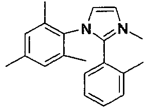 | 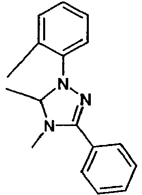 |
| **K37** | 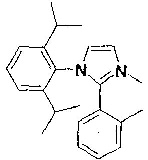 | 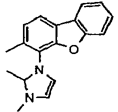 |
| **K38** | 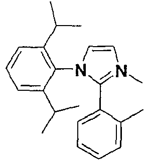 | 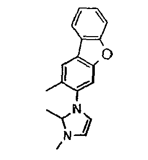 |
| **K39** | 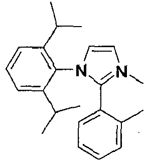 | 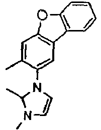 |
| **K40** | 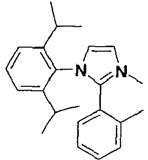 | 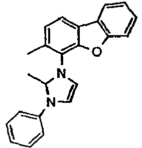 |
| **K41** | 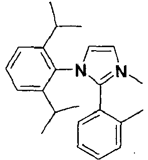 | 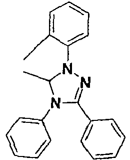 |
| **K46** | 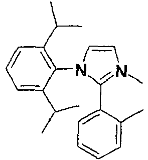 | 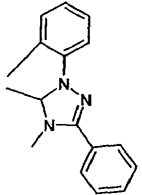 |
| **K49** | 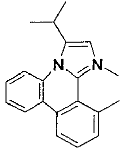 | 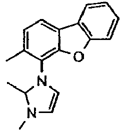 |
| **K50** | 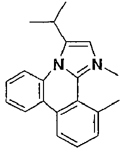 | 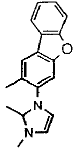 |
| **K51** | 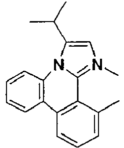 | 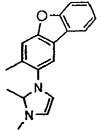 |
| **K52** | 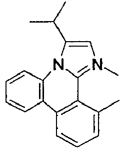 | 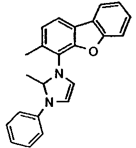 |
| **K53** | 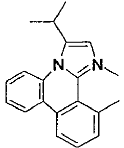 | 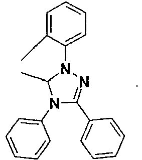 |
| **K58** | 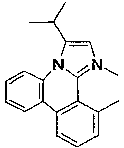 | 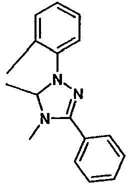 |
| **K61** | 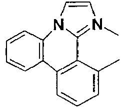 | 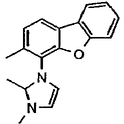 |
| **K62** | 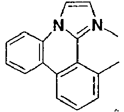 | 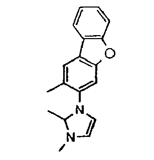 |
| **K63** | 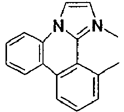 | 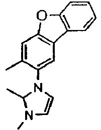 |
| **K64** | 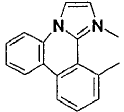 | 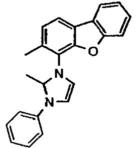 |
| **K65** | 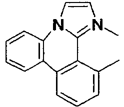 | 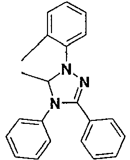 |
| **K70** | 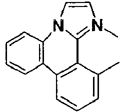 | 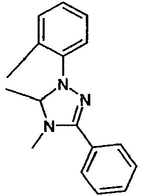 |
| **K73** | 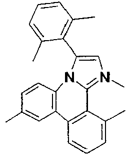 | 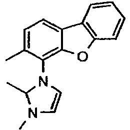 |
| **K74** | 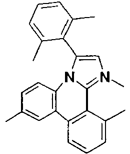 | 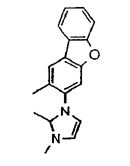 |
| **K75** | 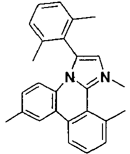 | 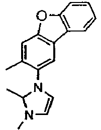 |
| **K76** | 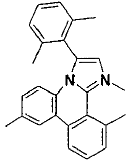 | 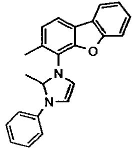 |
| **K77** | 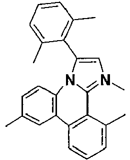 | 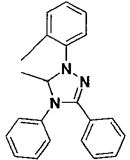 |
| **K82** | 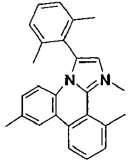 | 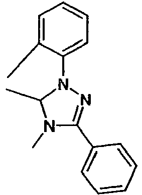 |
| **K85** | 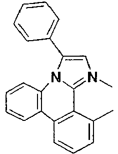 | 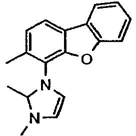 |
| **K86** | 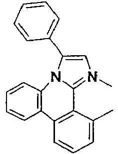 | 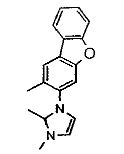 |
| **K87** | 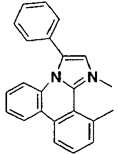 | 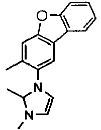 |
| **K88** | 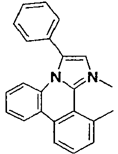 | 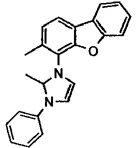 |
| **K89** | 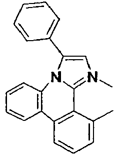 | 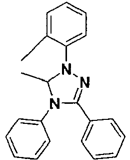 |
| **K94** | 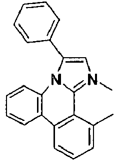 | 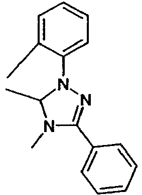 |

| | | |
|---|---|---|
| jeweils mit M = Ir, n= 2 und m = 1. | | |

In Abhängigkeit von der Koordinationszahl des in den erfindungsgemäßen heteroleptischen Komplexen der allgemeinen Formel (I) vorliegenden Metalls M und der Anzahl der eingesetzten Carbenliganden und Nichtcarbenliganden können verschiedene Isomere der entsprechenden heteroleptischen Metallkomplexe bei gleichem Metall M und gleicher Natur der eingesetzten Carbenliganden und Nichtcarbenliganden vorliegen.

Beispielsweise sind für oktaedrische Iridium(III)-Komplexe mit zwei Nichtcarbenliganden und einem Carbenliganden die folgenden Isomere S1 bis S4 möglich, die jeweils in Form zweier Enantiomere (a und b) vorliegen können:

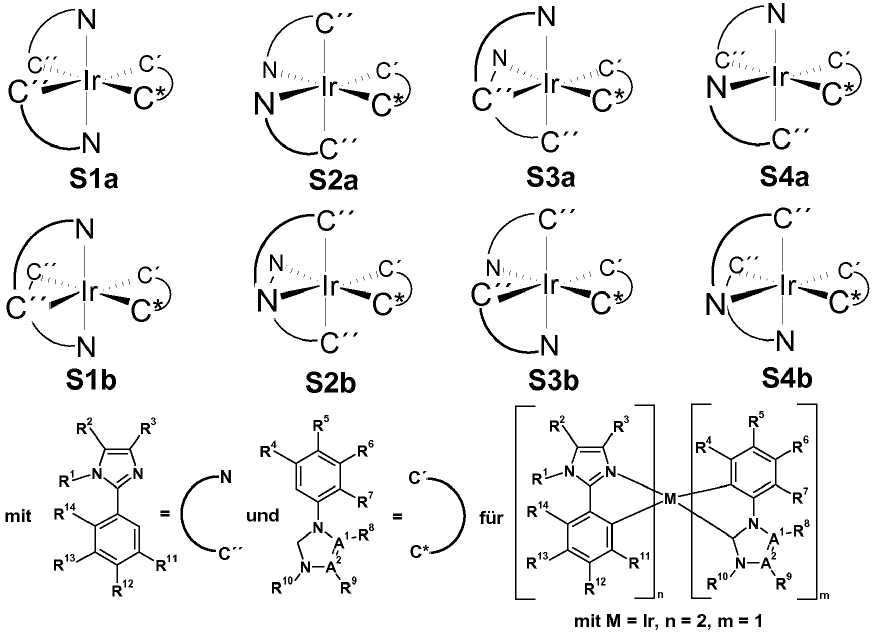

In der vorliegenden Anmeldung werden aufgrund der Anordnung der beiden 2-Phenyl-1H-imidazol-Liganden die Isomere S1a/S1b und S2a/S2b als pseudo-meridionale Isomere und die Isomere S3a/S3b und S4a/S4b als pseudo-faciale Isomere bezeichnet.

Überraschend wurde erfindungsgemäß gefunden, dass die Isomere S3 und S4 beim Einsatz in OLEDs in der Regel besonders gute Ergebnisse bezüglich Effizienz und Lebensdauer beim Einsatz in Dioden liefern. Daher sind die Isomere S3a/S3b und S4a/S4b, d. h. die pseudo-facialen Isomere, erfindungsgemäß besonders bevorzugt. Besonders bevorzugt liegen somit die erfindungsgemäßen Komplexe der allgemeinen Formel (I), die zwei Nichtcarbenliganden und einen Carbenliganden enthalten, als pseudo-faciale Isomere vor.

Für Iridium(III)-Komplexe mit einem Nichtcarbenliganden und zwei Carbenliganden sind die folgende Isomere T1 bis T4 möglich, die wiederum jeweils in Form zweier Enantiomere (a und b) vorliegen können:

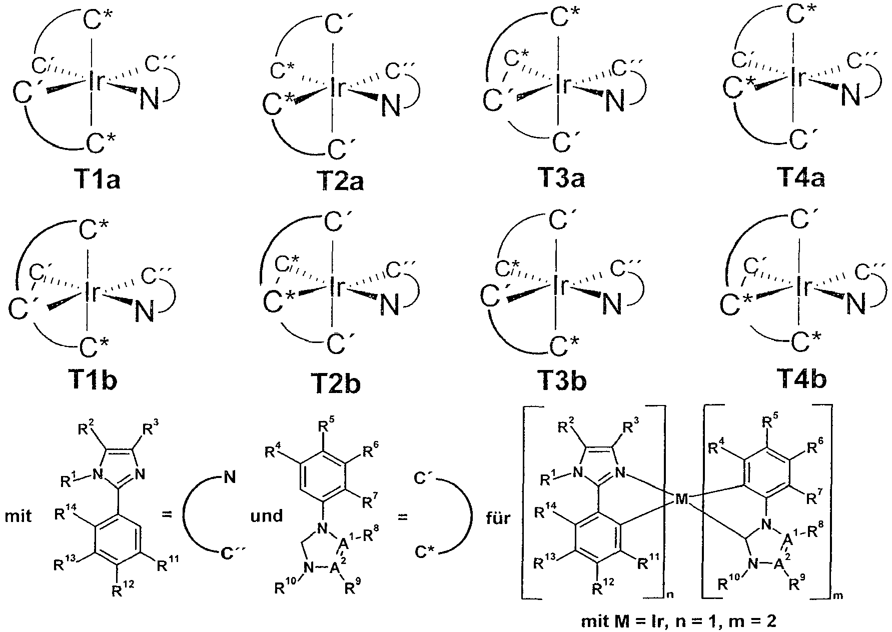

In der vorliegenden Anmeldung werden aufgrund der Anordnung der beiden Phenylcarben-Liganden die Isomere T1a/T1b und T2a/T2b als pseudo-meridionale Isomere und die Isomere T3a/T3b und T4a/T4b als pseudo-faciale Isomere bezeichnet.

Überraschend wurde erfindungsgemäß gefunden, dass die Isomere T3 und T4 beim Einsatz in OLEDs in der Regel besonders gute Ergebnisse bezüglich Effizienz und Lebensdauer beim Einsatz in Dioden liefern. Daher sind die Isomere T3a/T3b und T4a/T4b, d. h. die pseudo-facialen Isomere, erfindungsgemäß besonders bevorzugt. Besonders bevorzugt liegen somit die erfindungsgemäßen Komplexe der allgemeinen Formel (I), die einen Nichtcarbenliganden und zwei Carbenliganden enthalten, als pseudo-faciale Isomere vor.

Im Allgemeinen können die verschiedenen Isomere der heteroleptischen Metallkomplexe der Formel (I) nach dem Fachmann bekannten Verfahren, z. B. durch Chromatographie, Sublimation oder Kristallisation getrennt werden. Die verschiedenen Isomere können im Allgemeinen durch geeignete Reaktionsbedingungen (z. B. pH-Wert), thermisch oder photochemisch ineinander überführt werden.

Die vorliegende Erfindung betrifft sowohl jeweils die einzelnen Isomere bzw. Enantiomere der heteroleptischen Komplexe der Formel (I), als auch Gemische verschiedener Isomere bzw. Enantiomere in jedem beliebigen Mischungsverhältnis.

Daher betrifft die vorliegende Erfindung in einer besonders bevorzugten Ausführungsform die erfindungsgemäßen heteroleptischen Komplexe mit den genannten allgemeinen und bevorzugten Bedeutungen für M, A¹, A², n, m, R¹, R², R³, R⁴, R⁵, R⁶, R⁷, R⁸, R⁹, R¹⁰, R¹¹, R¹² R¹³ und R¹⁴, wobei diese eine der folgenden Konfigurationen IIIa, IIIb, IVa oder IVb aufweisen: 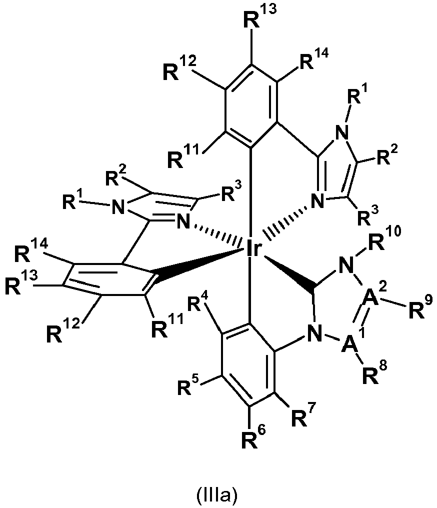 oder 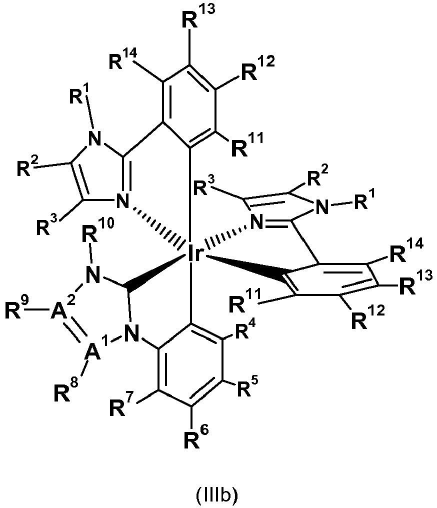 oder 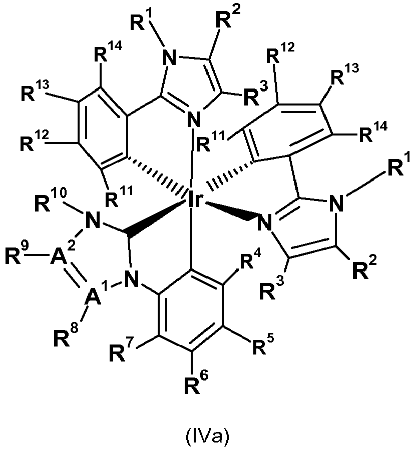 oder

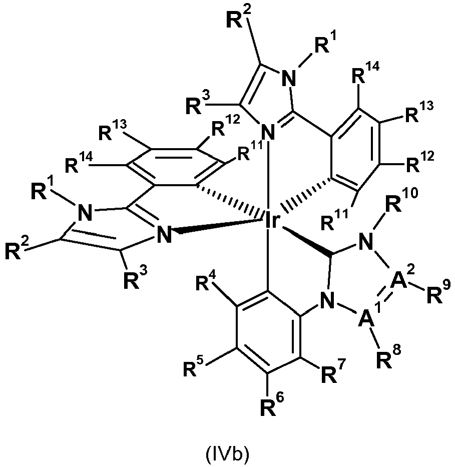

Die vorliegende Erfindung betrifft des Weiteren auch ein Verfahren zur Herstellung eines erfindungsgemäßen heteroleptischen Komplexes gemäß der allgemeinen Formel (I) durch

Inkontaktbringen wenigstens einer Vorläuferverbindung, enthaltend das Metall M und den wenigstens einen Liganden, der in den Komplexen der allgemeinen Formel (I) über Nichtcarbenbindungen an M angebunden ist, mit wenigstens einem Liganden, der in den Komplexen der allgemeinen Formel (I) über wenigstens eine Carbenbindung an M angebunden ist, bzw. dessen Ligandvorläufer wie z. B. einem entsprechenden Imidazoliumsalz,
oder
durch Inkontaktbringen wenigstens einer Vorläuferverbindung, enthaltend das Metall M sowie einen Liganden, der in den Komplexen der allgemeinen Formel (I) über wenigstens eine Carbenbindung an M gebunden ist, mit wenigstens einem Liganden, der in den Komplexen der allgemeinen Formel (I) über Nichtcarbenbindungen an M angebunden ist.

In einer bevorzugten Ausführungsform des erfindungsgemäßen Verfahrens wird ein Komplex enthaltend entsprechende Nichtcarbenliganden, angebunden an Iridium, und entsprechende Carbenliganden, bevorzugt in deprotonierter Form als freies Carben oder in Form eines geschützten Carbens z. B. als Silber-Carbenkomplex, in Kontakt gebracht. Geeignete Vorläuferverbindungen enthalten die entsprechenden Substituenten R¹ bis R¹⁴, die in den Komplexen der allgemeinen Formel (I) vorliegen sollen.

Entsprechende Komplexe enthaltend entsprechende Nichtcarbenliganden, angebunden an Iridium, sind dem Fachmann bekannt. Neben den Nichtcarbenliganden, die in dem Komplex der allgemeinen Formel (I) vorliegen, können diese als Vorläuferverbindungen eingesetzten Komplexe weitere dem Fachmann bekannte Liganden enthalten, beispielsweise Halogenide bevorzugt Chlorid,. Weitere geeignete Liganden sind beispielsweise 1,5-Cyclooctadien (COD), Phosphine, Cyanide, Alkoholate, Pseudohalogenide und/oder Alkyl.

Besonders bevorzugte Komplexe enthaltend entsprechende Nichtcarbenliganden, angebunden an das entsprechende Metall M, sind beispielsweise Verbindungen der allgemeinen Formel (VI) 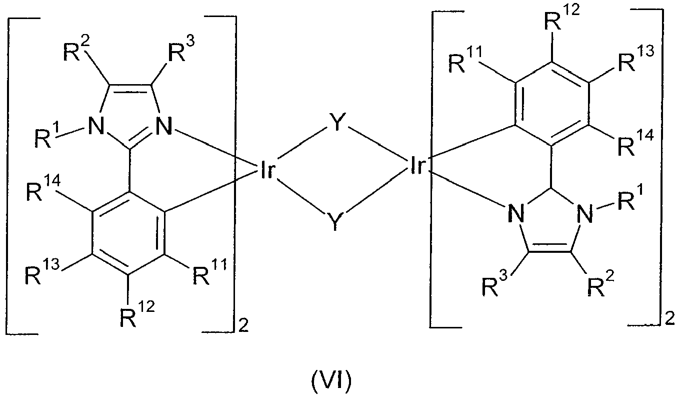 mit den oben genannten Bedeutungen für R¹, R², R³, R¹¹, R¹², R¹³ und R¹⁴ wobei Y unabhängig voneinander F, Cl, Br, I, Methoxy oder Carboxylat sein kann.

Besonders bevorzugte als Vorläuferverbindungen für die in Komplexen der allgemeinen Formel (I) eingesetzten Carbenliganden entsprechen beispielsweise den allgemeinen Formeln (VII) oder (VIII) 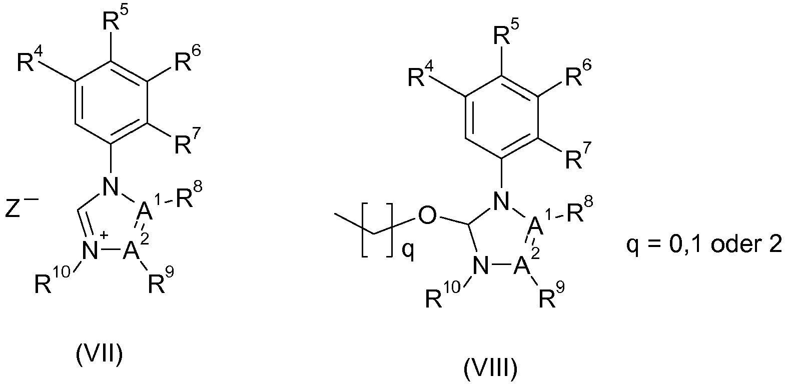 mit den oben genannten Bedeutungen für R⁴, R⁵, R⁶, R⁷, R⁸, R⁹, R¹⁰ und A, wobei Z F, Cl, Br, I, BF₄, PF₆, ClO₄ oder SbF₆ sein kann.

Die Deprotonierung der Carbenliganden-Vorläufer, bevorzugt vor der Reaktion, erfolgt beispielsweise durch dem Fachmann bekannte basische Verbindungen, beispielsweise basische Metallate, basische Metallacetate, -acetylacetonate oder -alkoxylate oder Basen wie KO^{t}Bu, NaO^{t}Bu, LiO^{t}Bu, NaH, Silylamide, Ag₂O sowie Phosphazen-Basen. In einer weiteren bevorzugten Ausführungsform kann das Freisetzen des Carbens auch durch Entfernen flüchtiger Substanzen, beispielsweise niedere Alkohole wie Methanol, Ethanol, beispielsweise bei erhöhter Temperatur und/oder erniedrigtem Druck, aus Vorläuferverbindungen der Carbenliganden erfolgen. Entsprechende Verfahren sind dem Fachmann bekannt.

Das Inkontaktbringen erfolgt bevorzugt in einem Lösungsmittel. Geeignete Lösungsmittel sind dem Fachmann an sich bekannt und sind bevorzugt ausgewählt aus der Gruppe bestehend aus aromatischen oder aliphatischen Lösungsmitteln, beispielsweise Benzol oder Toluol, cyclischen oder acyclischen Ethern, Alkoholen, Estern, Amiden, Ketonen, Nitrilen, halogenierten Verbindungen und Mischungen davon. Besonders bevorzugte Lösungsmittel sind Toluol, Xylole, Dioxan und THF.

Das molare Verhältnis von eingesetztem Metall-Nichtcarben-Komplex zu eingesetztem Carben-Ligandvorläufer beträgt im Allgemeinen 1 zu 10 bis 10 zu 1, bevorzugt 1 zu 1 bis 1 zu 5, besonders bevorzugt 1 zu 2 bis 1 zu 4.

Das Inkontaktbringen erfolgt im Allgemeinen bei einer Temperatur von 20 bis 200 °C, bevorzugt 50 bis 150 °C, besonders bevorzugt 60 bis 130 °C.

Die Reaktionsdauer ist abhängig von dem gewünschten Carben-Komplex und beträgt im Allgemeinen 0,02 bis 50 Stunden, bevorzugt 0,1 bis 24 Stunden, besonders bevorzugt 1 bis 12 Stunden.

Die nach der Reaktion erhaltenen Komplexe der allgemeinen Formel (I) können gegebenenfalls nach dem Fachmann bekannten Verfahren, beispielsweise Waschen, Kristallisation oder Chromatographie gereinigt werden und gegebenenfalls unter dem Fachmann ebenfalls bekannten Bedingungen, beispielsweise thermisch oder photochemisch, isomerisiert werden.

Die vorstehend genannten heteroleptischen Komplexe und Mischungen davon sind hervorragend als Emittermoleküle in organischen Licht-emittierenden Dioden (OLEDs) geeignet. Durch Variationen der Liganden ist es möglich, entsprechende Komplexe bereitzustellen, die Elektrolumineszenz im roten, grünen sowie insbesondere im blauen Bereich des elektromagnetischen Spektrums zeigen. Die erfindungsgemäßen heteroleptischen Komplexe der allgemeinen Formel (I) eignen sich daher hervorragend als Emittersubstanzen, da sie eine Emission (Elektrolumineszenz) im sichtbaren Bereich des elektromagnetischen Spektrums, beispielsweise bei 400 bis 800 nm, bevorzugt 400 bis 600 nm,, aufweisen. Durch die erfindungsgemäßen heteroleptischen Komplexe ist es möglich, Verbindungen bereitzustellen, die Elektrolumineszenz im roten, grünen sowie im blauen Bereich des elektromagnetischen Spektrums aufweisen. Somit ist es möglich, mithilfe der erfindungsgemäßen heteroleptischen Komplexe als Emittersubstanzen technisch einsetzbare OLEDs bereitzustellen.

Des Weiteren können die erfindungsgemäßen heteroleptischen Komplexe der allgemeinen Formel (I) als Matrixmaterial, Ladungstransportmaterial, insbesondere Lochtransportmaterial, und/oder Ladungsblocker eingesetzt werden.

Bevorzugt werden die erfindungsgemäßen heteroleptischen Komplexe der allgemeinen Formel (I) als Emitter und/oder Lochtransportmaterial eingesetzt, besonders bevorzugt als Emitter.

Besondere Eigenschaften der erfindungsgemäßen heteroleptischen Komplexe der allgemeinen Formel (I) sind besonders gute Effizienzen und Lebensdauern beim Einsatz in OLEDs.

Ein weiterer Gegenstand der vorliegenden Anmeldung ist daher eine OLED, enthaltend wenigstens einen erfindungsgemäßen heteroleptischen Komplex der allgemeinen Formel (I). Der erfindungsgemäße heteroleptische Komplex der allgemeinen Formel (I) wird in der OLED bevorzugt als Emitter, Matrixmaterial, Ladungstransportmaterial, insbesondere Lochtransportmaterial, und/oder Ladungsblocker eingesetzt, besonders bevorzugt als Emitter und/oder Lochtransportmaterial, ganz besonders bevorzugt als Emitter.

Ein weiterer Gegenstand der vorliegenden Anmeldung ist auch die Verwendung der heteroleptischen Komplexe der allgemeinen Formel (I) als Licht-emittierende Schicht in OLEDs, bevorzugt als Emitter, Matrixmaterial, Ladungstransportmaterial, insbesondere Lochtransportmaterial, und/oder Ladungsblocker, besonders bevorzugt als Emitter und/oder Lochtransportmaterial, ganz besonders bevorzugt als Emitter.

Organische Leuchtdioden sind grundsätzlich aus mehreren Schichten aufgebaut:
- Anode (1)
- Löcher-transportierende Schicht (2)
- Licht-emittierende Schicht (3)
- Elektronen-transportierende Schicht (4)
- Kathode (5)

Es ist jedoch auch möglich, dass die OLED nicht alle der genannten Schichten aufweist, zum Beispiel ist eine OLED mit den Schichten (1) (Anode), (3) (Licht-emittierende Schicht) und (5) (Kathode) ebenfalls geeignet, wobei die Funktionen der Schichten (2) (Löcher-transportierende Schicht) und (4) (Elektronen-transportierende Schicht) durch die angrenzenden Schichten übernommen werden. OLEDs, die die Schichten (1), (2), (3) und (5) bzw. die Schichten (1), (3), (4) und (5) aufweisen, sind ebenfalls geeignet.

Die heteroleptischen Komplexe der allgemeinen Formel (I) werden bevorzugt in der Licht-emittierenden Schicht (3) als Emittermoleküle und/oder Matrixmaterialien eingesetzt. Die erfindungsgemäßen heteroleptischen Komplexe der allgemeinen Formel (I) können auch - zusätzlich zu dem Einsatz als Emittermoleküle und/oder Matrixmaterialien in der Licht-emittierenden Schicht (3) oder anstelle des Einsatzes in der Licht-emittierenden Schicht - als Ladungstransportmaterial in der Löcher-transportierenden Schicht (2) oder in der Elektronen-transportierenden Schicht (4) und/oder als Ladungsblocker eingesetzt werden, wobei der Einsatz als Ladungstransportmaterial in der Löcher-transportierenden Schicht (2) (Lochtransportmaterial) bevorzugt ist.

Ein weiterer Gegenstand der vorliegenden Anmeldung ist daher eine Licht-emittierende Schicht enthaltend mindestens einen der erfindungsgemäßen heteroleptischen Komplexe der allgemeinen Formel (I), bevorzugt als Emittermolekül. Bevorzugte heteroleptische Komplexe der allgemeinen Formel (I) sind bereits vorstehend genannt.

Die erfindungsgemäß verwendeten heteroleptischen Komplexe der allgemeinen Formel (I) können in Substanz, d. h. ohne weitere Zusätze, in der Licht-emittierenden Schicht vorliegen. Es ist jedoch auch möglich, dass neben den erfindungsgemäß eingesetzten heteroleptischen Komplexen der allgemeinen Formel (I) weitere Verbindungen in der Licht-emittierenden Schicht vorliegen. Beispielsweise kann ein fluoreszierender Farbstoff anwesend sein, um die Emissionsfarbe des als Emittermoleküls eingesetzten heteroleptischen Komplexes zu verändern. Des Weiteren kann ein Verdünnungsmaterial (Matrixmaterial) eingesetzt werden. Dieses Verdünnungsmaterial kann ein Polymer sein, z. B. Poly(N-vinylcarbazol) oder Polysilan. Das Verdünnungsmaterial kann jedoch ebenfalls ein kleines Molekül sein, z. B. 4,4'-N,N'-Dicarbazolbiphenyl (CDP) oder tertiäre aromatische Amine. Wenn ein Verdünnungsmaterial eingesetzt wird, beträgt der Anteil der erfindungsgemäßen heteroleptischen Komplexe der allgemeinen Formel (I) in der Licht-emittierenden Schicht im Allgemeinen weniger als 40 Gew.-%, bevorzugt 3 bis 30 Gew.-%. Bevorzugt werden die erfindungsgemäßen heteroleptischen Komplexe der allgemeinen Formel (I) in einer Matrix eingesetzt, Somit enthält die Licht-emittierende Schicht bevorzugt mindestens einen erfindungsgemäßen heteroleptischen Komplex der allgemeinen Formel (I) und mindestens ein Matrixmaterial als Verdünnungsmaterial.

Als Matrixmaterialien sind - neben den vorstehend genannten Verdünnungsmaterialien - grundsätzlich die nachstehend als Loch- und Elektronentransportmaterialien genannten Materialien sowie Carbenkomplexe, z.B. die Carbenkomplexe der Formel (I) oder die in WO 2005/019373 genannten Carbenkomplexe, geeignet. Besonders geeignet sind Carbazolderivate, z.B. 4,4'-Bis(carbazol-9-yl)-2,2'-dimethyl-biphenyl (CDBP), 4,4'-Bis(carbazol-9-yl)-biphenyl (CBP), 1,3-Bis(N-carbazolyl)benzol (mCP), sowie die in den folgenden Anmeldungen genannten Matrixmaterialien: WO2008/034758, WO2009/003919.

Weitere geeignete Matrixmaterialien, wobei es sich um kleine Moleküle oder (Co)Polymere von den genannten kleinen Molekülen handeln kann, sind in den nachstehenden Veröffentlichungen genannt:
WO2007108459 (H-1 bis H-37), bevorzugt H-20 bis H-22 und H-32 bis H-37, ganz besonders bevorzugt H-20, H-32, H-36, H-37, WO2008035571 A1 (Host 1 bis Host 6), JP2010135467 (Verbindungen 1 bis 46 und Host-1 bis Host-39 und Host-43), WO2009008100 Verbindungen No.1 bis No.67, bevorzugt No.3, No.4, No.7 bis No. 12, No.55, No.59, No. 63 bis No.67, besonders bevorzugt No. 4, No. 8 bis No. 12, No. 55, No. 59, No.64, No.65, und No. 67, WO2009008099 Verbindungen No. 1 bis No. 110, WO2008140114 Verbindungen 1-1 bis 1-50, WO2008090912 Verbindungen OC-7 bis OC-36 und die Polymeren von Mo-42 bis Mo-51, JP2008084913 H-1 bis H-70, WO2007077810 Verbindungen 1 bis 44, bevorzugt 1, 2, 4-6, 8, 19-22, 26, 28-30, 32, 36, 39-44, WO201001830 die Polymere der Monomeren 1-1 bis 1-9, bevorzugt von 1-3, 1-7, und 1-9, WO2008029729 die (Polymeren von) Verbindungen 1-1 bis 1-36, WO20100443342 HS-1 bis HS-101 und BH-1 bis BH-17, bevorzugt BH-1 bis BH-17, JP2009182298 die (Co-)Polymere basierend auf den Monomeren 1 bis 75, JP2009170764, JP2009135183 die (Co-)Polymere basierend auf den Monomeren 1-14, WO2009063757 bevorzugt die (Co-)Polymere basierend auf den Monomeren 1-1 bis 1-26, WO2008146838 die Verbindungen a-1 bis a-43 und 1-1 bis 1-46, JP2008207520 die (Co)-Polymere basierend auf den Monomeren 1-1 bis 1-26, JP2008066569 die (Co)-Polymere basierend auf den Monomeren 1-1 bis 1-16, WO2008029652 die (Co)-Polymere basierend auf den Monomeren 1-1 bis 1-52, WO2007114244 die (Co)-Polymere basierend auf den Monomeren 1-1 bis 1-18, JP2010040830 die Verbindungen HA-1 bis HA-20, HB-1 bis HB-16, HC-1 bis HC-23 und die (Co)-Polymere basierend auf den Monomeren HD-1 bis HD-12, JP2009021336, WO2010090077 die Verbindungen 1 bis 55, WO2010079678 die Verbindungen H1 bis H42, WO2010067746 WO2010044342 die Verbindungen HS-1 bis HS-101 und Poly-1 bis Poly-4, JP2010114180 die Verbindungen PH-1 bis PH-36, US2009284138 die Verbindungen 1 bis 111 und H1 bis H71, WO2008072596 die Verbindungen 1 bis 45, JP2010021336 die Verbindungen H-1 bis H-38, bevorzugt H-1, WO2010004877 die Verbindungen H-1 bis H-60, JP2009267255 die Verbindungen 1-1 bis 1-105, WO2009104488 die Verbindungen 1-1 bis 1-38, WO2009086028, US2009153034, US2009134784, WO2009084413 die Verbindungen 2-1 bis 2-56, JP2009114369 die Verbindungen 2-1 bis 2-40, JP2009114370 die Verbindungen 1 bis 67, WO2009060742 die Verbindungen 2-1 bis 2-56, WO2009060757 die Verbindungen 1-1 bis 1-76, WO2009060780 die Verbindungen 1-1 bis 1-70, WO2009060779 die Verbindungen 1-1 bis 1-42, WO2008156105 die Verbindungen 1 bis 54, JP2009059767 die Verbindungen 1 bis 20, JP2008074939 die Verbindungen 1 bis 256, JP2008021687 die Verbindungen 1 bis 50, WO2007119816 die Verbindungen 1 bis 37, WO2010087222 die Verbindungen H-1 bis H-31, WO2010095564 die Verbindungen HOST-1 bis HOST-61, WO2007108362, WO2009003898, WO2009003919, WO2010040777, US2007224446 und WO06128800.

In einer besonders bevorzugten Ausführungsform werden eine oder mehrere Verbindungen der nachstehend genannten allgemeinen Formel (X) als Matrixmaterial eingesetzt. Bevorzugte Ausführungsformen der Verbindungen der allgemeinen Formel (X) sind ebenfalls nachstehend genannt.

Die vorstehend genannten Matrixmaterialien sowie die nachstehend genannten Verbindungen der allgemeinen Formel (X) können nicht nur als Matrixmaterial in der Licht-emittierenden Schicht eingesetzt werden, sondern auch als Matrixmaterialien in anderen Schichten einer OLED, z.B. in der Elektronentransportschicht und/oder in der Lochtransportschicht. Es ist ebenfalls möglich, zwei oder mehr verschiedene der vorstehend genannten Materialien und/oder der nachstehend genannten Verbindungen der allgemeinen Formel (X) als Matrixmaterial einzusetzen.

Die einzelnen der vorstehend genannten Schichten der OLED können wiederum aus zwei oder mehreren Schichten aufgebaut sein. Beispielsweise kann die Löcher-transportierende Schicht aus einer Schicht aufgebaut sein, in die aus der Elektrode Löcher injiziert werden und einer Schicht, die die Löcher von der Loch-injizierenden Schicht weg in die Licht-emittierende Schicht transportiert. Die Elektronen-transportierende Schicht kann ebenfalls aus mehreren Schichten bestehen, z. B. einer Schicht, worin Elektronen durch die Elektrode injiziert werden, und einer Schicht, die aus der Elektronen-injizierenden Schicht Elektronen erhält und in die Licht-emittierende Schicht transportiert. Diese genannten Schichten werden jeweils nach Faktoren wie Energieniveau, Temperaturresistenz und Ladungsträgerbeweglichkeit sowie Energiedifferenz der genannten Schichten mit den organischen Schichten oder den Metallelektroden ausgewählt. Der Fachmann ist in der Lage, den Aufbau der OLEDs so zu wählen, dass er optimal an die erfindungsgemäß als Emittersubstanzen verwendeten heteroleptischen Komplexe gemäß der vorliegenden Erfindung angepasst ist.

Um besonders effiziente OLEDs zu erhalten, sollte das HOMO (höchstes besetztes Molekülorbital) der Loch-transportierenden Schicht mit der Arbeitsfunktion der Anode angeglichen sein und das LUMO (niedrigstes unbesetztes Molekülorbital) der elektronentransportierenden Schicht sollte mit der Arbeitsfunktion der Kathode angeglichen sein.

Ein weiterer Gegenstand der vorliegenden Anmeldung ist eine OLED enthaltend mindestens eine erfindungsgemäße Licht-emittierende Schicht. Die weiteren Schichten in der OLED können aus einem beliebigen Material aufgebaut sein, das üblicherweise in solchen Schichten eingesetzt wird und dem Fachmann bekannt ist.

Geeignete Materialien für die vorstehend genannten Schichten (Anode, Kathode, Loch-und Elektroneninjektionsmaterialien, Loch- und Elektronentransportmaterialien und Loch- und Elektronenblockermaterialien, Matrixmaterialien, Fluoreszenz- und Phosphoreszenzemitter) sind dem Fachmann bekannt und z.B. in H. Meng, N. Herron, Organic Small Molecule Materials for Organic Light-Emitting Devices in Organic Light-Emitting Materials and Devices, Ed.: Z. Li, H. Meng, Taylor & Francis, 2007, Chapter 3, Seiten 295 bis 411 genannt.

Die Anode ist eine Elektrode, die positive Ladungsträger bereitstellt. Sie kann zum Beispiel aus Materialien aufgebaut sein, die ein Metall, eine Mischung verschiedener Metalle, eine Metalllegierung, ein Metalloxid oder eine Mischung verschiedener Metalloxide enthält. Alternativ kann die Anode ein leitendes Polymer sein. Geeignete Metalle umfassen die Metalle der Gruppen 11, 4, 5 und 6 des Periodensystems der Elemente sowie die Übergangsmetalle der Gruppen 8 bis 10. Wenn die Anode lichtdurchlässig sein soll, werden im Allgemeinen gemischte Metalloxide der Gruppen 12, 13 und 14 des Periodensystems der Elemente eingesetzt, zum Beispiel Indium-Zinn-Oxid (ITO). Es ist ebenfalls möglich, dass die Anode (1) ein organisches Material, zum Beispiel Polyanilin enthält, wie beispielsweise in Nature, Vol. 357, Seiten 477 bis 479 (11. Juni 1992) beschrieben ist. Zumindest entweder die Anode oder die Kathode sollten mindestens teilweise transparent sein, um das gebildete Licht auskoppeln zu können.

Geeignete Lochtransportmaterialien für die Schicht (2) des erfindungsgemäßen OLEDs sind zum Beispiel in Kirk-Othmer Encyclopedia of Chemical Technology, 4. Auflage, Vol. 18, Seiten 837 bis 860, 1996 offenbart. Sowohl Löcher transportierende Moleküle als auch Polymere können als Lochtransportmaterial eingesetzt werden. Üblicherweise eingesetzte Löcher transportierende Moleküle sind ausgewählt aus der Gruppe bestehend aus 4,4'-Bis[N-(1-naphthyl)-N-phenyl-amino]biphenyl (α-NPD), N,N'-Diphenyl-N, N'-Bis(3-methylphenyl)-[1,1'-biphenyl]-4,4'-diamin (TPD), 1,1-Bis[(di-4-tolylamino)-phenyl]cyclohexan (TAPC), N,N'-Bis(4-methylphenyl)-N, N'-Bis(4-ethylphenyl)-[1,1'-(3,3'-dimethyl)biphenyl]-4,4'-diamin (ETPD), Tetrakis-(3-methylphenyl)-N,N,N',N'-2,5-phenylendiamin (PDA), α-Phenyl-4-N,N-diphenylaminostyrol (TPS), p-(Diethylamino)-benzaldehyddiphenylhydrazon (DEH), Triphenylamin (TPA), Bis[4-(N,N-diethylamino)-2-methylphenyl)(4-methyl-phenyl)methan (MPMP), 1-Phenyl-3-[p-(diethylamino)styryl]-5-[p-(diethylamino)phenyl]pyrazolin (PPR oder DEASP), 1,2-trans-Bis(9H-carbazol-9-yl)cyclobutan (DCZB), N,N,N',N'-tetrakis(4-methylphenyl)-(1,1'-biphenyl)-4,4'-diamin (TTB), Fluorenverbindungen wie 2,2',7,7'-Tetra(N, N-di-tolyl)amino-9,9-spiro-bifluoren (Spiro-TTB), N,N'-Bis(naphthalen-1-yl)-N,N'-bis(phenyl)-9,9-spirobifluoren (Spiro-NPB) und 9,9-Bis(4-(N,N-bis-biphenyl-4-yl-amino)phenyl-9H-fluoren, Benzidinverbindungen wie N,N'-Bis(naphthalen-1-yl)-N,N'-bis(phenyl)-benzidin und Porphyrinverbindungen wie Kupferphthalocyanine. Üblicherweise eingesetzte Löcher transportierende Polymere sind ausgewählt aus der Gruppe bestehend aus Polyvinylcarbazolen, (Phenyl-methyl)polysilanen und Polyanilinen. Es ist ebenfalls möglich, Löcher transportierende Polymere durch Dotieren Löcher transportierender Moleküle in Polymere wie Polystyrol und Polycarbonat zu erhalten. Geeignete Löcher transportierende Moleküle sind die bereits vorstehend genannten Moleküle.

Weiterhin können - in einer Ausführungsform - Carbenkomplexe als Lochleitermaterialien eingesetzt werden, wobei die Bandlücke des mindestens einen Lochleitermaterials im Allgemeinen größer ist als die Bandlücke des eingesetzten Emittermaterials. Dabei ist unter Bandlücke im Sinne der vorliegenden Anmeldung die Triplett-Energie zu verstehen. Geeignete Carben-Komplexe sind z.B. die erfindungsgemäßen Carben-Komplexe der allgemeinen Formel (I), Carben-Komplexe wie sie in WO 2005/019373 A2, WO 2006/056418 A2, WO 2005/113704, WO 2007/115970, WO 2007/115981 und WO 2008/000727 beschrieben sind. Ein Beispiel für einen geeigneten Carben-Komplex ist Ir(DPBIC)₃ mit der Formel:

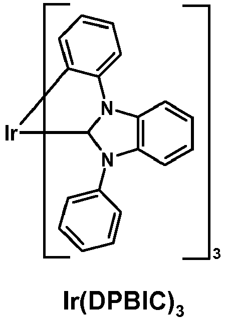

Es ist ebenfalls möglich Mischungen in der Löcher-transportierenden Schicht einzusetzen, im Besonderen Mischungen, die zu einer elektrischen p-Dotierung der Löcher-transportierenden Schicht führen. Eine p-Dotierung wird durch das Hinzufügen von oxidierenden Materialien erreicht. Diese Mischungen können beispielsweise die folgenden Mischungen sein: Mischungen aus den oben genannten Lochtransportmaterialien mit mindestens einem Metalloxid, z.B. MoO₂ MoO₃, WOₓ, ReO₃ und/oder V₂O₅, bevorzugt MoO₃ und/oder ReO₃, besonders bevorzugt ReO₃ oder Mischungen umfassend die vorstehend genannten Lochtransportmatierialien und eine oder mehrere Verbindungen ausgewählt aus 7,7,8,8-Tetracyanoquinodimethan (TCNQ), 2,3,5,6-Tetrafluoro-7,7,8,8-tetracyano-quinodimethan (F₄-TCNQ), 2,5-Bis(2-hydroxy-ethoxy)-7,7,8,8-tetracyanoquino-dimethan, Bis(tetra-n-butyl-ammonium)tetracyanodiphenoquino-dimethan, 2,5-Dimethyl-7,7,8,8-tetracyanoquinodimethan, Tetracyanoethylen, 11,11,12,12-Tetracyano-naphtho-2,6-quinodimethan, 2-Fluoro-7,7,8,8-tetracyanoquinodimethan, 2,5-Difluoro-7,7,8,8-tetracyanoquinodimethan, Dicyanomethylen-1,3,4,5,7,8-hexafluoro-6H-naphthalen-2-yliden)-malononitril (F₆-TNAP), Mo(tfd)₃ (aus Kahn et al., J. Am. Chem. Soc. 2009, 131 (35), 12530-12531), Verbindungen wie sie in EP1988587 und in EP2180029 beschrieben sind und Chinonverbindungen wie sie in EP 09153776.1 erwähnt sind.

Geeignete Elektronen transportierende Materialien für die Schicht (4) der erfindungsgemäßen OLEDs umfassen mit oxinoiden Verbindungen chelatisierte Metalle wie Tris(8-hydroxychinolato)aluminium (Alq₃), Verbindungen auf Phenanthrolinbasis wie 2,9-Dimethyl-4,7-Diphenyl-1,10-phenanthrolin (DDPA = BCP), 4,7-Diphenyl-1,10-phenanthrolin (Bphen), 4,7-Diphenyl-1,10-phenanthrolin (DPA) oder Phenanthrolin-Derivate, die in EP1786050 oder in EP1097981 offenbart sind, und Azolverbindungen wie 2-(4-Biphenylyl)-5-(4-t-butylphenyl)-1,3,4-oxadiazol (PBD) und 3-(4-Biphenylyl)-4-phenyl-5-(4-t-butylphenyl)-1,2,4-triazol (TAZ). Dabei kann die Schicht (4) sowohl zur Erleichterung des Elektronentransports dienen als auch als Pufferschicht oder als Sperrschicht, um ein Quenchen des Excitons an den Grenzflächen der Schichten der OLED zu vermeiden. Vorzugsweise verbessert die Schicht (4) die Beweglichkeit der Elektronen und reduziert ein Quenchen des Excitons.

Es ist ebenfalls möglich Mischungen von mindestens zwei Materialien in der elektronen-transportierenden Schicht einzusetzen, wobei mindestens ein Material elektronen-leitend ist. Bevorzugt wird in solchen gemischten elektronentransportierenden Schichten mindestens eine Phenanthrolin-Verbindung eingesetzt. Besonders bevorzugt werden in gemischten elektronentransportierenden Schichten neben mindestens einer Phenantrolin-Verbindung zusätzlich Alkalimetall-hydroxychinolat-Komplexe wie beispielsweise Liq eingesetzt. Darüberhinaus können Mischungen eingesetzt werden, die zu einer elektrischen n-Dotierung der elektronen-transportierenden Schicht führen. Eine n-Dotierung wird durch das Hinzufügen von reduzierenden Materialien erreicht. Diese Mischungen können beispielsweise sein, Mischungen aus den oben genannten Elektrontransportmaterialien mit (Erd-) Alkalimetallen oder (Erd-)-Alkalimetallsalzen wie beispielsweise Li, Cs, Ca, Sr, Cs₂CO₃, mit Alkalimetall-Komplexen wie beispielsweise 8-Hydroxychinolato-lithium (Liq), sowie mit Y, Ce, Sm, Gd, Tb, Er, Tm, Yb, Li₃N, Rb₂CO₃, Dikaliumphthalat, W(hpp)₄ aus EP 1786050 oder mit Verbindungen, wie sie in EP1837926 B1 beschrieben sind.

Die vorliegende Erfindung betrifft daher auch eine erfindungsgemäße OLED, wobei sie eine Elektronen-transportierende Schicht enthält, umfassend mindestens zwei verschiedenen Materialien, wovon mindestens ein Material Elektronen-leitend sein soll, enthält.

In einer bevorzugten Ausführungsform betrifft die vorliegende Erfindung eine erfindungsgemäße OLED, wobei die Elektronen-transportierende Schicht mindestens ein Phenanthrolin-Derivat enthält.

In einer weiteren bevorzugten Ausführungsform betrifft die Erfindung eine erfindungsgemäße OLED, wobei die Elektronen-transportierende Schicht mindestens ein Phenanthrolin-Derivat und mindestens einen Alkalimetall-Hydroxychinolat-Komplex enthält.

In einer weiteren bevorzugten Ausführungsform betrifft die Erfindung eine erfindungsgemäße OLED, wobei die Elektronen-transportierende Schicht mindestens ein Phenanthrolin-Derivat und 8-Hydroxychinolato-lithium enthält.

Von den vorstehend als Lochtransportmaterialien und Elektronen-transportierende Materialien genannten Materialien können einige mehrere Funktionen erfüllen. Zum Beispiel sind einige der Elektronen- transportierenden Materialien gleichzeitig Löcher blockende Materialien, wenn sie ein tief liegendes HOMO aufweisen.

Die Ladungstransportschichten können auch elektronisch dotiert sein, um die Transporteigenschaften der eingesetzten Materialien zu verbessern, um einerseits die Schichtdicken großzügiger zu gestalten (Vermeidung von Pinholes/Kurzschlüssen) und um andererseits die Betriebsspannung des Devices zu minimieren. Beispielsweise können die Lochtransportmaterialien mit Elektronenakzeptoren dotiert werden, zum Beispiel können Phthalocyanine bzw. Arylamine wie TPD oder TDTA mit Tetrafluorotetracyano-chinodimethan (F4-TCNQ) dotiert werden. Die elektronische Dotierung ist dem Fachmann bekannt und zum Beipsiel in W. Gao, A. Kahn, J. Appl. Phys., Vol. 94, No. 1, 1 July 2003 (p-dotierte organische Schichten); A. G. Werner, F. Li, K. Harada, M. Pfeiffer, T. Fritz, K. Leo, Appl. Phys. Lett., Vol. 82, No. 25, 23 June 2003 und Pfeiffer et al., Organic Electronics 2003, 4, 89 - 103 und K. Walzer, B. Maennig, M. Pfeiffer, K. Leo, Chem. Soc. Rev. 2007, 107, 1233 offenbart.

Die Kathode (5) ist eine Elektrode, die zur Einführung von Elektronen oder negativen Ladungsträgern dient. Die Kathode kann jedes Metall oder Nichtmetall sein, das eine geringere Arbeitsfunktion aufweist als die Anode. Geeignete Materialien für die Kathode sind ausgewählt aus der Gruppe bestehend aus Alkalimetallen der Gruppe 1, zum Beispiel Li, Cs, Erdalkalimetallen der Gruppe 2, Metallen der Gruppe 12 des Periodensystems der Elemente, umfassend die Seltenerdmetalle und die Lanthanide und Aktinide. Des Weiteren können Metalle wie Aluminium, Indium, Calcium, Barium, Samarium und Magnesium sowie Kombinationen davon eingesetzt werden. Weiterhin können Lithium enthaltende organometallische Verbindungen wie 8-Hydroxychinolato-lithium (Liq) oder LiF oder mindestens eine der folgenden Verbindungen Cs₂CO₃, KF, CsF oder NaF zwischen der organischen Schicht und der Kathode als Elektroneninjektionsschicht aufgebracht werden, um die Betriebsspannung (Operating Voltage) zu vermindern.

Die OLED gemäß der vorliegenden Erfindung kann zusätzlich weitere Schichten enthalten, die dem Fachmann bekannt sind. Beispielsweise kann zwischen der Schicht (2) und der Licht emittierenden Schicht (3) eine Schicht aufgebracht sein, die den Transport der positiven Ladung erleichtert und/oder die Bänderlücke der Schichten aneinander anpasst. Alternativ kann diese weitere Schicht als Schutzschicht dienen. In analoger Weise können zusätzliche Schichten zwischen der Licht emittierenden Schicht (3) und der Schicht (4) vorhanden sein, um den Transport der negativen Ladung zu erleichtern und/oder die Bänderlücke zwischen den Schichten aneinander anzupassen. Alternativ kann diese Schicht als Schutzschicht dienen.

In einer bevorzugten Ausführungsform enthält die erfindungsgemäße OLED zusätzlich zu den Schichten (1) bis (5) mindestens eine der im Folgenden genannten weiteren Schichten:
- eine Loch-Injektionsschicht zwischen der Anode (1) und der Löcher-transportierenden Schicht (2);
- eine Blockschicht für Elektronen zwischen der Löcher-transportierenden Schicht (2) und der Licht-emittierenden Schicht (3);
- eine Blockschicht für Löcher zwischen der Licht-emittierenden Schicht (3) und der Elektronen-transportierenden Schicht (4);
- eine Elektronen-Injektionsschicht zwischen der Elektronen-transportierenden Schicht (4) und der Kathode (5).

Wie bereits vorstehend erwähnt, ist es jedoch auch möglich, dass die OLED nicht alle der genannten Schichten (1) bis (5) aufweist, zum Beispiel ist ein OLED mit den Schichten (1) (Anode), (3) (Licht-emittierende Schicht) und (5) (Kathode) ebenfalls geeignet, wobei die Funktionen der Schichten (2) (Löcher-transportierende Schicht) und (4) (Elektronen-transportierende Schicht) durch die angrenzenden Schichten übernommen werden. OLEDs, die die Schichten (1), (2), (3) und (5) bzw. die Schichten (1), (3), (4) und (5) aufweisen, sind ebenfalls geeignet.

Dem Fachmann ist bekannt, wie er (zum Beispiel auf Basis von elektrochemischen Untersuchungen) geeignete Materialien auswählen muss. Geeignete Materialien für die einzelnen Schichten sind dem Fachmann bekannt und z. B. in WO 00/70655 offenbart.

Des Weiteren ist es möglich, dass einige oder alle der Schichten (1), (2), (3), (4) und (5) oberflächenbehandelt sind, um die Effizienz des Ladungsträgertransports zu erhöhen. Die Auswahl der Materialien für jede der genannten Schichten ist bevorzugt dadurch bestimmt, eine OLED mit einer hohen Effizienz zu erhalten.

Die Herstellung der erfindungsgemäßen OLED kann nach dem Fachmann bekannten Methoden erfolgen. Im Allgemeinen wird die OLED durch aufeinanderfolgende Dampfabscheidung (Vapor deposition) der einzelnen Schichten auf ein geeignetes Substrat hergestellt. Geeignete Substrate sind zum Beispiel Glas, anorganische Materialien wie ITO oder IZO oder Polymerfilme. Zur Dampfabscheidung können übliche Techniken eingesetzt werden wie thermische Verdampfung, Chemical Vapor Deposition (CVD), Physical Vapor Deposition (PVD) und andere.

In einem alternativen Verfahren können die organischen Schichten aus Lösungen oder Dispersionen in geeigneten Lösungsmitteln beschichtet werden, wobei dem Fachmann bekannte Beschichtungstechniken angewendet werden. Geeignete Beschichtungstechniken sind beispielsweise das Spin-coating, die Casting-Methode, die Langmuir-Blodgett ("LB")-Methode, die Tintenstrahldruck-Methode, Dip-coating, Letterpress-Druck, Screen-Druck, Doctor-blade-printing, Roller-printing, Reverse-Roller-printing, Offset-Lithography-Druck, flexographischer Druck, Webprinting, Sprühbeschichtung, Beschichtung durch einen Pinsel oder Padprinting und ähnliche. Unter den genannten Verfahren sind - neben der vorstehend erwähnten Dampfabscheidung - das Spin-coating, die Tintenstrahldruck-Methode und die Casting-Methode bevorzugt, da sie besonders einfach und kostengünstig durchzuführen sind. Für den Fall, dass Schichten der OLED durch die Spin-Coating-Methode, die Casting-Methode oder die Tintenstrahldruckmethode erzeugt werden, kann die Beschichtung unter Verwendung einer Lösung, hergestellt durch Auflösen der Zusammensetzung in einer Konzentration von 0,0001 bis 90 Gew.-% in einem geeigneten organischen Lösungsmittel wie Benzol, Toluol, Xylol, Tetrahydrofuran, Methyltetrahydrofuran, N,N-Dimethylformamid, Aceton, Acetonitril, Anisol, Dichlormethan, Dimethylsulfoxid und Mischungen davon, erhalten werden.

Es ist möglich, dass die Schichten der OLED alle mit derselben Beschichtungsmethode hergestellt werden. Des Weiteren ist es ebenfalls möglich, dass zur Herstellung der Schichten der OLED zwei oder mehr verschiedene Beschichtungsmethoden durchgeführt werden.

Im Allgemeinen haben die verschiedenen Schichten folgende Dicken: Anode (2) 500 bis 5000 Å (Angstrom), bevorzugt 1000 bis 2000 Å; Löcher-transportierende Schicht (3) 50 bis 1000 Å, bevorzugt 200 bis 800 Å, Licht-emittierende Schicht (4) 10 bis 1000 Å, bevorzugt 100 bis 800 Å, Elektronen transportierende Schicht (5) 50 bis 1000 Å, bevorzugt 200 bis 800 Å, Kathode (6) 200 bis 10.000 Å, bevorzugt 300 bis 5000 Å. Die Lage der Rekombinationszone von Löchern und Elektronen in der erfindungsgemäßen OLED und somit das Emissionsspektrum der OLED können durch die relative Dicke jeder Schicht beeinflusst werden. Das bedeutet, die Dicke der Elektronentransportschicht sollte bevorzugt so gewählt werden, dass die Elektronen/Löcher Rekombinationszone in der Licht-emittierenden Schicht liegt. Das Verhältnis der Schichtdicken der einzelnen Schichten in der OLED ist von den eingesetzten Materialien abhängig. Die Schichtdicken von gegebenenfalls eingesetzten zusätzlichen Schichten sind dem Fachmann bekannt.

In einer bevorzugten Ausführungsform betrifft die vorliegende Erfindung auch eine O-LED enthaltend mindestens einen erfindungsgemäßen heteroleptischen Komplex der allgemeinen Formel (I), sowie mindestens eine Verbindung der allgemeinen Formel (X) 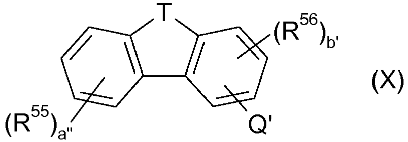 worin bedeuten
- T: NR⁵⁷, S, O oder PR⁵⁷, bevorzugt S oder O, besonders bevorzugt O;
- R⁵⁷: Aryl, Heteroaryl, Alkyl, Cycloalkyl oder Heterocycloalkyl;
- Q': -NR⁵⁸R⁵⁹, -P(O)R⁶⁰R⁶¹, -PR⁶²R⁶³, -S(O)₂R⁶⁴, -S(O)R⁶⁵, -SR⁶⁶ oder -OR⁶⁷, bevorzugt -NR⁵⁸R⁵⁹; besonders bevorzugt 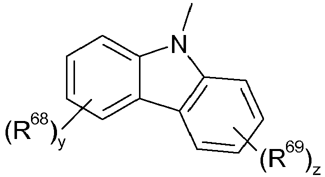 worin bedeuten
R⁶⁸, R⁶⁹ unabhängig voneinander Alkyl, Cycloalkyl, Heterocycloalkyl, Aryl oder Heteroaryl; bevorzugt Methyl, Carbazolyl, Dibenzofuryl oder Dibenzothienyl;
y, z unabhängig voneinander 0, 1, 2, 3 oder 4, bevorzugt 0 oder 1;
- R⁵⁵, R⁵⁶: unabhängig voneinander Alkyl, Cycloalkyl, Heterocycloalkyl, Aryl, Heteroaryl, SiR⁷⁰R⁷¹R⁷², eine Gruppe Q' oder eine Gruppe mit Donor- oder Akzeptorwirkung;
- a": 0, 1, 2, 3 oder 4;
- b': 0, 1, 2 oder 3;
- R⁵⁸, R⁵⁹: bilden gemeinsam mit dem N-Atom einen cyclischen Rest mit 3 bis 10 Ringatomen, der unsubstituiert oder mit einem oder mehreren Substituenten ausgewählt aus Alkyl, Cycloalkyl, Heterocycloalkyl, Aryl, Heteroaryl und einer Gruppe mit Donor- oder Akzeptorwirkung substituiert sein kann und/oder mit einem oder mehreren weiteren cyclischen Resten mit 3 bis 10 Ringatomen anelliert sein kann, wobei die anellierten Reste unsubstituiert oder mit einem oder mehreren Substituenten ausgewählt aus Alkyl, Cycloalkyl, Heterocycloalkyl, Aryl, Heteroaryl, und einer Gruppe mit Donor- oder Akzeptorwirkung substituiert sein können;
- R⁷⁰, R⁷¹, R⁷², R⁶⁰, R⁶¹, R⁶², R⁶³, R⁶⁴, R⁶⁵, R⁶⁶, R⁶⁷: unabhängig voneinander Aryl, Heteroaryl, Alkyl, Cycloalkyl oder Heterocycloalkyl,
oder
zwei Einheiten der allgemeinen Formel (X) sind über eine lineare oder verzweigte, gesättigte oder ungesättigte, gegebenenfalls durch wenigstens ein Heteroatom unterbrochene Verbrückung, über eine Bindung oder über O miteinander verbrückt.

Bevorzugt sind Verbindungen der Formel (X), worin bedeuten:
- T: S oder O, bevorzugt O, und
- Q': 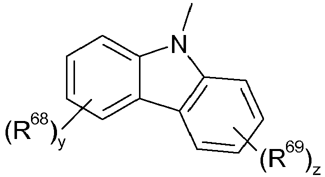 worin bedeuten
R⁶⁸, R⁶⁹ unabhängig voneinander Alkyl, Cycloalkyl, Heterocycloalkyl, Aryl oder Heteroaryl; bevorzugt Methyl, Carbazolyl, Dibenzofuryl oder Dibenzothienyl;
y, z unabhängig voneinander 0, 1, 2, 3 oder 4, bevorzugt 0 oder 1.

Besonders bevorzugte Verbindungen der Formel (X) weisen die folgende Formel (Xa) auf: 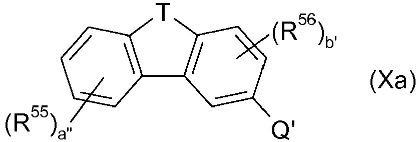 worin die Symbole und Indizes Q', T, R⁵⁵, R⁵⁶, a" und b' die vorstehend genannten Bedeutungen aufweisen.

Ganz besonders bevorzugte Verbindungen der Formel (X) weisen die Formel (Xaa) auf: 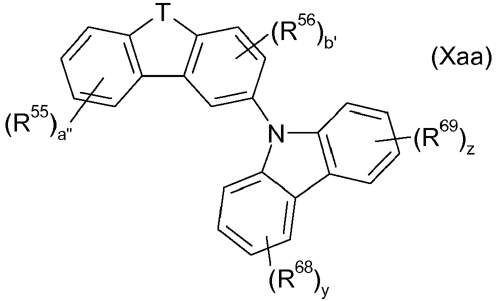 worin die Symbole und Indizes R⁶⁸, R⁶⁹ y, z, T, R⁵⁵, R⁵⁶, a" und b' die vorstehend genannten Bedeutungen aufweisen.

In einer ganz besonders bevorzugten Ausführungsform bedeuten in Formel (Xaa):
- T: O oder S, bevorzugt O;
- a": 1;
- b': 0;
- y, z: unabhängig voneinander 0 oder 1; und
- R⁶⁸, R⁶⁹: unabhängig voneinander Methyl, Carbazolyl, Dibenzofuryl oder Dibenzothienyl
- R⁵⁵: substituiertes Phenyl, Carbazolyl, Dibenzofuryl oder Dibenzothienyl.

In einer weiteren bevorzugten Ausführungsform weisen die Verbindungen der Formel (X) die Formel (XI) oder (XI*) auf: 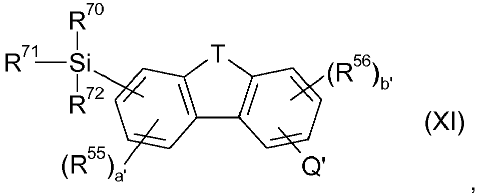 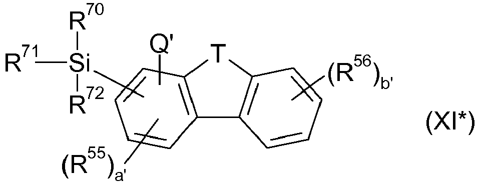 worin bedeuten
- T: NR⁵⁷, S, O oder PR⁵⁷;
- R⁵⁷: Aryl, Heteroaryl, Alkyl, Cycloalkyl oder Heterocycloalkyl;
- Q': -NR⁵⁸R⁵⁹, -P(O)R⁶⁰R⁶¹, -PR⁶²R⁶³, -S(O)₂R⁶⁴, -S(O)R⁶⁵, -SR⁶⁶ oder-OR⁶⁷;
- R⁷⁰, R⁷¹, R⁷²: unabhängig voneinander Aryl, Heteroaryl, Alkyl, Cycloalkyl, Heterocycloalkyl, wobei wenigstens einer der Reste R⁷⁰, R⁷¹, R⁷² mindestens zwei Kohlenstoffatome enthält oder OR⁷³,
- R⁵⁵, R⁵⁶: unabhängig voneinander Alkyl, Cycloalkyl, Heterocycloalkyl, Aryl, Heteroaryl, eine Gruppe Q oder eine Gruppe mit Donor- oder Akzeptorwirkung;
- a', b': für die Verbindung der Formel (XI): unabhängig voneinander 0, 1,2, 3; für die Verbindung der Formel (XI*) bedeuten a' 0, 1, 2 und b' 0, 1, 2,3,4;
- R⁵⁸, R⁵⁹: bilden gemeinsam mit dem N-Atom einen cyclischen Rest mit 3 bis 10 Ringatomen, der unsubstituiert oder mit einem oder mehreren Substituenten ausgewählt aus Alkyl, Cycloalkyl, Heterocycloalkyl, Aryl, Heteroaryl und einer Gruppe mit Donor- oder Akzeptorwirkung substituiert sein kann und/oder mit einem oder mehreren weiteren cyclischen Resten mit 3 bis 10 Ringatomen anelliert sein kann, wobei die anellierten Reste unsubstituiert oder mit einem oder mehreren Substituenten ausgewählt aus Alkyl, Cycloalkyl, Heterocycloalkyl, Aryl, Heteroaryl, und einer Gruppe mit Donor- oder Akzeptorwirkung substituiert sein können;
- R⁷³: unabhängig voneinander SiR⁷⁴R⁷⁵R⁷⁶, Aryl, Heteroaryl, Alkyl, Cycloalkyl oder Heterocycloalkyl, gegebenenfalls substituiert mit einer Gruppe OR⁷⁷
- R⁷⁷: unabhängig voneinander SiR⁷⁴R⁷⁵R⁷⁶, Aryl, Heteroaryl, Alkyl, Cycloalkyl oder Heterocycloalkyl,
- R⁶⁰, R⁶¹, R⁶², R⁶³, R⁶⁴, R⁶⁵, R⁶⁶, R⁶⁷, R⁷⁴, R⁷⁵, R⁷⁶,: unabhängig voneinander Aryl, Heteroaryl, Alkyl, Cycloalkyl oder Heterocycloalkyl,
oder
zwei Einheiten der allgemeinen Formeln (XI) und/oder (XI*) sind über eine lineare oder verzweigte, gesättigte oder ungesättigte, gegebenenfalls durch wenigstens ein Heteroatom unterbrochene Verbrückung oder über O miteinander verbrückt, wobei diese Verbrückung in den allgemeinen Formeln (XI) und/oder (XI*) jeweils anstelle von R⁷¹ an die Si-Atome angebunden ist.

Die Verbindungen der allgemeinen Formel (X) können als Matrix (Verdünnungsmaterial), Lochblocker, Excitonenblocker, Elektronentransportmaterial oder Lochtransportmaterial in Kombination mit den beanspruchten heteroleptischen Komplexen, die dann bevorzugt als Emitter dienen, eingesetzt werden. Erfindungsgemäße OLEDs, die sowohl mindestens eine Verbindung der Formel (X) als auch eine Verbindung der Formel (I) beinhalten, zeigen besonders gute Effizienzen und Lebensdauern. Je nachdem in welcher Funktion die Verbindung der Formel (X) eingesetzt wird, liegt sie rein oder in verschiedenen Mischungsverhältnissen vor. In einer besonders bevorzugten Ausführungsform werden eine oder mehrere Verbindungen der Formel (X) als Matrixmaterial in der Licht-emittierenden Schicht eingesetzt.

Für die Verbindungen der allgemeinen Formel (X), insbesondere für die Reste R⁵⁵ bis R⁷⁷, gilt:
Die Begriffe Arylrest oder -gruppe, Heteroarylrest oder -gruppe, Alkylrest oder - gruppe, Cycloalkylrest oder -gruppe, Heterocycloalkylrest oder -gruppe, Alkenylrest oder -gruppe, Alkinylrest oder -gruppe, und Gruppen mit Donor- und/oder Akzeptorwirkung haben die folgenden Bedeutungen:
   Unter einem Arylrest (oder -gruppe) ist ein Rest mit einem Grundgerüst von 6 bis 30 Kohlenstoffatomen, bevorzugt 6 bis 18 Kohlenstoffatomen zu verstehen, der aus einem aromatischen Ring oder mehreren kondensierten aromatischen Ringen aufgebaut ist. Geeignete Grundgerüste sind zum Beispiel Phenyl, Naphthyl, Anthracenyl oder Phenanthrenyl, Indenyl oder Fluorenyl. Dieses Grundgerüst kann unsubstituiert sein (d. h., dass alle Kohlenstoffatome, die substituierbar sind, Wasserstoffatome tragen), oder an einer, mehreren oder allen substituierbaren Positionen des Grundgerüsts substituiert sein.

Geeignete Substituenten sind zum Beispiel Deuterium, Alkoxyreste, Aryloxyreste, Alkylaminogruppen, Arylaminogruppen, Carbazoylgruppen, Silylgruppen, SiR⁷⁸R⁷⁹R⁸⁰, wobei geeignete Silylgruppen SiR⁷⁸R⁷⁹R⁸⁰ nachstehend genannt sind, Alkylreste, bevorzugt Alkylreste mit 1 bis 8 Kohlenstoffatomen, besonders bevorzugt Methyl, Ethyl oder i-Propyl, Arylreste, bevorzugt C₆-Arylreste, die wiederum substituiert oder unsubstituiert sein können, Heteroarylreste, bevorzugt Heteroarylreste, die mindestens ein Stickstoffatom enthalten, besonders bevorzugt Pyridylreste und Carbazolylreste, Alkenylreste, bevorzugt Alkenylreste, die eine Doppelbindung tragen, besonders bevorzugt Alkenylreste mit einer Doppelbindung und 1 bis 8 Kohlenstoffatomen, Alkinylreste, bevorzugt Alkinylreste mit einer Dreifachbindung, besonders bevorzugt Alkinylreste mit einer Dreifachbindung und 1 bis 8 Kohlenstoffatomen oder Gruppen mit Donor- oder Akzeptorwirkung. Geeignete Gruppen, mit Donor- oder Akzeptorwirkung sind nachstehend genannt. Ganz besonders bevorzugt tragen die substituierten Arylreste Substituenten ausgewählt aus der Gruppe bestehend aus Methyl, Ethyl, Isopropyl, Alkoxy, Heteroaryl, Halogen, Pseudohalogen und Amino, bevorzugt Arylamino. Bevorzugt ist der Arylrest oder die Arylgruppe ein C₆-C₁₈-Arylrest, besonders bevorzugt ein C₆-Arylrest, der gegebenenfalls mit mindestens einem oder mehreren der vorstehend genannten Substituenten substituiert ist. Besonders bevorzugt weist der C₆-C₁₈-Arylrest, bevorzugt C₆-Arylrest, keinen, einen, zwei, drei oder vier, ganz besonders bevorzugt keinen, einen oder zwei der vorstehend genannten Substituenten auf.

Unter einem Heteroarylrest oder einer Heteroarylgruppe sind Reste zu verstehen, die sich von den vorstehend genannten Arylresten dadurch unterscheiden, dass in dem Grundgerüst der Arylreste mindestens ein Kohlenstoffatom durch ein Heteroatom ersetzt ist, sowie dadurch, dass das Grundgerüst der Heteroarylreste bevorzugt 5 bis 18 Ringatome aufweist. Bevorzugte Heteroatome sind N, O und S. Besonders bevorzugt geeignete Heteroarylreste sind stickstoffhaltige Heteroarylreste. Ganz besonders bevorzugt sind ein oder zwei Kohlenstoffatome des Grundgerüsts durch Heteroatome, bevorzugt Stickstoff, ersetzt. Insbesondere bevorzugt ist das Grundgerüst ausgewählt aus Systemen wie Pyridin, Pyrimidin und fünfgliedrigen Heteroaromaten wie Pyrrol, Furan, Pyrazol, Imidazol, Thiophen, Oxazol, Thiazol, Triazol. Des Weiteren kann es sich bei den Heteroarylresten um kondensierte Ringsysteme handeln, z. B. um Benzofuryl,- Benzothienyl-, Benzopyrrolyl-, Dibenzofuryl-, Dibenzothienyl-, Phenanthrolinyl-, Carbazolylreste, Azacarbazolylreste oder Diazacarbazoylreste. Das Grundgerüst kann an einer, mehreren oder allen substituierbaren Positionen des Grundgerüsts substituiert sein. Geeignete Substituenten sind dieselben, die bereits bezüglich der Arylgruppen genannt wurden.

Unter einem Alkylrest oder einer Alkylgruppe ist ein Rest mit 1 bis 20 Kohlenstoffatomen, bevorzugt 1 bis 10 Kohlenstoffatomen, besonders bevorzugt 1 bis 8, ganz besonders bevorzugt 1 bis 4 Kohlenstoffatomen zu verstehen. Dieser Alkylrest kann verzweigt oder unverzweigt sein und gegebenenfalls mit einem oder mehreren Heteroatomen, bevorzugt Si, N, O oder S, besonders bevorzugt N, O oder S, unterbrochen sein. Des Weiteren kann dieser Alkylrest mit einem oder mehreren der bezüglich der Arylgruppen genannten Substituenten substituiert sein. Des Weiteren können die erfindungsgemäß vorliegenden Alkylreste wenigstens ein Halogenatom, beispielsweise F, Cl, Br oder I, insbesondere F, aufweisen. In einer weiteren Ausführungsform können die erfindungsgemäß vorliegenden Alkyreste vollständig fluoriert sein. Es ist ebenfalls möglich, dass der Alkylrest eine oder mehrere (Hetero-)-Arylgruppen trägt. Im Sinne der vorliegenden Anmeldung stellen z. B. Benzylreste somit substituierte Alkylreste dar. Dabei sind alle der vorstehend aufgeführten (Hetero-)Arylgruppen geeignet. Besonders bevorzugt sind die Alkylreste ausgewählt aus der Gruppe bestehend aus Methyl, Ethyl, iso-Propyl, n-Propyl, n-Butyl, iso-Butyl und tert-Butyl, ganz besonders bevorzugt sind Methyl und Ethyl.

Unter einem Cycloalkylrest oder einer Cycloalkylgruppe ist ein Rest mit 3 bis 20 Kohlenstoffatomen, bevorzugt 3 bis 10 Kohlenstoffatomen, besonders bevorzugt 3 bis 8 Kohlenstoffatomen zu verstehen. Dieses Grundgerüst kann unsubstituiert sein (d. h., dass alle Kohlenstoffatome, die substituierbar sind, Wasserstoffatome tragen), oder an einer, mehreren oder allen substituierbaren Positionen des Grundgerüsts substituiert sein. Geeignete Substituenten sind die bereits vorstehend bezüglich der Arylreste genannten Gruppen. Es ist ebenfalls möglich, dass der Cycloalkylrest eine oder mehrere (Hetero-)Arylgruppen trägt. Beispiele für geeignete Cycloalkylreste sind Cyclopropyl, Cyclopentyl und Cyclohexyl.

Unter einem Heterocycloalkylrest oder einer Heterocycloalkylgruppe sind Reste zu verstehen, die sich von den vorstehend genannten Cycloalkylresten dadurch unterscheiden, dass in dem Grundgerüst der Cycloalkylreste mindestens ein Kohlenstoffatom durch ein Heteroatom ersetzt ist. Bevorzugte Heteroatome sind N, O und S. Ganz besonders bevorzugt sind ein oder zwei Kohlenstoffatome des Grundgerüsts der Cycloalkylreste durch Heteroatome ersetzt. Beispiele für geeignete Heterocycloalkylreste sind Reste abgeleitet von Pyrrolidin, Piperidin, Piperazin, Tetrahydrofuran, Dioxan.

Unter einem Alkenylrest oder einer Alkenylgruppe ist ein Rest zu verstehen, der den vorstehend genannten Alkylresten mit mindestens zwei Kohlenstoffatomen entspricht, mit dem Unterschied, dass mindestens eine C-C-Einfachbindung des Alkylrests durch eine C-C-Doppelbindung ersetzt ist. Bevorzugt weist der Alkenylrest eine oder zwei Doppelbindungen auf.

Unter einem Alkinylrest oder einer Alkinylgruppe ist ein Rest zu verstehen, der den vorstehend genannten Alkylresten mit mindestens zwei Kohlenstoffatomen entspricht, mit dem Unterschied, dass mindestens eine C-C-Einfachbindung des Alkylrests durch eine C-C-Dreifachbindung ersetzt ist. Bevorzugt weist der Alkinylrest eine oder zwei Dreifachbindungen auf.

Unter einer Gruppe SiR⁷⁸R⁷⁹R⁸⁰ ist ein Silylrest zu verstehen, worin

R⁷⁸, R⁷⁹ und R⁸⁰ unabhängig voneinander Alkyl, Cycloalkyl, Heterocycloalkyl, Aryl, Heteroaryl oder OR⁷³ bedeuten.

Unter einer Gruppe SiR⁷⁴R⁷⁵R⁷⁶ ist ein Silylrest zu verstehen, worin

R⁷⁴, R⁷⁵ und R⁷⁶ unabhängig voneinander Alkyl, Cycloalkyl, Heterocycloalkyl, Aryl, Heteroaryl oder OR⁷³ bedeuten.

Unter einer Gruppe oder einem Substituenten mit Donor- oder Akzeptorwirkung sind im Sinne der vorliegenden Anmeldung die folgenden Gruppen zu verstehen:
Unter Gruppen mit Donorwirkung sind Gruppen zu verstehen, die einen +I- und/oder +M-Effekt aufweisen, und unter Gruppen mit Akzeptorwirkung sind Gruppen zu verstehen, die einen -I- und/oder -M-Effekt aufweisen. Bevorzugte geeignete Gruppen sind ausgewählt aus C₁-C₂₀-Alkoxy, C₆-C₃₀-Aryloxy, C₁-C₂₀-Alkylthio, C₆-C₃₀-Arylthio, SiR⁸¹R⁸²R⁸³, OR⁷³, Halogenresten, halogenierten C₁-C₂₀-Alkylresten, Carbonyl (-CO(R⁸¹)), Carbonylthio (- C = O (SR⁸¹)), Carbonyloxy (- C = O(OR⁸¹)), Oxycarbonyl (-OC = O(R⁸¹)), Thiocarbonyl (- SC = O(R⁸¹)), Amino (-NR⁸¹R⁸²), Pseudohalogenresten, Amido (- C = O (NR⁸¹)), -NR⁸¹C = O (R⁸³), Phosphonat (- P(O) (OR⁸¹)₂, Phosphat (-OP(O) (OR⁸¹)₂), Phosphin (-PR⁸¹R⁸²), Phosphinoxid (-P(O)R⁸¹₂), Sulfat (-OS(O)₂OR⁸¹), Sulfoxid (-S(O)R⁸¹), Sulfonat (-S(O)₂OR⁸¹), , Sulfonyl (-S(O)₂R⁸¹), Sulfonamid (-S(O)₂NR⁸¹R⁸²), NO₂, Boronsäureestern (-OB(OR⁸¹)₂), Imino (-C = NR⁸¹R⁸²)), Boranresten, Stannanresten, Hydrazinresten, Hydrazonresten, Oximresten, Nitroso-Gruppen, Diazo-Gruppen, Vinylgruppen, Sulfoximinen, Alanen, Germanen, Boroximen und Borazinen.

Die in den vorstehend genannten Gruppen mit Donor- oder Akzeptorwirkung erwähnten Reste R⁸¹, R⁸² und R⁸³ bedeuten unabhängig voneinander:
Substituiertes oder unsubstituiertes C₁-C₂₀-Alkyl oder substituiertes oder unsubstituiertes C₆-C₃₀-Aryl, oder OR⁷⁶ wobei geeignete und bevorzugte Alkyl- und Arylreste vorstehend genannt sind. Besonders bevorzugt bedeuten die Reste R⁸¹, R⁸² und R⁸³ C₁-C₆-Alkyl, z. B. Methyl, Ethyl oder i-Propyl oder Phenyl. In einer bevorzugten Ausführungsform - im Falle von SiR⁸¹R⁸²R⁸³ - bedeuten R⁸¹, R⁸² und R⁸³ bevorzugt unabhängig voneinander substituiertes oder unsubstituiertes C₁-C₂₀-Alkyl oder substituiertes oder unsubstituiertes Aryl, bevorzugt Phenyl.

Bevorzugte Substituenten mit Donor- oder Akzeptorwirkung sind ausgewählt aus der Gruppe bestehend aus:
C₁- bis C₂₀-Alkoxy, bevorzugt C₁-C₆-Alkoxy, besonders bevorzugt Ethoxy oder Methoxy; C₆-C₃₀-Aryloxy, bevorzugt C₆-C₁₀-Aryloxy, besonders bevorzugt Phenyloxy; SiR⁸¹R⁸²R⁸³,wobei R⁸¹,R⁸² und R⁸³ bevorzugt unabhängig voneinander substituiertes oder unsubstituiertes Alkyl oder substituiertes oder unsubstituiertes Aryl. bevorzugt Phenyl, bedeuten; besonders bevorzugt ist mindestens einer der Reste R⁸¹ ,R⁸² oder R⁸³ substituiertes oder unsubstituiertes Phenyl, wobei geeignete Substituenten vorstehend genannt sind; Halogenresten, bevorzugt F, Cl, besonders bevorzugt F, halogenierten C₁-C₂₀-Alkylresten, bevorzugt halogenierten C₁-C₆-Alkylresten, ganz besonders bevorzugt fluorierten C₁-C₆-Alkylresten, z. B. CF₃, CH₂F, CHF₂ oder C₂F₅; Amino, bevorzugt Dimethylamino, Diethylamino oder Diarylamino, besonders bevorzugt Diarylamino; Pseudohalogenresten, bevorzugt CN, -C(O)OC₁-C₄-Alkyl, bevorzugt -C(O)OMe, P(O)R₂, bevorzugt P(O)Ph₂.

Ganz besonders bevorzugte Substituenten mit Donor- oder Akzeptorwirkung sind ausgewählt aus der Gruppe bestehend aus Methoxy, Phenyloxy, halogeniertem C₁-C₄-Alkyl, bevorzugt CF₃, CH₂F, CHF₂, C₂F₅, Halogen, bevorzugt F, CN, SiR⁸¹R⁸²R⁸³, wobei geeignete Reste R⁸¹, R⁸² und R⁸³ bereits genannt sind, Diarylamino (NR⁸⁴R⁸⁵, wobei R⁸⁴, R⁸⁵ jeweils C₆-C₃₀-Aryl bedeuten), -C(O)OC₁-C₄-Alkyl, bevorzugt -C(O)OMe, P(O)Ph₂.

Unter Halogengruppen sind bevorzugt F, Cl und Br, besonders bevorzugt F und Cl, ganz besonders bevorzugt F, zu verstehen.

Unter Pseudohalogengruppen sind bevorzugt CN, SCN und OCN, besonders bevorzugt CN, zu verstehen.

Die vorstehend genannten Gruppen mit Donor- oder Akzeptorwirkung schließen nicht aus, dass weitere der in der vorliegenden Anmeldung genannte Reste und Substituenten, die nicht in der vorstehenden Liste der Gruppen mit Donor- oder Akzeptorwirkung aufgeführt sind, eine Donor- oder Akzeptorwirkung aufweisen.

Die Arylreste oder -gruppen, Heteroarylreste oder -gruppen, Alkylreste oder -gruppen, Cycloalkylreste oder -gruppen, Heterocycloalkylreste oder -gruppen, Alkenylreste oder -gruppen und Gruppen mit Donor- und/oder Akzeptorwirkung können - wie vorstehend erwähnt - substituiert oder unsubstituiert sein. Unter einer unsubstituierten Gruppe ist im Sinne der vorliegenden Anmeldung eine Gruppe zu verstehen, worin die substituierbaren Atome der Gruppe Wasserstoffatome tragen. Unter einer substituierten Gruppe ist im Sinne der vorliegenden Anmeldung eine Gruppe zu verstehen, worin ein oder mehrere substituierbare Atom(e) mindestens an einer Position anstelle eines Wasserstoffatoms einen Substituenten tragen. Geeignete Substituenten sind die vorstehend bezüglich der Arylreste oder -gruppen genannten Substituenten.

Kommen Reste mit denselben Nummerierungen mehrfach in den Verbindungen gemäß der vorliegenden Anmeldung vor, so können diese Reste jeweils unabhängig voneinander die genannten Bedeutungen aufweisen.

Der Rest T in den Verbindungen der Formel (X) bedeutet NR⁵⁷, S, O oder PR⁵⁷, bevorzugt NR⁵⁷, S oder O, besonders bevorzugt O oder S, ganz besonders bevorzugt O.

Der Rest R⁵⁷ bedeutet Aryl, Heteroaryl, Alkyl, Cycloalkyl oder Heterocycloalkyl, bevorzugt Aryl, Heteroaryl oder Alkyl, besonders bevorzugt Aryl, wobei die vorstehend genannten Reste unsubstituiert oder substituiert sein können. Geeignete Substituenten sind vorstehend genannt. Besonders bevorzugt bedeutet R⁶⁵ Phenyl, das mit den vorstehend genannten Substituenten substituiert oder unsubstituiert sein kann. Ganz besonders bevorzugt bedeutet R⁵⁷ unsubstituiertes Phenyl.

Die Gruppe Q' in den Verbindungen der Formel (X) bedeutet -NR⁵⁸R⁵⁹, -P(O)R⁶⁰R⁶¹, - PR⁶²R⁶³, -S(O)₂R⁶⁴, -S(O)R⁶⁵, -SR⁶⁶ oder -OR⁶⁷; bevorzugt NR⁵⁸R⁵⁹, -P(O)R⁶⁰R⁶¹ oder -OR⁶⁷, besonders bevorzugt-NR⁵⁸R⁵⁹.

Die Reste R⁵⁸ bis R⁶⁷ und R⁷⁴ bis R⁷⁶ weisen dabei die folgenden Bedeutungen auf:
- R⁵⁸, R⁵⁹: bilden gemeinsam mit dem N-Atom einen cyclischen Rest mit 3 bis 10 Ringatomen, der unsubstituiert oder mit einem oder mehreren Substituenten ausgewählt aus Alkyl, Cycloalkyl, Heterocycloalkyl, Aryl, Heteroaryl und einer Gruppe mit Donor- oder Akzeptorwirkung substituiert sein kann und/oder mit einem oder mehreren weiteren cyclischen Resten mit 3 bis 10 Ringatomen anelliert sein kann, wobei die anellierten Reste unsubstituiert oder mit einem oder mehreren Substituenten ausgewählt aus Alkyl, Cycloalkyl, Heterocycloalkyl, Aryl, Heteroaryl, und einer Gruppe mit Donor- oder Akzeptorwirkung substituiert sein können;
- R⁶⁰ R⁶¹, R⁶², R⁶³, R⁶⁴, R⁶⁵, R⁶⁶, R⁶⁷, R⁷⁴, R⁷⁵, R⁷⁶: nabhängig voneinander Aryl, Heteroaryl, Alkyl, Cycloalkyl oder Heterocycloalkyl, bevorzugt Aryl oder Heteroaryl, wobei die Reste unsubstituiert oder mit einem oder mehreren der Reste ausgewählt aus Alkyl, Cycloalkyl, Heterocycloalkyl, Aryl, Heteroaryl und einer Gruppe mit Donor oder Akzeptorwirkung substituiert sein können, besonders bevorzugt unsubstituiertes oder substituiertes Phenyl, wobei geeignete Substituenten vorstehend genannt sind, z.B. Tolyl oder eine Gruppe der Formel 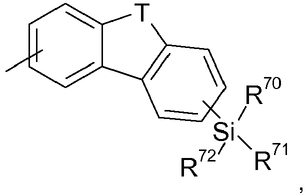 worin die Gruppe T und die Reste R⁷⁰, R⁷¹ und R⁷² unabhängig voneinander die bezüglich der Verbindungen der Formel (XI) oder (XI*) genannten Bedeutungen aufweisen.

Ganz besonders bevorzugt bedeuten R⁶⁰, R⁶¹, R⁶², R⁶³, R⁶⁴, R⁶⁵, R⁶⁶ und R⁶⁷ unabhängig voneinander Phenyl, Tolyl oder eine Gruppe der Formel 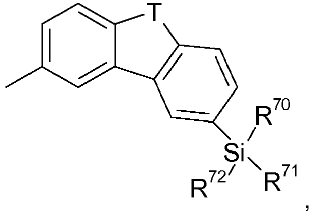 worin T NPh, S oder O bedeutet.

Beispiele für bevorzugt geeignete Gruppen -NR⁵⁸R⁵⁹ sind ausgewählt aus der Gruppe bestehend aus Pyrrolyl, 2,5-Dihydro-1-pyrrolyl, Pyrrolidinyl, Indolyl, Indolinyl, Isoindolinyl, Carbazolyl, Azacarbazolyl, Diazacarbazolyl, Imidazolyl, Imidazolinyl, Benzimidazolyl, Pyrazolyl, Indazolyl, 1,2,3-Triazolyl, Benzotriazolyl, 1,2,4-Triazolyl, Tetrazolyl, 1,3-Oxazolyl, 1,3-Thiazolyl, Piperidyl, Morpholinyl, 9,10-Dihydroacridinyl und 1,4-Oxazinyl, wobei die vorstehend genannten Gruppen unsubstituiert oder mit einem oder mehreren Substituenten ausgewählt aus Alkyl, Cycloalkyl, Heterocycloalkyl, Aryl, Heteroaryl und einer Gruppe mit Donor- oder Akzeptorwirkung substituiert sein können, bevorzugt ist die Gruppe -NR⁶R⁷ ausgewählt aus Carbazolyl, Pyrrolyl, Indolyl, Imidazolyl, Benzimidazolyl, Azacarbazolyl und Diazacarbazolyl, wobei die vorstehend genannten Gruppen unsubstituiert oder mit einem oder mehreren Substituenten ausgewählt aus Alkyl, Cycloalkyl, Heterocycloalkyl, Aryl, Heteroaryl und einer Gruppe mit Donor- oder Akzeptorwirkung substituiert sein können, besonders bevorzugt bedeutet die Gruppe -NR⁵⁸R⁵⁹ Carbazolyl, das unsubstituiert oder mit einem oder mehreren Substituenten ausgewählt aus Alkyl, Cycloalkyl, Heterocycloalkyl, Aryl, Heteroaryl und einer Gruppe mit Donor-oder Akzeptorwirkung substituiert sein kann.

Besonders bevorzugte Gruppen -NR⁵⁸R⁵⁹ sind: 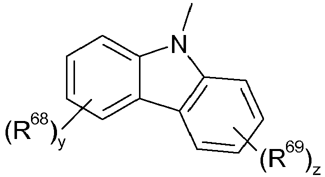 worin bedeuten
- R⁶⁸, R⁶⁹: unabhängig voneinander Alkyl, Cycloalkyl, Heterocycloalkyl, Aryl oder Heteroaryl; bevorzugt Methyl, Carbazolyl, Dibenzofuryl oder Dibenzothienyl;
- y, z: unabhängig voneinander 0, 1, 2, 3 oder 4, bevorzugt 0 oder 1;
zum Beispiel: 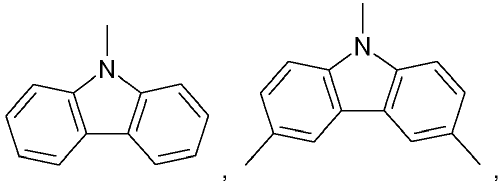 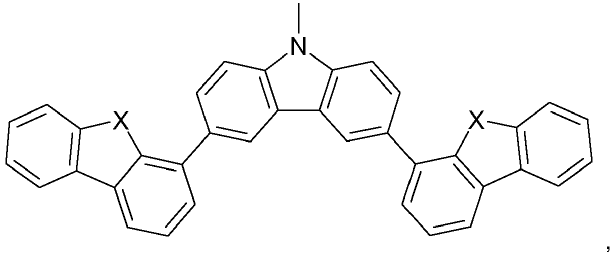 worin X NPh, S oder O bedeutet; 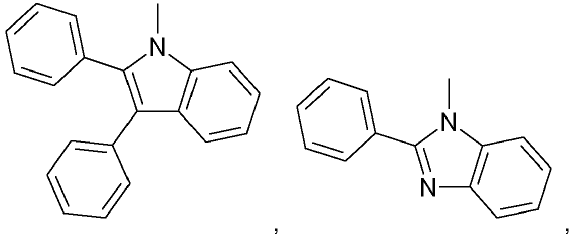 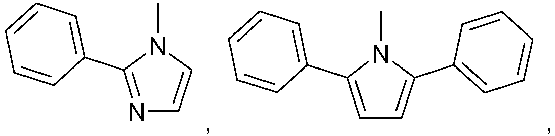 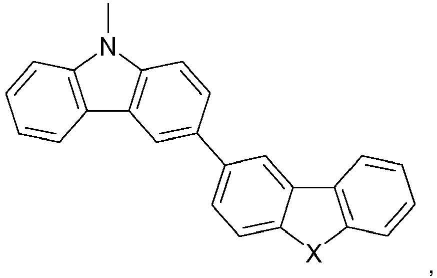 worin X NPh, S oder O bedeutet,

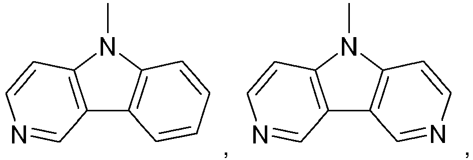

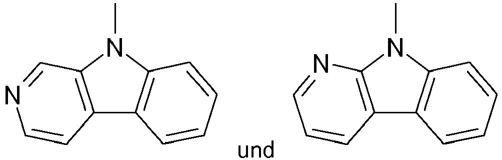

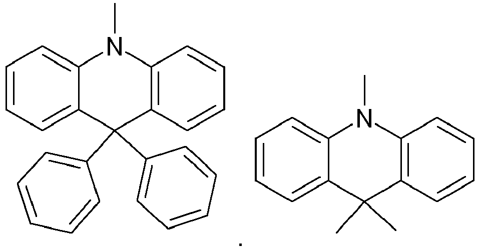

Besonders bevorzugte Gruppen -P(O)R⁶⁰R⁶¹ sind: 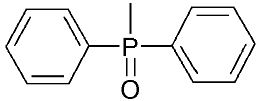 und

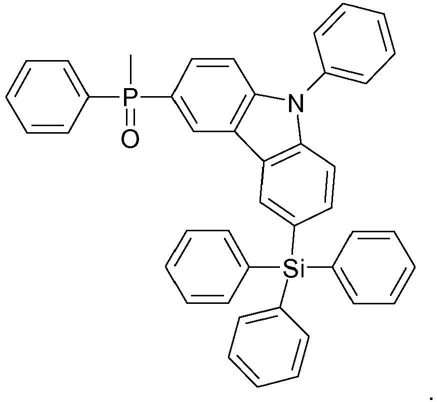

Eine besonders bevorzugte Gruppe PR⁶²R⁶³ ist:

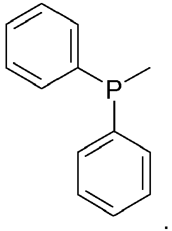

Besonders bevorzugte Gruppen -S(O)₂R⁶⁴ und -S(O)R⁶⁵ sind:

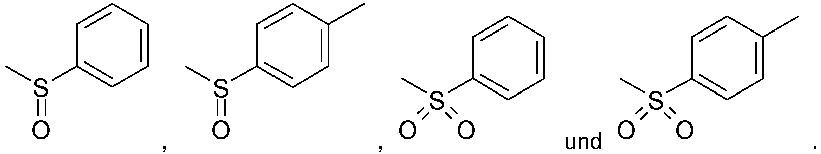

Besonders bevorzugte Gruppen -SR⁶⁶ und -OR⁶⁷ sind: 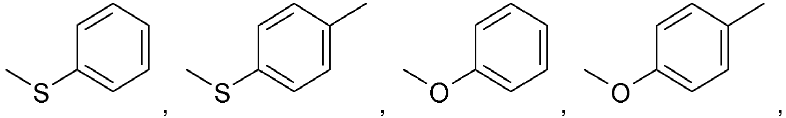 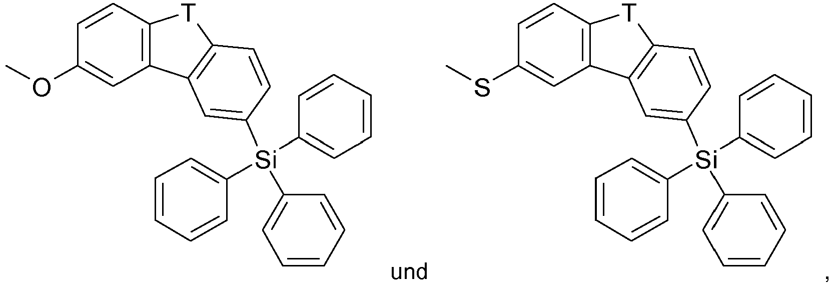 worin T jeweils NPh, S oder O bedeutet.

R⁵⁵, R⁵⁶ in den Verbindungen der Formel (X) bedeuten unabhängig voneinander Alkyl, Cycloalkyl, Heterocycloalkyl, Aryl, Heteroaryl, eine weitere Gruppe A oder eine Gruppe mit Donor- oder Akzeptorwirkung; bevorzugt unabhängig voneinander Alkyl, Aryl, Heteroaryl oder eine Gruppe mit Donor- oder Akzeptorwirkung. Beispielsweise können R⁵⁵ oder R⁵⁶ unabhängig voneinander bedeuten: 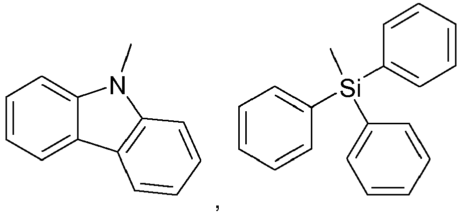 oder 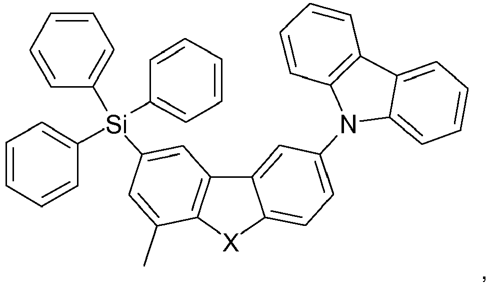 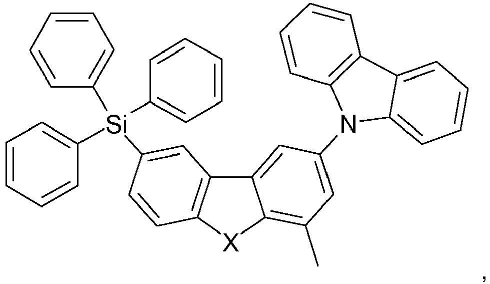 worin X NPh, S oder O bedeutet.

Dabei können in den Verbindungen der Formel (X) a" Gruppen R⁵⁵ und/oder b' Gruppen R⁵⁶ vorliegen, wobei a" und b' bedeuten:
- a": 0, 1, 2, 3 oder 4; bevorzugt unabhängig voneinander 0, 1 oder 2;
- b': 0, 1, 2, oder 3; bevorzugt unabhängig voneinander 0, 1 oder 2.

Ganz besonders bevorzugt ist mindestens a" oder b' 0, insbesondere ganz besonders bevorzugt sind a" und b' 0 oder a" bedeutet 1 und b' bedeutet 0.

R⁷³ bedeutet in den Verbindungen der allgemeinen Formel (XI) im Allgemeinen unabhängig voneinander SiR⁷⁴R⁷⁵R⁷⁶, Aryl, Heteroaryl, Alkyl, Cycloalkyl oder Heterocycloalkyl, gegebenenfalls substituiert mit einer Gruppe OR⁷⁷.

R⁷⁷ bedeutet in Verbindungen der allgemeinen Formel (XI) im Allgemeinen unabhängig voneinander Aryl, Heteroaryl, Alkyl, Cycloalkyl oder Heterocycloalkyl.

Der gegebenenfalls vorliegende Substituent OR⁷⁷ kann in den genannten Resten im Allgemeinen an allen dem Fachmann für geeignet erscheinenden Stellen vorliegen.

In einer weiteren Ausführungsform sind zwei Einheiten der allgemeinen Formel (XI) und/oder (XI*) über eine lineare oder verzweigte, gesättigte oder ungesättigte, gegebenenfalls durch wenigstens ein Heteroatom unterbrochene Verbrückung oder über O miteinander verbrückt, wobei diese Verbrückung in der allgemeinen Formel (XI) und/oder (XI*) jeweils anstelle von R⁷¹ an die Si-Atome angebunden ist.

Bevorzugt ist diese Verbrückung ausgewählt aus der Gruppe bestehend aus -CH₂-,-C₂H₄-, -C₃H₆-, -C₄H₈-, -C₆H₁₂-, -C₈H₁₆-, -C₉H₁₈-, -CH(C₈H₁₇)CH₂-, -C₂H₄(CF₂)₈ C₂H₄-,-C=C-, -1,4-(CH₂)₂-Phenyl-(CH₂)₂-, 1,3-(CH₂)₂-Phenyl-(CH₂)₂-, -1,4-Phenyl-, -1,3-Phenyl-, -O-, -O-Si(CH₃)₂-O-, -O-Si(CH₃)₂-O- Si(CH₃)₂-O-, -O-

In einer bevorzugten Ausführungsform der vorliegenden Anmeldung weisen die Verbindungen der allgemeinen Formel (X) die allgemeine Formel (Xla), (Xlb), (Xlc), (Xld) oder (Xle) auf, d.h. sie sind bevorzugte Ausführungsformen der Verbindungen der allgemeinen Formel (XI) oder (XI*): 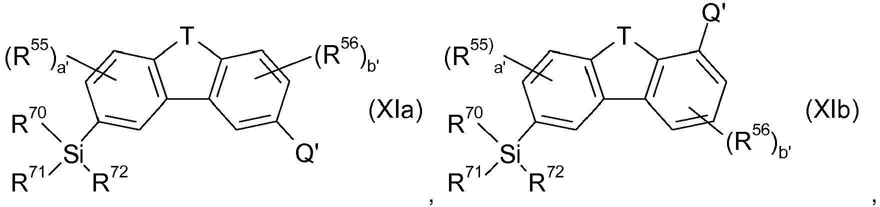 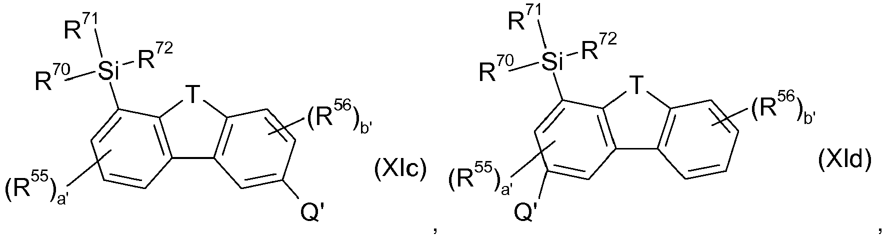 oder 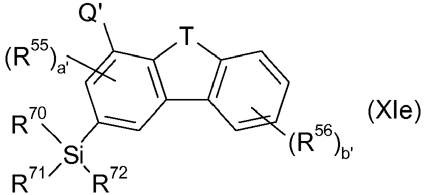 worin die Reste und Gruppen Q', T, R⁷⁰, R⁷¹, R⁷², R⁵⁵, R⁵⁶ sowie a' und b' die vorstehend genannten Bedeutungen aufweisen.

In einer weiteren erfindungsgemäß bevorzugten Ausführungsform bedeuten in den Verbindungen der allgemeinen Formel (XI) oder (XI*) R⁷⁰, R⁷¹ oder R⁷² aromatische Einheiten der allgemeinen Formeln (Xli) und/oder (XIi*) bedeuten 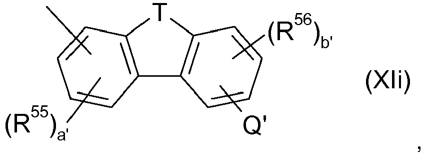 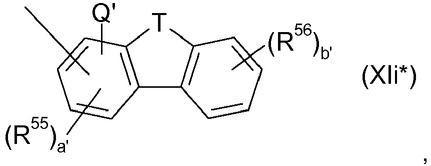 wobei R⁵⁵, R⁵⁶, Q', T, a' und b' die gleichen Bedeutungen wie oben angegeben.

Daher betrifft die vorliegende Erfindung in einer Ausführungsform eine erfindungsgemäße OLED, wobei in den Verbindungen der allgemeinen Formel (XI) oder (XI*) R⁷⁰, R⁷¹ oder R⁷² aromatische Einheiten der allgemeinen Formeln (Xli) und/oder (XIi*) bedeuten 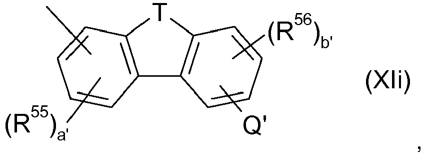 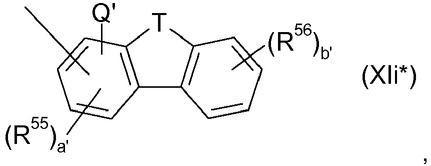 wobei R⁵⁵, R⁵⁶, Q', T, a' und b' die gleichen Bedeutungen wie oben angegeben.

Ganz besonders bevorzugt betrifft die vorliegende Erfindung eine OLED, wobei die Verbindung der allgemeinen Formel (XI) oder (XI*) ausgewählt ist aus der folgenden Gruppe:

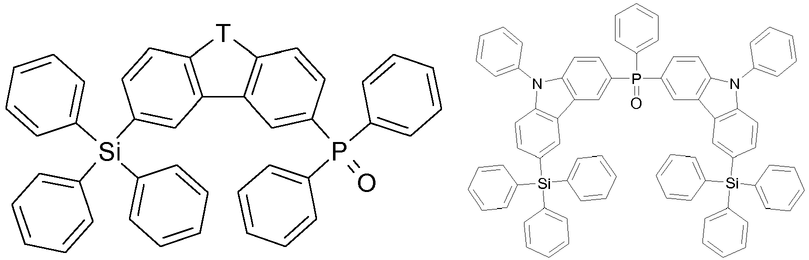

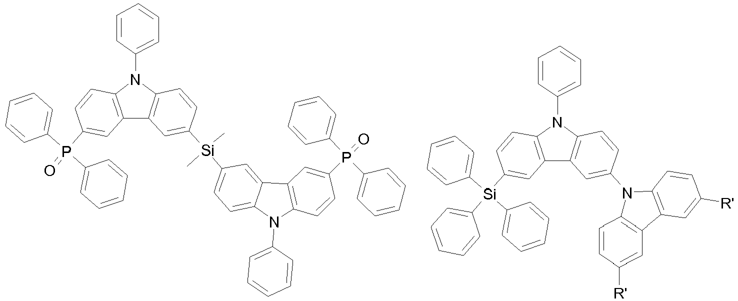

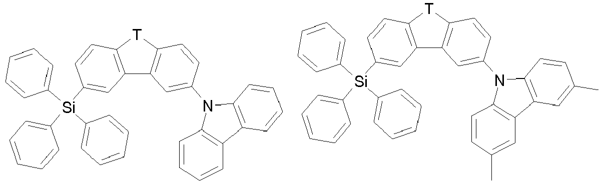

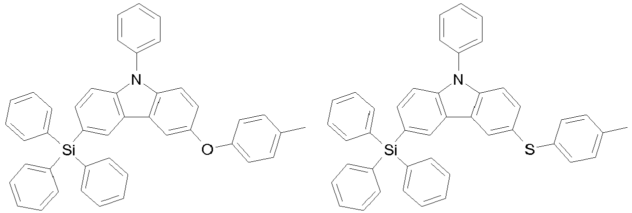

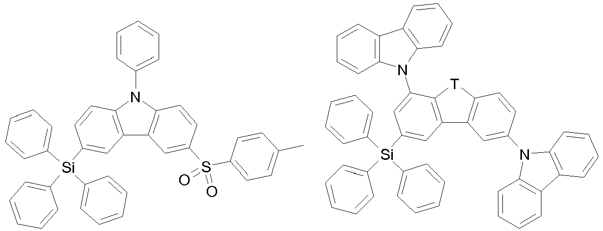

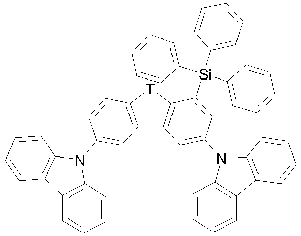

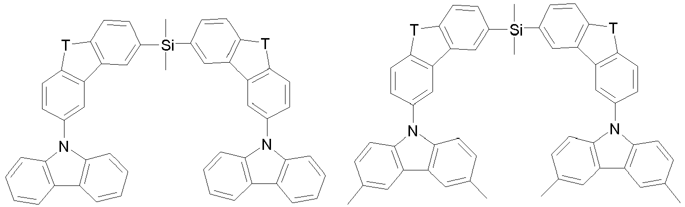

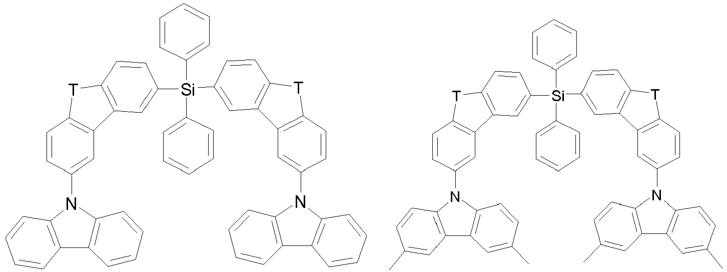

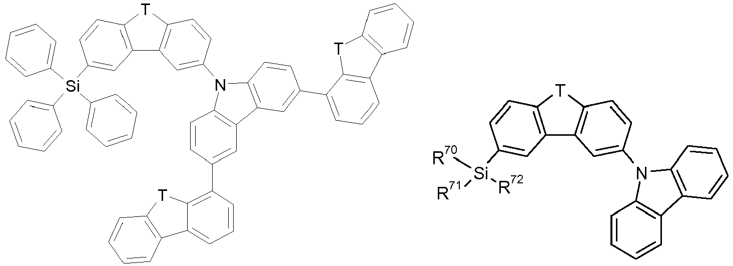

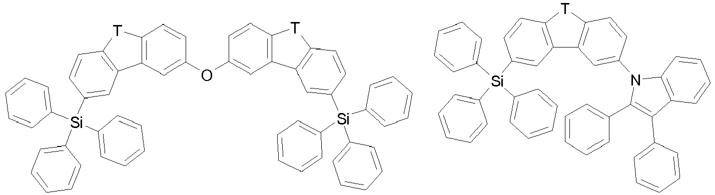

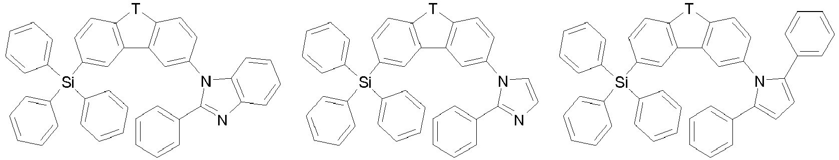

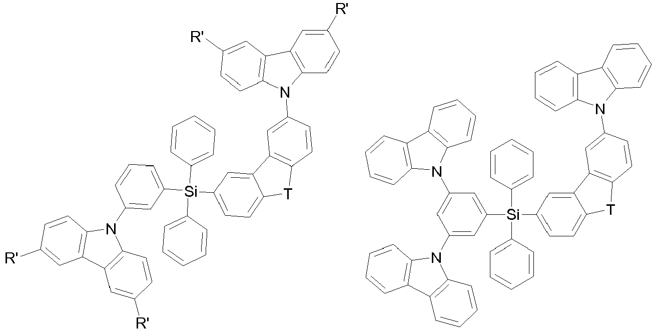

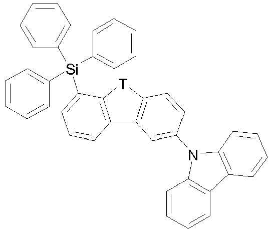

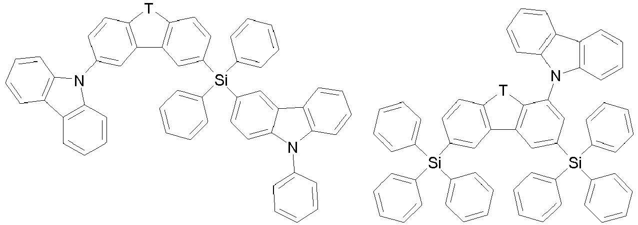

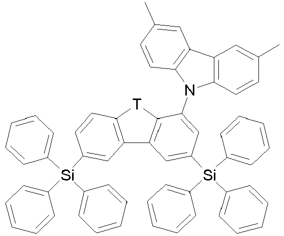

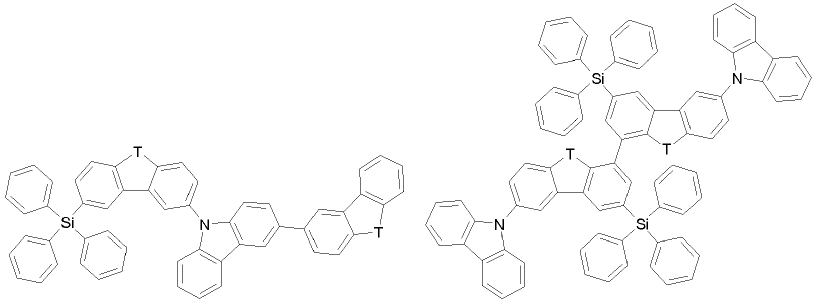

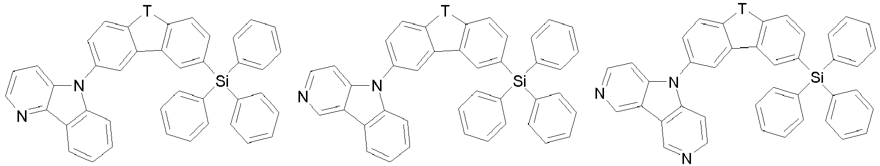

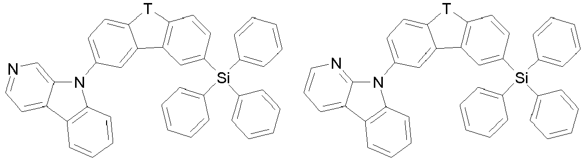

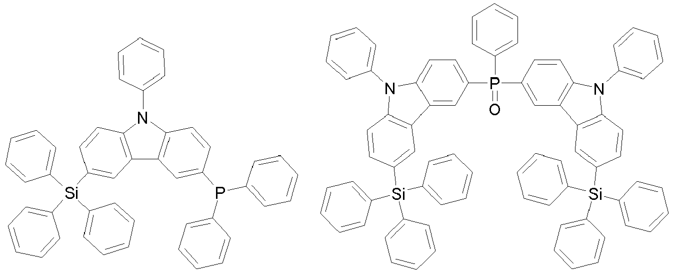

In diesen besonders bevorzugten Verbindungen der allgemeinen Formel (XI) oder (XI*) bedeuten:
- T: S oder O, und
- R': H oder CH₃; und
- R⁷⁰, R⁷¹, R⁷²: Phenyl, Carbazolyl, Dibenzofuran oder Dibenzothiophen.

Weitere besonders geeignete Verbindungen der allgemeinen Formel (XI) oder (XI*) sind:

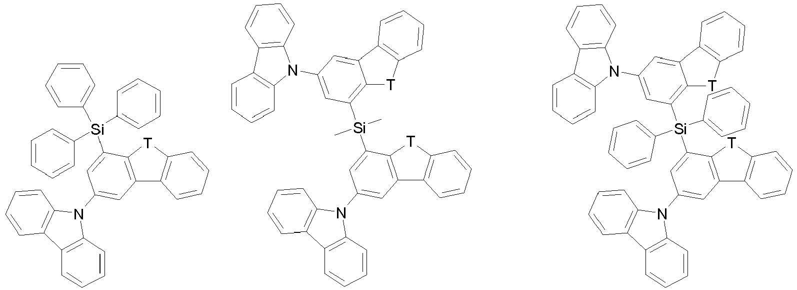

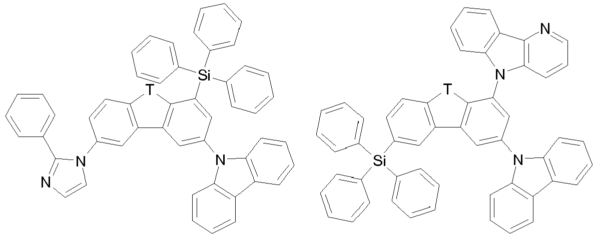

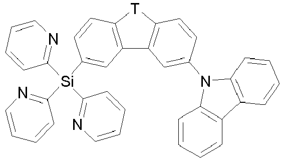

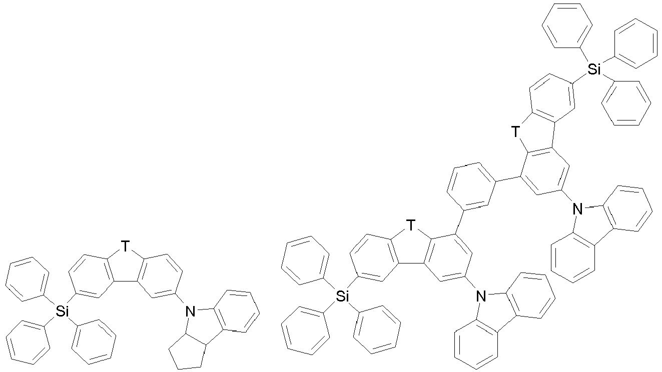

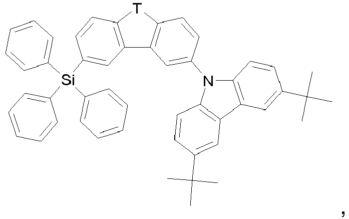

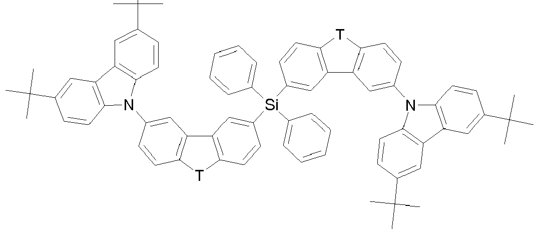

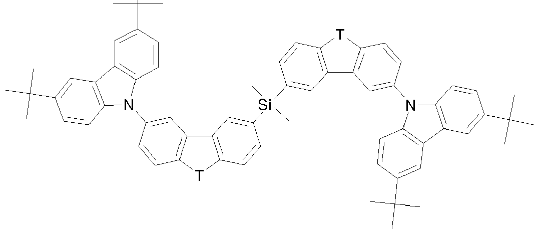

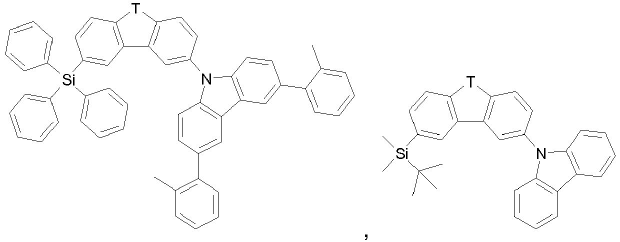

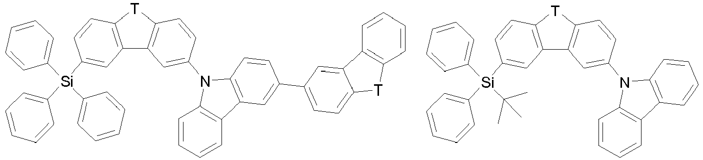

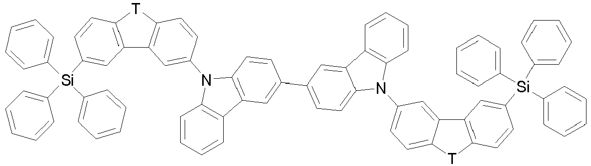

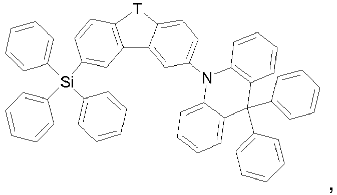

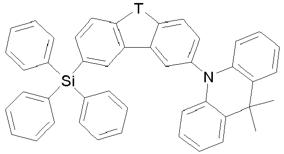

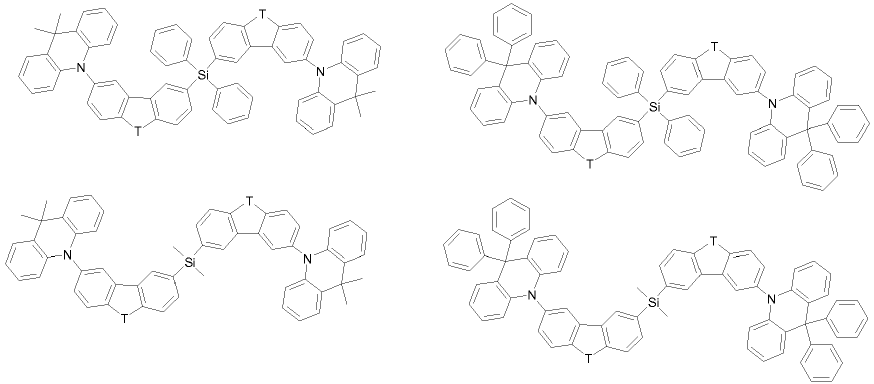

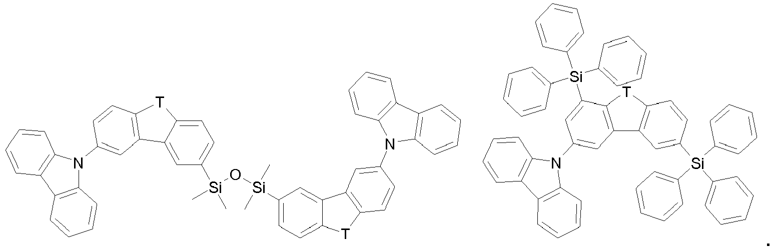

Auch in diesen besonders bevorzugten Verbindungen der allgemeinen Formel (XI) oder (XI*) bedeutet T O oder S, bevorzugt O.

Weitere erfindungsgemäße Verbindungen der allgemeinen Formel (XI) oder (XI*) entsprechen der folgenden Formel (XII)

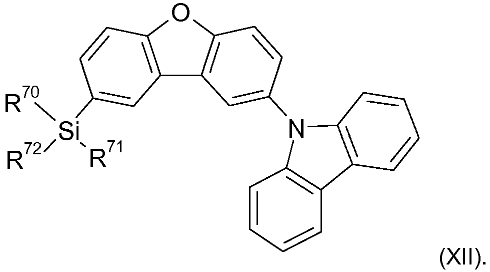

In der allgemeinen Formel (XII) haben R⁷⁰, R⁷¹, R⁷² die folgenden Bedeutungen:

| **Nr** | **R⁷⁰** | **R⁷¹** | **R⁷²** |
|---|---|---|---|
| **1** | Methyl | Methyl | Ethyl |
| **2** | Methyl | Methyl | i-Propyl |
| **3** | Methyl | Methyl | n-Propyl |
| **4** | Methyl | Methyl | n-Butyl |
| **5** | Methyl | Methyl | i-Butyl |
| **6** | Methyl | Methyl | t-Butyl |
| **7** | Methyl | Methyl | n-Pentyl |
| **8** | Methyl | Methyl | n-Hexyl |
| **9** | Methyl | Methyl | -CH₂CH₂C(CH₃)₃ |
| **10** | Methyl | Methyl | n-C₈H₁₇ |
| **11** | Methyl | Methyl | i-C₈H₁₇ |
| **12** | Methyl | Methyl | n-C₁₀H₂₁ |
| **13** | Methyl | Methyl | n-C₁₂H₂₅ |
| **16** | Methyl | Methyl | n-C₁₈H₃₇ |
| **17** | Methyl | Methyl | n-C₃₀H₆₁ |
| **19** | Methyl | Methyl | Cyclohexyl |
| **20** | Methyl | Methyl | C(CH₃)₂Ph |
| **21** | Methyl | Methyl | -C(CH₃)₂CH(CH₃)₂ |
| **22** | Methyl | Methyl | -CCH₂CH(CH₃)(C₂H₅) |
| **23** | Methyl | Methyl | -CH₂CH(C₄₀H₂₁)₂ |
| **24** | Methyl | Methyl | -CH₂CH(C₁₂H₂₅)₂ |
| **25** | Methyl | Methyl | -CH₂CH₂(C₃F₆)CF₃ |
| **26** | Methyl | Methyl | -CH₂CH₂(C₇F₁₄)CF₃ |
| **27** | Methyl | Methyl | -CH₂CH₂(C₅F₁₀)CF₃ |
| **29** | Methyl | Methyl | -CH₂CH₂CF₃ |
| **30** | Methyl | Methyl | Phenyl |
| **31** | Methyl | Methyl | 2-Biphenyl |
| **32** | Methyl | Methyl | p-Tolyl |
| **33** | Methyl | Methyl | C₆F₅ |
| **34** | Methyl | Methyl | 3,5-(CF₃)₂Phenyl |
| **35** | Methyl | Methyl | -CH₂C(CH₃)₂Phenyl |
| **36** | Methyl | Methyl | 9-Fluorenyl |
| **37** | Methyl | Methyl | 3,6-Di(tert-butyl)-9-Fluorenyl |
| **15** | Methyl | Methyl | R⁸⁶ |
| **38** | Methyl | Methyl | -OMe |
| **39** | Methyl | Methyl | -OEt |
| **40** | Methyl | Methyl | 2,4,6-t-Butylphenoxy |
| **41** | Methyl | Methyl | -O-tBu (tert-Butoxy) |
| **42** | Methyl | Methyl | -OSiEt₃ |
| **43** | Methyl | Ethyl | Ethyl |
| **44** | Methyl | Ethyl | Phenyl |
| **45** | Methyl | Ethyl | R⁸⁶ |
| **46** | Methyl | n-Propyl | n-Propyl |
| **47** | Methyl | n-Propyl | Phenyl |
| **48** | Methyl | n-Propyl | R⁸⁶ |
| **49** | Methyl | i-Propyl | i-Propyl |
| **50** | Methyl | i-Propyl | Phenyl |
| **51** | Methyl | i-Propyl | R⁸⁶ |
| **52** | Methyl | n-Butyl | n-Butyl |
| **53** | Methyl | n-Butyl | Phenyl |
| **54** | Methyl | n-Butyl | R⁸⁶ |
| **55** | Methyl | i-Butyl | i-Butyl |
| **56** | Methyl | i-Butyl | Phenyl |
| **57** | Methyl | i-Butyl | R⁸⁶ |
| **58** | Methyl | t-Butyl | t-Butyl |
| **59** | Methyl | t-Butyl | Phenyl |
| **60** | Methyl | t-Butyl | R⁸⁶ |
| **61** | Methyl | n-Pentyl | n-Pentyl |
| **62** | Methyl | n-Pentyl | n-Hexyl |
| **63** | Methyl | n-Pentyl | Phenyl |
| **64** | Methyl | n-Pentyl | R⁸⁶ |
| **65** | Methyl | n-Hexyl | Hexyl |
| **66** | Methyl | n-Hexyl | Phenyl |
| **67** | Methyl | n-Hexyl | R⁸⁶ |
| **68** | Methyl | n-Heptyl | R⁸⁶ |
| **69** | Methyl | n-Octyl | R⁸⁶ |
| **70** | Methyl | n-Decyl | R⁸⁶ |
| **71** | Methyl | n-C₁₂H₂₅ | R⁸⁶ |
| **72** | Methyl | n-C₁₈H₃₇ | R⁸⁶ |
| **73** | Methyl | n-C₂₂H₄₅ | R⁸⁶ |
| **74** | Methyl | n-C₃₀H₆₁ | R⁸⁶ |
| **75** | Methyl | Cyclopentyl | Cyclopentyl |
| **76** | Methyl | Cyclopentyl | Phenyl |
| **77** | Methyl | Cyclopentyl | R⁸⁶ |
| **78** | Methyl | Cyclohexyl | Cyclohexyl |
| **79** | Methyl | Cyclohexyl | Phenyl |
| **80** | Methyl | Cyclohexyl | R⁸⁶ |
| **81** | Methyl | -CF₂CHF₂ | R⁸⁶ |
| **82** | Methyl | -CH₂CH₂CF₃ | R⁸⁶ |
| **83** | Methyl | -CH₂CH₂(CF₂)₃CF₃ | R⁸⁶ |
| **84** | Methyl | -CH₂CH₂(CF₂)₅CF₃ | R⁸⁶ |
| **85** | Methyl | -CH₂CH₂(CF₂)₇CF₃ | R⁸⁶ |
| **86** | Methyl | Phenyl | Phenyl |
| **87** | Methyl | Phenyl | p-Tolyl |
| **89** | Methyl | Phenyl | Mesityl |
| **90** | Methyl | Phenyl | R⁸⁶ |
| **91** | Methyl | p-Tolyl | p-Tolyl |
| **92** | Methyl | p-Tolyl | R⁸⁶ |
| **93** | Methyl | Mesityl | Mesityl |
| **94** | Methyl | Mesityl | R5 |
| **95** | Methyl | R⁸⁶ | R⁸⁶ |
| **96** | Methyl | Methoxy | Methoxy |
| **97** | Methyl | Ethoxy | Ethoxy |
| **98** | Methyl | -OSiEt₃ | -OSiEt₃ |
| **99** | Methyl | -O-SiMe₂- CH₂CH₂(CF₂)₄CF₃ | -O-SiMe₂-CH₂CH₂(CF₂)₄CF₃ |
| **100** | Ethyl | Ethyl | Ethyl |
| **101** | Ethyl | Ethyl | n-Propyl |
| **102** | Ethyl | Ethyl | i-Propyl |
| **103** | Ethyl | Ethyl | n-Butyl |
| **104** | Ethyl | Ethyl | i-Butyl |
| **105** | Ethyl | Ethyl | t-Butyl |
| **106** | Ethyl | Ethyl | Phenyl |
| **107** | Ethyl | Ethyl | R5 |
| **108** | Ethyl | Phenyl | Phenyl |
| **109** | Ethyl | Phenyl | R⁸⁶ |
| **110** | Ethyl | R⁸⁶ | R⁸⁶ |
| **111** | Ethyl | Ethoxy | Ethoxy |
| **112** | n-Propyl | n-Propyl | n-Propyl |
| **113** | n-Propyl | n-Propyl | Phenyl |
| **114** | n-Propyl | n-Propyl | R⁸⁶ |
| **115** | n-Propyl | Phenyl | Phenyl |
| **116** | n-Propyl | Phenyl | R⁸⁶ |
| **117** | n-Propyl | R⁸⁶ | R⁸⁶ |
| **118** | i-Propyl | i-Propyl | i-Propyl |
| **119** | i-Propyl | i-Propyl | Phenyl |
| **120** | i-Propyl | i-Propyl | R⁸⁶ |
| **121** | i-Propyl | i-Propyl | 2-Biphenyl |
| **122** | i-Propyl | i-Propyl | Ethoxy |
| **123** | i-Propyl | Phenyl | Phenyl |
| **124** | i-Propyl | Phenyl | R⁸⁶ |
| **125** | i-Propyl | R⁸⁶ | R⁸⁶ |
| **126** | n-Butyl | n-Butyl | n-Butyl |
| **127** | n-Butyl | n-Butyl | Phenyl |
| **128** | n-Butyl | n-Butyl | R⁸⁶ |
| **129** | n-Butyl | n-Hexyl | R⁸⁶ |
| **130** | n-Butyl | Phenyl | Phenyl |
| **131** | n-Butyl | Phenyl | R⁸⁶ |
| **132** | n-Butyl | R⁸⁶ | R⁸⁶ |
| **133** | sec-Butyl | sec-Butyl | sec-Butyl |
| **134** | sec-Butyl | sec-Butyl | Phenyl |
| **135** | sec-Butyl | sec-Butyl | R⁸⁶ |
| **136** | sec-Butyl | Phenyl | Phenyl |
| **137** | sec-Butyl | Phenyl | R⁸⁶ |
| **138** | sec-Butyl | R⁸⁶ | R⁸⁶ |
| **139** | i-Butyl | i-Butyl | i-Butyl |
| **140** | i-Butyl | i-Butyl | n-C₈H₁₇ |
| **141** | i-Butyl | i-Butyl | n-C₁₈H₃₇ |
| **142** | i-Butyl | i-Butyl | Phenyl |
| **143** | i-Butyl | i-Butyl | R⁸⁶ |
| **144** | i-Butyl | Phenyl | Phenyl |
| **145** | i-Butyl | Phenyl | R⁸⁶ |
| **146** | i-Butyl | R⁸⁶ | R⁸⁶ |
| **147** | t-Butyl | t-Butyl | t-Butyl |
| **148** | t-Butyl | t-Butyl | n-C₈H₁₇ |
| **149** | t-Butyl | t-Butyl | Phenyl |
| **150** | t-Butyl | t-Butyl | R⁸⁶ |
| **151** | t-Butyl | Phenyl | Phenyl |
| **152** | t-Butyl | Phenyl | R5 |
| **153** | t-Butyl | R⁸⁶ | R⁸⁶ |
| **154** | n-Pentyl | n-Pentyl | n-Pentyl |
| **155** | n-Pentyl | n-Pentyl | Phenyl |
| **156** | n-Pentyl | n-Pentyl | R⁸⁶ |
| **157** | n-Pentyl | Phenyl | Phenyl |
| **158** | n-Pentyl | Phenyl | R⁸⁶ |
| **159** | n-Pentyl | R⁸⁶ | R⁸⁶ |
| **160** | Cyclopentyl | Cyclopentyl | Cyclopentyl |
| **161** | Cyclopentyl | Cyclopentyl | Phenyl |
| **162** | Cyclopentyl | Cyclopentyl | R⁸⁶ |
| **163** | Cyclopentyl | Phenyl | Phenyl |
| **164** | Cyclopentyl | Phenyl | R⁸⁶ |
| **165** | Cyclopentyl | R⁸⁶ | R⁸⁶ |
| **166** | n-Hexyl | n-Hexyl | n-Hexyl |
| **167** | n-Hexyl | n-Hexyl | Phenyl |
| **168** | n-Hexyl | n-Hexyl | R⁸⁶ |
| **169** | n-Hexyl | Phenyl | Phenyl |
| **170** | n-Hexyl | Phenyl | R⁸⁶ |
| **171** | n-Hexyl | R⁸⁶ | R⁸⁶ |
| **172** | -CH₂CH₂C(CH₃)₃ | -CH₂CH₂C(CH₃)₃ | -CH₂CH₂C(CH₃)₃ |
| **173** | -CH₂CH₂C(CH₃)₃ | -CH₂CH₂C(CH₃)₃ | R⁸⁶ |
| **174** | CH₂CH₂C(CH₃)₃ | R⁸⁶ | R⁸⁶ |
| **175** | t-Hexyl | t-Hexyl | t-Hexyl |
| **176** | t-Hexyl | t-Hexyl | R⁸⁶ |
| **177** | t-Hexyl | R⁸⁶ | R⁸⁶ |
| **178** | n-Heptyl | n-Heptyl | n-Heptyl |
| **179** | n-Heptyl | n-Heptyl | R⁸⁶ |
| **180** | n-Heptyl | R⁸⁶ | R⁸⁶ |
| **181** | n-Octyl | n-Octyl | n-Octyl |
| **182** | n-Octyl | n-Octyl | R⁸⁶ |
| **183** | n-Octyl | R⁸⁶ | R⁸⁶ |
| **184** | i-Octyl | i-Octyl | i-Octyl |
| **185** | i-Octyl | i-Octyl | R⁸⁶ |
| **186** | i-Octyl | R⁸⁶ | R⁸⁶ |
| **187** | n-Nonyl | n-Nonyl | n-Nonyl |
| **188** | n-Nonyl | n-Nonyl | R⁸⁶ |
| **189** | n-Nonyl | R⁸⁶ | R⁸⁶ |
| **190** | Cyclohexyl | Cyclohexyl | Cyclohexyl |
| **191** | Cyclohexyl | Cyclohexyl | R⁸⁶ |
| **192** | Cyclohexyl | R⁸⁶ | R⁸⁶ |
| **193** | Cyclooctyl | Cyclooctyl | Cyclooctyl |
| **194** | Cyclooctyl | Cyclooctyl | R⁸⁶ |
| **195** | Cyclooctyl | R⁸⁶ | R⁸⁶ |
| **196** | n-C₁₀H₂₁ | n-C₁₀H₂₁ | n-C₁₀H₂₁ |
| **197** | n-C₁₀H₂₁ | n-C₁₀H₂₁ | R⁸⁶ |
| **198** | n-C₁₀H₂₁ | R⁸⁶ | R⁸⁶ |
| **199** | n-CₙH₂₃ | n-CₙH₂₃ | n-CₙH₂₃ |
| **200** | n-CₙH₂₃ | n-CₙH₂₃ | R⁸⁶ |
| **201** | n-CₙH₂₃ | R⁸⁶ | R⁸⁶ |
| **202** | n-C₁₂H₂₅ | n-C₁₂H₂₅ | n-C₁₂H₂₅ |
| **203** | n-C₁₂H₂₅ | n-C₁₂H₂₅ | R⁸⁶ |
| **204** | n-C₁₂H₂₅ | R⁸⁶ | R⁸⁶ |
| **205** | n-C₁₄H₂₉ | n-C₁₄H₂₉ | n-C₁₄H₂₉ |
| **206** | n-C₁₄H₂₉ | n-C₁₄H₂₉ | R⁸⁶ |
| **207** | n-C₁₄H₂₉ | R⁸⁶ | R⁸⁶ |
| **208** | n-C₁₆H₃₃ | n-C₁₆H₃₃ | n-C₁₆H₃₃ |
| **209** | n-C₁₆H₃₃ | n-C₁₆H₃₃ | R⁸⁶ |
| **210** | n-C₁₆H₃₃ | R⁸⁶ | R⁸⁶ |
| **211** | n-C₁₈H₃₇ | n-C₁₈H₃₇ | R⁸⁶ |
| **212** | n-C₁₈H₃₇ | R⁸⁶ | R⁸⁶ |
| **213** | n-C₁₈H₃₇ | OEt | OEt |
| **214** | n-C₁₈H₃₇ | R⁸⁶ | OMe |
| **215** | n-C₂₀H₄₁ | n-C₂₀H₄₁ | n-C₂₀H₄₁ |
| **216** | n-C₂₀H₄₁ | n-C₂₀H₄₁ | R⁸⁶ |
| **217** | n-C₂₀H₄₁ | R⁸⁶ | R⁸⁶ |
| **218** | n-C₂₂H₄₅ | n-C₂₂H₄₅ | n-C₂₂H₄₅ |
| **219** | n-C₂₂H₄₅ | n-C₂₂H₄₅ | R⁸⁶ |
| **220** | n-C₂₂H₄₅ | R⁸⁶ | R⁸⁶ |
| **221** | n-C₂₆H₅₃ | n-C₂₆H₅₃ | n-C₂₆H₅₃ |
| **222** | n-C₂₆H₅₃ | n-C₂₆H₅₃ | R⁸⁶ |
| **223** | n-C₂₆H₅₃ | R⁸⁶ | R⁸⁶ |
| **224** | n-C₃₀H₆₁ | n-C₃₀H₆₁ | n-C₃₀H₆₁ |
| **225** | n-C₃₀H₆₁ | n-C₃₀H₆₁ | R⁸⁶ |
| **226** | n-C₃₀H₆₁ | R⁸⁶ | R⁸⁶ |
| **227** | -CH₂-Cyclohexyl | -CH₂-Cyclohexyl | R⁸⁶ |
| **228** | -CH₂CH₂CF₃ | -CH₂CH₂CF₃ | -CH₂CH₂CF₃ |
| **229** | -CH₂CH₂CF₃ | -CH₂CH₂CF₃ | R⁸⁶ |
| **230** | -CH₂CH₂CF₃ | R⁸⁶ | R⁸⁶ |
| **231** | -CH₂CH₂(CF₂)₃CF₃ | -CH₂CH₂(CF₂)₃CF₃ | -CH₂CH₂(CF₂)₃CF₃ |
| **232** | -CH₂CH₂(CF₂)₃CF₃ | -CH₂CH₂(CF₂)₃CF₃ | R⁸⁶ |
| **233** | -CH₂CH₂(CF₂)₃CF₃ | R⁸⁶ | R⁸⁶ |
| **234** | -CH₂CH₂(CF₂)₅CF₃ | -CH₂CH₂(CF₂)₅CF₃ | -CH₂CH₂(CF₂)₅CF₃ |
| **235** | -CH₂CH₂(CF₂)₅CF₃ | -CH₂CH₂(CF₂)₅CF₃ | R⁸⁶ |
| **236** | -CH₂CH₂(CF₂)₅CF₃ | R⁸⁶ | R⁸⁶ |
| **237** | -CH₂CH₂(CF₂)₇CF₃ | -CH₂CH₂(CF₂)₇CF₃ | -CH₂CH₂(CF₂)₇CF₃ |
| **238** | -CH₂CH₂(CF₂)₇CF₃ | -CH₂CH₂(CF₂)₇CF₃ | R⁸⁶ |
| **239** | -CH₂CH₂(CF₂)₇CF₃ | R⁸⁶ | R⁸⁶ |
| **240** | -CH₂CH₂(CF₂)₉CF₃ | -CH₂CH₂(CF₂)₉CF₃ | -CH₂CH₂(CF₂)₉CF₃ |
| **241** | -CH₂CH₂(CF₂)₉CF₃ | -CH₂CH₂(CF₂)₉CF₃ | R⁸⁶ |
| **242** | -CH₂CH₂(CF₂)₉CF₃ | R⁸⁶ | R⁸⁶ |
| **243** | -CH₂CH₂(CF₂)₁₁CF₃ | -CH₂CH₂(CF₂)₁₁CF₃ | -CH₂CH₂(CF₂)₁₁CF₃ |
| **244** | -CH₂CH₂(CF₂)₁₁CF₃ | -CH₂CH₂(CF₂)₁₁CF₃ | R⁸⁶ |
| **245** | -CH₂CH₂(CF₂)₁₁CF₃ | R⁸⁶ | R⁸⁶ |
| **246** | -CF₂CHF₂ | -CF₂CHF₂ | -CF₂CHF₂ |
| **247** | -CF₂CHF₂ | -CF₂CHF₂ | R⁸⁶ |
| **248** | -CF₂CHF₂ | R⁸⁶ | R⁸⁶ |
| **249** | -(CF₂)₃CHF₂ | -(CF₂)₃CHF₂ | -(CF₂)₃CHF₂ |
| **250** | -(CF₂)₃CHF₂ | -(CF₂)₃CHF₂ | R⁸⁶ |
| **251** | -(CF₂)₃CHF₂ | R⁸⁶ | R⁸⁶ |
| **14** | Phenyl | Phenyl | Phenyl |
| **252** | Phenyl | Phenyl | p-Tolyl |
| **253** | Phenyl | Phenyl | m-Tolyl |
| **254** | Phenyl | Phenyl | o-Tolyl |
| **255** | Phenyl | Phenyl | 2-Xylyl |
| **256** | Phenyl | Phenyl | 5-Xylyl |
| **257** | Phenyl | Phenyl | Mesityl |
| **258** | Phenyl | Phenyl | 9-Fluorenyl |
| **18** | Phenyl | Phenyl | R⁸⁶ |
| **259** | Phenyl | Phenyl | -O-tBu (tert-Butoxy) |
| **260** | Phenyl | p-Tolyl | p-Tolyl |
| **261** | Phenyl | m-Tolyl | m-Tolyl |
| **262** | Phenyl | o-Tolyl | o-Tolyl |
| **263** | Phenyl | 2-Xylyl | 2-Xylyl |
| **264** | Phenyl | 5-Xylyl | 5-Xylyl |
| **265** | Phenyl | Mesityl | Mesityl |
| **266** | Phenyl | R⁸⁶ | R⁸⁶ |
| **267** | Phenyl | Ethoxy | Ethoxy |
| **268** | p-Tolyl | p-Tolyl | p-Tolyl |
| **269** | p-Tolyl | p-Tolyl | R⁸⁶ |
| **270** | p-Tolyl | R⁸⁶ | R⁸⁶ |
| **271** | m-Tolyl | m-Tolyl | m-Tolyl |
| **272** | m-Tolyl | m-Tolyl | R⁸⁶ |
| **273** | o-Tolyl | o-Tolyl | o-Tolyl |
| **274** | o-Tolyl | o-Tolyl | R⁸⁶ |
| **275** | 2-Xylyl | 2-Xylyl | 2-xylyl |
| **276** | 2-Xylyl | 2-Xylyl | R⁸⁶ |
| **277** | 5-Xylyl | 5-Xylyl | 5-xylyl |
| **278** | 5-Xylyl | 5-Xylyl | R⁸⁶ |
| **279** | Mesityl | Mesityl | Mesityl |
| **280** | Mesityl | Mesityl | R⁸⁶ |
| **281** | C₆F₅ | C₆F₅ | C₆F₅ |
| **282** | C₆F₅ | C₆F₅ | R⁸⁶ |
| **283** | C₆F₅ | R⁸⁶ | R⁸⁶ |
| **284** | R⁸⁶ | R⁸⁶ | R⁸⁶ |
| **285** | R⁸⁶ | Ethoxy | Ethoxy |
| **286** | R⁸⁶ | n-Butoxy | n-Butoxy |
| **287** | R⁸⁶ | R⁸⁶ | Methoxy |
| **288** | R⁸⁶ | R⁸⁶ | Ethoxy |
| **289** | R⁸⁶ | R⁸⁶ | OSiMe₃ |
| **290** | R⁸⁶ | R⁸⁶ | -(CH₂)ₙO-(CH₂)₂OCH₃ |
| **291** | Methoxy | Methoxy | Methoxy |
| **292** | Ethoxy | Ethoxy | Ethoxy |
| **293** | i-Propoxy | i-Propoxy | i-Propoxy |
| **294** | t-Butoxy | t-Butoxy | t-Butoxy |
| **295** | OSiMe₃ | OSiMe₃ | OSiMe₃ |
| **296** | Cyclobutyl | | Methyl |
| **297** | Cyclobutyl | | R⁸⁶ |
| **298** | Cyclobutyl | | p-Methoxyphenyl |
| **299** | Cyclopentyl | | Methyl |
| **300** | Cyclopentyl | | R⁸⁶ |
| **301** | Cyclohexyl | | Methyl |
| **302** | Cyclohexyl | | R⁸⁶ |

In dieser Tabelle ist

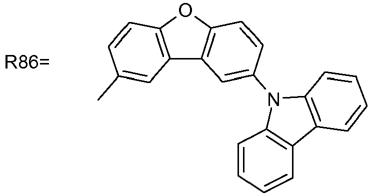

Besonders bevorzugte Verbindungen, in denen zwei Einheiten der allgemeinen Formeln (XI) und/oder (XI*) über eine lineare oder verzweigte, gesättigte oder ungesättigte, gegebenenfalls durch wenigstens ein Heteroatom unterbrochene Verbrückung oder über O miteinander verbrückt sind, wobei diese Verbrückung in den allgemeinen Formeln (XI) und/oder (XI*) jeweils anstelle von R⁷¹ an die Si-Atome angebunden ist, entsprechen der allgemeinen Formel (XIII)

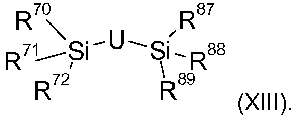

In Formel (XIII) haben U, R⁷⁰, R⁷¹, R⁷², R⁸⁷, R⁸⁸ und R⁸⁹ die folgenden Bedeutungen:

| Nr. | **R70** | **R71** | **R72** | **R87** | **R88** | **R89** | **U** |
|---|---|---|---|---|---|---|---|
| 303 | Methyl | R⁸⁶ | R⁸⁶ | Methyl | R5 | R⁸⁶ | -CH₂- |
| 304 | Methyl | Methyl | R⁸⁶ | Methyl | Methyl | R⁸⁶ | -CH₂- |
| 305 | R⁸⁶ | R⁸⁶ | R⁸⁶ | R⁸⁶ | R⁸⁶ | R⁸⁶ | -CH₂- |
| 306 | Methyl | R⁸⁶ | R⁸⁶ | Methyl | R5 | R⁸⁶ | -C₂H₄- |
| 307 | Methyl | Methyl | R⁸⁶ | Methyl | Methyl | R⁸⁶ | -C₂H₄- |
| 308 | R⁸⁶ | R⁸⁶ | R⁸⁶ | R⁸⁶ | R⁸⁶ | R⁸⁶ | -C₂H₄- |
| 309 | Methyl | R⁸⁶ | R⁸⁶ | Methyl | R⁸⁶ | R⁸⁶ | -C₃H₆- |
| 310 | Methyl | Methyl | R⁸⁶ | Methyl | Methyl | R⁸⁶ | -C₃H₆- |
| 311 | R⁸⁶ | R⁸⁶ | R⁸⁶ | R⁸⁶ | R⁸⁶ | R⁸⁶ | -C₃H₆- |
| 312 | Methyl | R⁸⁶ | R⁸⁶ | Methyl | R⁸⁶ | R⁸⁶ | -C₄H₈- |
| 313 | Methyl | Methyl | R⁸⁶ | Methyl | Methyl | R⁸⁶ | -C₄H₈- |
| 314 | R⁸⁶ | R⁸⁶ | R⁸⁶ | R⁸⁶ | R⁸⁶ | R⁸⁶ | -C₄H₈- |
| 315 | Methyl | R⁸⁶ | R⁸⁶ | Methyl | R⁸⁶ | R⁸⁶ | -C₆H₁₂- |
| 316 | Methyl | Methyl | R⁸⁶ | Methyl | Methyl | R⁸⁶ | -C₆H₁₂- |
| 317 | R⁸⁶ | R⁸⁶ | R⁸⁶ | R⁸⁶ | R⁸⁶ | R⁸⁶ | -C₆H₁₂- |
| 318 | Methyl | R⁸⁶ | R⁸⁶ | Methyl | R⁸⁶ | R⁸⁶ | -C₈H₁₆- |
| 319 | Methyl | Methyl | R⁸⁶ | Methyl | Methyl | R⁸⁶ | -C₈H₁₆- |
| 320 | R⁸⁶ | R⁸⁶ | R⁸⁶ | R⁸⁶ | R⁸⁶ | R⁸⁶ | -C₈H₁₆- |
| 321 | Methyl | R⁸⁶ | R⁸⁶ | Methyl | R⁸⁶ | R⁸⁶ | -C₉H₁₈- |
| 322 | Methyl | Methyl | R⁸⁶ | Methyl | Methyl | R⁸⁶ | -C₉H₁₈- |
| 323 | R⁸⁶ | R⁸⁶ | R⁸⁶ | R^{8b} | R^{8b} | R⁸⁶ | -C₉H₁₈- |
| 324 | R⁸⁶ | R⁸⁶ | R⁸⁶ | R⁸⁶ | R⁸⁶ | R⁸⁶ | -CH(C₈H₁₇)CH ₂- |
| 325 | Methyl | R⁸⁶ | R⁸⁶ | Methyl | R⁸⁶ | R⁸⁶ | -C₂H₄(CF₂)₈ C₂H₄- |
| 326 | Methyl | Methyl | R⁸⁶ | Methyl | Methyl | R⁸⁶ | -C₂H₄(CF₂)₈ C₂H₄- |
| 327 | R⁸⁶ | R⁸⁶ | R⁸⁶ | R⁸⁶ | R⁸⁶ | R⁸⁶ | -C₂H₄(CF₂)₈ C₂H₄- |
| 328 | Methyl | R⁸⁶ | R⁸⁶ | Methyl | R⁸⁶ | R⁸⁶ | -C≡C- |
| 329 | Methyl | Methyl | R⁸⁶ | Methyl | Methyl | R⁸⁶ | -C≡C- |
| 330 | R⁸⁶ | R⁸⁶ | R⁸⁶ | R⁸⁶ | R⁸⁶ | R⁸⁶ | -C≡C- |
| 331 | Methyl | R⁸⁶ | R⁸⁶ | Methyl | R⁸⁶ | R⁸⁶ | -1,4-(CH₂)₂- Phenyl-(CH₂)₂- |
| 332 | Methyl | Methyl | R⁸⁶ | Methyl | Methyl | R⁸⁶ | -1,4-(CH₂)₂-Phenyl-(CH₂)₂- |
| 333 | R⁸⁶ | R⁸⁶ | R⁸⁶ | R⁸⁶ | R⁸⁶ | R⁸⁶ | -1,4-(CH₂)₂-Phenyl-(CH₂)₂- |
| 334 | Methyl | R⁸⁶ | R⁸⁶ | Methyl | R⁸⁶ | R⁸⁶ | -1,3-(CH₂)₂-Phenyl-(CH₂)₂- |
| 335 | Methyl | Methyl | R⁸⁶ | Methyl | Methyl | R⁸⁶ | -1,3-(CH₂)₂-Phenyl-(CH₂)₂- |
| 336 | R⁸⁶ | R⁸⁶ | R⁸⁶ | R⁸⁶ | R⁸⁶ | R⁸⁶ | -1,3-(CH₂)₂-Phenyl-(CH₂)₂- |
| 337 | Methyl | R⁸⁶ | R⁸⁶ | Methyl | R⁸⁶ | R⁸⁶ | -1,4-(CH₂)₃-Phenyl-(CH₂)₃- |
| 338 | Methyl | Methyl | R⁸⁶ | Methyl | Methyl | R⁸⁶ | -1,4-(CH₂)₃-Phenyl-(CH₂)₃- |
| 339 | R⁸⁶ | R⁸⁶ | R⁸⁶ | R⁸⁶ | R⁸⁶ | R⁸⁶ | -1,4-(CH₂)₃-Phenyl-(CH₂)₃- |
| 340 | Methyl | R⁸⁶ | R⁸⁶ | Methyl | R⁸⁶ | R⁸⁶ | -1,3-(CH₂)₃-Phenyl-(CH₂)₃- |
| 341 | Methyl | Methyl | R⁸⁶ | Methyl | Methyl | R⁸⁶ | -1,3-(CH₂)₃-Phenyl-(CH₂)₃-- |
| 342 | R⁸⁶ | R⁸⁶ | R⁸⁶ | R⁸⁶ | R⁸⁶ | R⁸⁶ | -1,3-(CH₂)₃-Phenyl-(CH₂)₃- |
| 343 | Methyl | R⁸⁶ | R⁸⁶ | Methyl | R^{8b} | R⁸⁶ | -1,4-Phenyl- |
| 344 | Methyl | Methyl | R⁸⁶ | Methyl | Methyl | R⁸⁶ | -1,4-Phenyl- |
| 345 | R⁸⁶ | R⁸⁶ | R⁸⁶ | R⁸⁶ | R⁸⁶ | R⁸⁶ | -1,4-Phenyl- |
| 346 | Methyl | R⁸⁶ | R⁸⁶ | Methyl | R⁸⁶ | R⁸⁶ | -1,3-Phenyl- |
| 347 | Methyl | Methyl | R⁸⁶ | Methyl | Methyl | R⁸⁶ | -1,3-Phenyl- |
| 348 | R⁸⁶ | R⁸⁶ | R⁸⁶ | R⁸⁶ | R⁸⁶ | R⁸⁶ | -1,3-Phenyl- |
| **28** | Methyl | Methyl | R⁸⁶ | Methyl | Methyl | R⁸⁶ | -O- |
| 349 | Methyl | R⁸⁶ | R⁸⁶ | Methyl | R⁸⁶ | R⁸⁶ | -O- |
| 350 | Methyl | Methyl | R⁸⁶ | Methyl | Methyl | R⁸⁶ | -O-Si(CH₃)₂-O- |
| 351 | Methyl | Methyl | R⁸⁶ | Methyl | Methyl | R⁸⁶ | -O-Si(CH₃)(Ph)-O- |
| 352 | Methyl | Methyl | R⁸⁶ | Methyl | Methyl | R⁸⁶ | -O-Si(CH₃)₂-O- Si(CH₃)₂-O- |
| 353 | Methyl | Methyl | R⁸⁶ | Methyl | Methyl | R⁸⁶ | -O-Si(CH₃)₂-O-Si(CH₃)₂-O- Si(CH₃)₂-O- |
| 354 | Methyl | -OSiMe₃ | R⁸⁶ | Methyl | -OSiMe₃ | R⁸⁶ | -O- |
| 355 | Methyl | Phenyl | R⁸⁶ | Methyl | Phenyl | R⁸⁶ | -O- |
| 356 | i-Propyl | i-Propyl | R⁸⁶ | i-Propyl | i-Propyl | R⁸⁶ | -O- |
| 357 | Cyclopen tyl | Cyclopenty l | R⁸⁶ | Cyclopent yl | Cyclopenty l | R⁸⁶ | -O- |
| 358 | Phenyl | Phenyl | R⁸⁶ | Phenyl | Phenyl | R⁸⁶ | -O- |
| 359 | Phenyl | R⁸⁶ | R⁸⁶ | Phenyl | R⁸⁶ | R⁸⁶ | -O- |
| 360 | R⁸⁶ | R⁸⁶ | R⁸⁶ | R⁸⁶ | R⁸⁶ | R⁸⁶ | -O- |

In dieser Tabelle ist

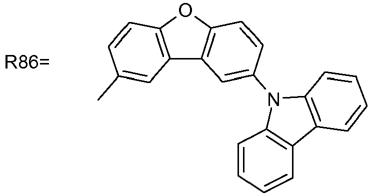

Weitere geeignete Verbindungen der Formel (XI) und/oder (XI*) sind im Folgenden genannt. Darin bedeutet R jeweils unabhängig voneinander Me, Phenyl oder R⁸⁶, wobei mindestens ein Rest R R⁸⁶ ist:

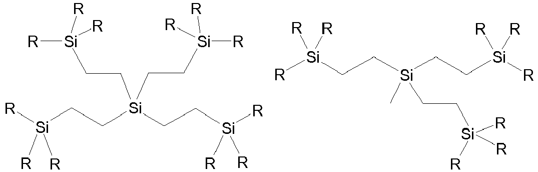

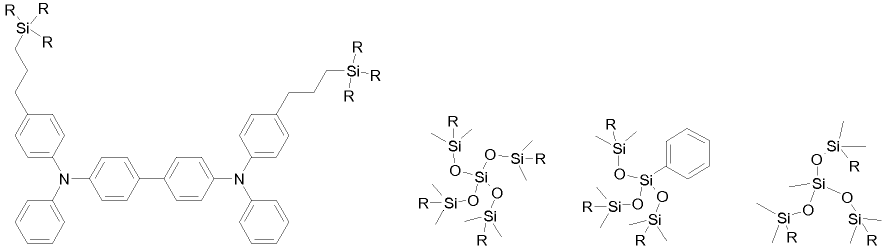

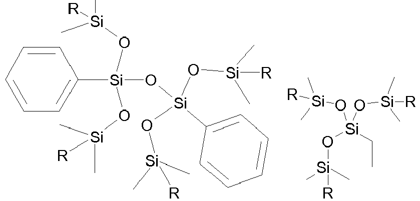

In einer ganz besonders bevorzugten Ausführungsform betrifft die vorliegende Erfindung eine OLED, die neben mindestens einem heteroleptische Komplex der allgemeinen Formel (I) mindestens eine Verbindung der allgemeinen Formel (X) enhält, wobei es sich bei der Verbindung der Formel (X) ganz besonders bevorzugt um mindestens eine der nachstehend genannten Verbindungen handelt:

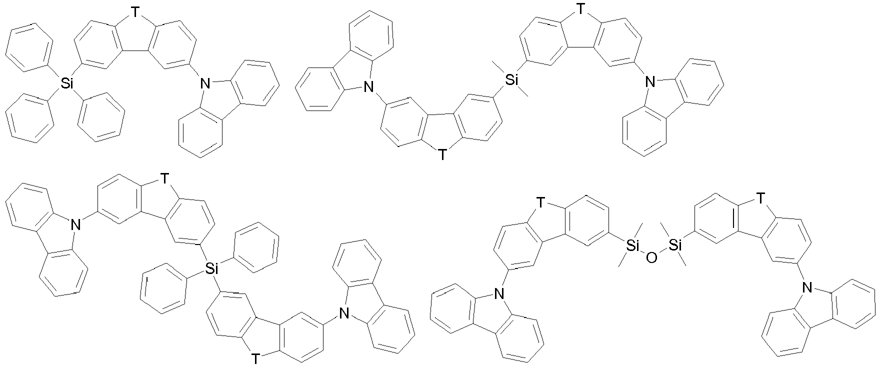

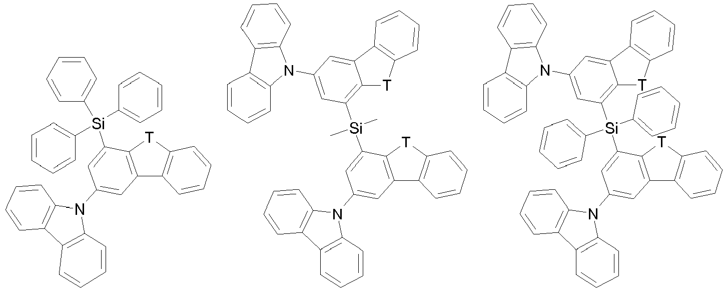

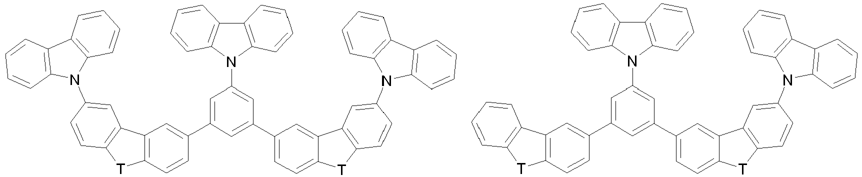

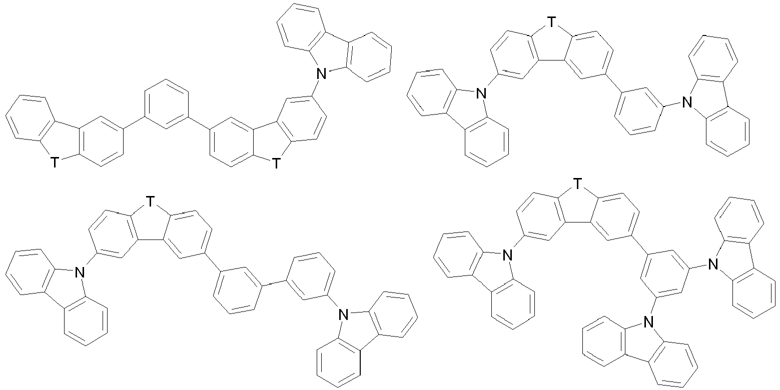

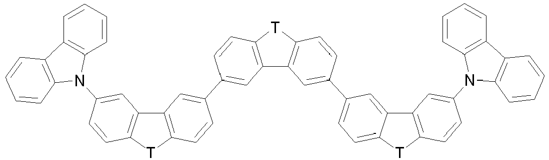

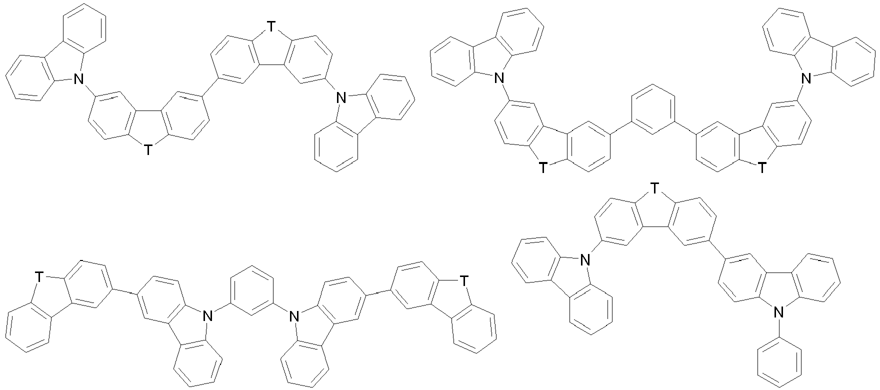

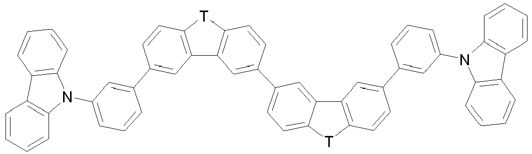

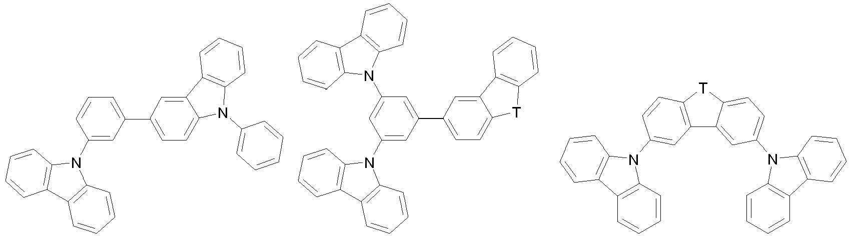

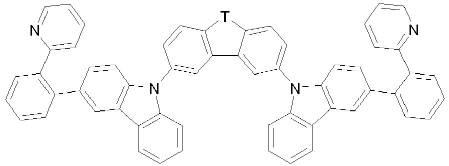

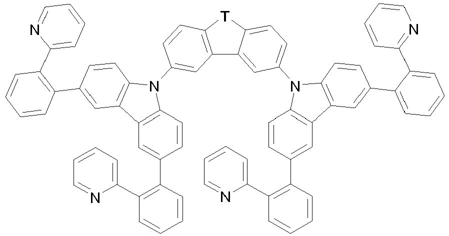

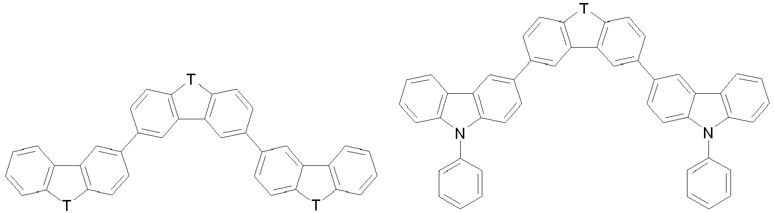

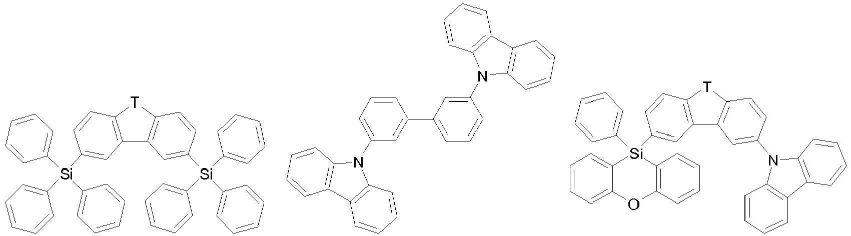

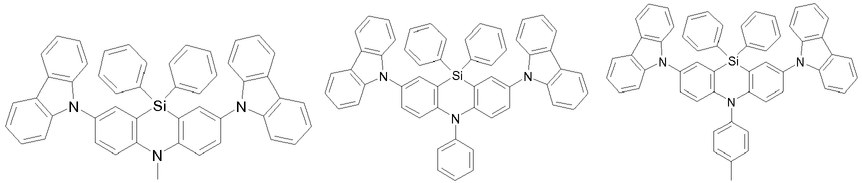

In den vorstehend genannten Verbindungen bedeutet T, O oder S, bevorzugt O. Wenn mehr als ein T im Molekül vorkommt, haben alle Gruppen T die gleiche Bedeutung.

Neben den Verbindungen der Formel (X) können gemäß der vorliegenden Erfindung auch vernetzte oder polymere Materialien umfassend Wiederholungseinheiten basierend auf der allgemeinen Formel (X) in vernetzter oder polymerisierter Form gemeinsam mit mindestens einem heteroleptischen Komplex der allgemeinen Formel (I) eingesetzt werden. Diese werden - wie die Verbindungen der allgemeinen Formel (X) - bevorzugt als Matrixmaterialien eingesetzt.

Die vernetzten oder polymeren Materialien weisen eine hervorragende Löslichkeit in organischen Lösungsmitteln, hervorragende Film-formende Eigenschaften und relativ hohe Glasübergangstemperaturen auf. Zusätzlich können hohe Ladungsträgermobilitäten, hohe Stabilitäten der Farbemission und lange Betriebszeiten der entsprechenden Bauteile beobachtet werden, wenn vernetzte oder polymere Materialien gemäß der vorliegenden Erfindung in organischen Licht-emittierenden Dioden (OLEDs) verwendet werden.

Die vernetzten oder polymersierten Materialien eignen sich besonders als Beschichtungen oder in dünnen Filmen, da sie thermisch und mechanisch stabil und relativ defektfrei sind.

Die vernetzten oder polymerisierten Materialien umfassend Wiederholungseinheiten basierend auf der allgemeinen Formel (X) können durch ein Verfahren umfassend die Schritte (a) und (a) hergestellt werden:
(a) Herstellen einer vernetzbaren oder polymerisierbaren Verbindung der allgemeinen Formel (X), wobei wenigstens einer der a" Reste R⁵⁵ oder wenigstens einer der b' Reste R⁵⁶ eine über einen Spacer angebundene vernetzbare oder polymerisierbare Gruppe bedeutet, und
(b) Vernetzung oder Polymerisation der aus Schritt (a) erhaltenen Verbindung der allgemeinen Formel (X).

Bei den vernetzten oder polymerisierten Materialien kann es sich um Homopolymere handeln, d. h. ausschließlich Einheiten der allgemeinen Formel (X) liegen in vernetzter oder polymerisierter Form vor. Es kann sich auch Copolymere handeln, d. h. neben den Einheiten der allgemeinen Formel (X) liegen weitere Monomere, beispielsweise Monomere mit lochleitenden und/oder elektronenleitenden Eigenschaften, in vernetzter oder polymerisierter Form vor.

In einer weiteren bevorzugten Ausführungsform der erfindungsgemäßen OLED enthält diese eine Emissionsschicht umfassend mindestens einen erfindungsgemäßen heteroleptischen Komplex der allgemeinen Formel (I), mindestens Matrixmaterial gemäß Formel (X), und gegebenenfalls mindestens ein weiteres lochtransportierendes Matrixmaterial.

Die erfindungsgemäßen OLEDs können in allen Vorrichtungen eingesetzt werden, worin Elektrolumineszenz nützlich ist. Geeignete Vorrichtungen sind bevorzugt ausgewählt aus stationären und mobilen Bildschirmen und Beleuchtungsmitteln. Die vorliegende Erfindung betrifft daher auch eine Vorrichtung ausgewählt aus der Gruppe bestehend aus stationären Bildschirmen und mobilen Bildschirmen und Beleuchtungsmitteln, enthaltend ein erfindungsgemäßes OLED.

Stationäre Bildschirme sind z. B. Bildschirme von Computern, Fernsehern, Bildschirme in Druckern, Küchengeräten sowie Reklametafeln, Beleuchtungen und Hinweistafeln. Mobile Bildschirme sind z.B. Bildschirme in Handys, Laptops, Digitalkameras, mp-3 Playern, Smartphones, Fahrzeugen sowie Zielanzeigen an Bussen und Bahnen.

Weiterhin können die erfindungsgemäßen heteroleptischen Komplexe der allgemeinen Formel (I) in OLEDs mit inverser Struktur eingesetzt werden. Bevorzugt werden die erfindungsgemäßen Komplexe in diesen inversen OLEDs wiederum in der Licht-emittierenden Schicht, eingesetzt. Der Aufbau von inversen OLEDs und die üblicherweise darin eingesetzten Materialien sind dem Fachmann bekannt.

Ein weiterer Gegenstand der vorliegenden Erfindung ist eine weiße OLED enthaltend mindestens einen erfindungsgemäßen heteroleptischen Komplex der allgemeinen Formel (I). In einer bevorzugten Ausführungsform wird der heteroleptische Komplex der allgemeinen Formel (I) in der weißen OLED als Emittermaterial eingesetzt. Bevorzugte Ausführungsformen des heteroleptischen Komplexes der allgemeinen Formel (I) sind vorstehend genannt. Neben dem mindestens einen heteroleptischen Komplex der allgemeinen Formel (I) kann die weiße OLED mindestens eine Verbindung der Formel (X) enthalten. Die Verbindung der Formel (X) wird bevorzugt als Matrixmaterial eingesetzt. Bevorzugte Verbindungen der Formel (X) sind vorstehend genannt;

Um weißes Licht zu erzeugen, muss die OLED Licht erzeugen, das den gesamten sichtbaren Bereich des Spektrums abdeckt. Normalerweise emittieren organische Emitter jedoch nur in einem begrenztem Teil des sichtbaren Spektrums - sind also farbig. Weißes Licht kann durch die Kombination von verschiedenen Emittern erzeugt werden. Üblicherweise werden rote, grüne und blaue Emitter kombiniert Im Stand der Technik sind jedoch auch andere Methoden zur Ausbildung weißer OLEDs bekannt, z.B. der Triplett-Harvesting Ansatz. Geeignete Aufbauten für weiße OLEDs bzw. Methoden zur Ausbildung weißer OLEDs sind dem Fachmann bekannt.

Die vorliegende Erfindung betrifft des Weiteren ein organisches Elektronikbauteil, bevorzugt eine Organische Licht-Emittierende Diode (OLED), Organische Photovoltaik-Zelle (OPV), Organischer Feldeffekttransistor (OFET) oder Licht-Emittierende Elektrochemische Zelle (LEEC), enthaltend wenigstens einen erfindungsgemäßen heteroleptischen Komplex der allgemeinen Formel (I).

### Beispiele

Die folgenden Beispiele, insbesondere die in den Beispielen aufgeführten Methoden, Materialien, Bedingungen, Prozessparameter, Apparate und Ähnliches sollen die vorliegende Erfindung stützen, den Umfang der vorliegenden Erfindung aber nicht beschränken.

*N*-(2,6-diisopropylphenyl)-2-phenylimidazol **L1** wird analog Beispiel 14 in WO2006/121811 synthetisiert. Die Synthese von 5-Methoxy-1,3,4-triphenyl-4,5-dihydro-1H-1,2,4-triazol **C1** erfolgt nach D. Enders, K. Breuer, G. Raabe, J. Runsink, J. H. Teles, J.-P. Melder, K. Ebel, S. Brode, Angew. Chem. 1995, 107, 9, 1119-1122 bzw. D. Enders, K. Breuer, U. Kallfass, T. Balensiefer, Synthesis 2003, 8, 1292-1295. 3-(2,6-dimethylphenyl)-7-methylimidazo[1,2-f]phenanthridin **L3** wird analog Beispiel 10 in WO 2007/095118 synthetisiert. Die Synthese des Ligandvorläufers 1-Isopropyl-1,2,4-triazolo[4,3-f]phenanthridinium-iodid **C3** erfolgt wie in WO 2009/050281 beschrieben. Die Synthese des Excitonen- und Lochblockers 2,8-bis(Triphenylsilyl)-dibenzofuran **LB1** ist in Synthesebeispiel 4g in WO2009/003898 offenbart.

Alle Versuche werden in Schutzgasatmosphäre ausgeführt.

### Beispiel 1:

### µ-Dichlorodimer D1:

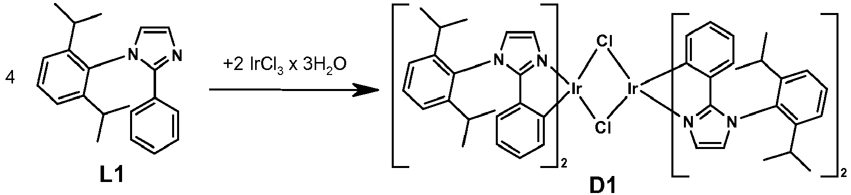

3.50 g (11.5 mmol) 1-(2,6-Diisopropyl-phenyl)-2-phenyl-1 H-imidazol **L1** werden in 200 ml 2-Ethoxyethanol/Wasser (Verhältnis 3/1) vorgelegt und mit 1.84 g (5.2 mmol) Iridium(III)chlorid-Trihydrat versetzt. Das Reaktionsgemisch wird 18 h am Rückfluss erhitzt. Nach dem Abkühlen werden 50 ml destilliertes Wasser zugegeben. Der Niederschlag wird abfiltriert, mit destilliertem Wasser gewaschen und getrocknet. Man erhält 3.50 g (80%) µ-Dichlorodimer **D1** als gelbes Pulver.
¹H-NMR (CD₂Cl₂, 400 MHz):
δ= 0.95 (d, ³*J*_{H,H} = 6.9 Hz, 12H), 1.18 (d, ³*J*_{H,H} = 6.9 Hz, 12H), 1.27 (d, ³*J*_{H,H} = 6.9 Hz, 12H), 1.34 (d, ³*J*_{H,H} = 6.9 Hz, 12H), 2.80-2.91 (m, 8H), 6.08 (d, ³*J*_{H,H} = 7.7 Hz, 4H), 6.24 (d, ³*J*_{H,H} = 7.7 Hz, 4H), 6.39 (pt, ³*J*_{H,H} = 7.5 Hz, 4H), 6.53 (pt, ³*J*_{H,H} = 7.5 Hz, 4H),6.97 (d, ³*J*_{H,H} = 1.5 Hz, 4H), 7.39-7.45 (m, 8H), 7.59 (t, ³*J*_{H,H} = 7.8 Hz, 4H), 7.67 (d, *J*_{H,H} = 1.5 Hz, 4H).

### Komplex Em1-s:

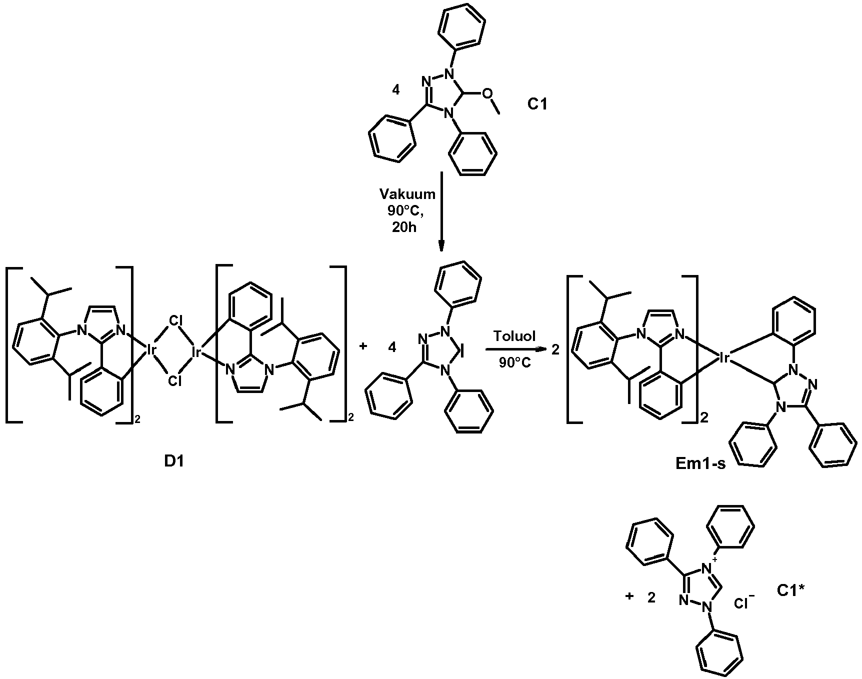

2.37 g (7.2 mmol) 5-Methoxy-1,3,4-triphenyl-4,5-dihydro-1H-1,2,4-triazol **C1** werden 18 h im Vakuum auf 90°C erhitzt. Nach dem Abkühlen auf Raumtemperatur werden zunächst 100 ml wasserfreies Toluol und anschließend eine Suspension aus 3.00 g (1.8 mmol) Chlorodimer **D1** und 150 ml wasserfreiem Toluol zugegeben. Es wird 2 h auf 90°C erhitzt. Der entstandene weiße Niederschlag (1.15 g, Imidazoliumchlorid **C1***) wird abfiltriert. Das Filtrat wird mit 3 x 40 ml gesättigter NaHCO₃-Lösung und 1 x 40 ml destilliertem Wasser gewaschen, über MgSO₄ getrocknet und im Vakuum vom Lösungsmittel befreit. Der Rückstand wird mit 2 x 50 ml Methanol gewaschen, aus Methylenchlorid/Methanol und anschließend aus Nitromethan umkristallisiert. Man erhält 3.2 g des Komplexes **Em1-s** als gelbes Pulver (82%).

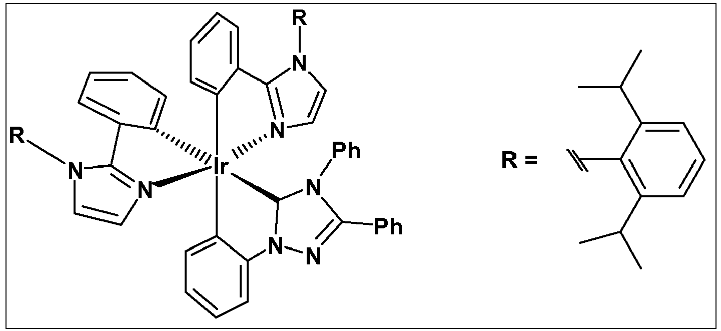

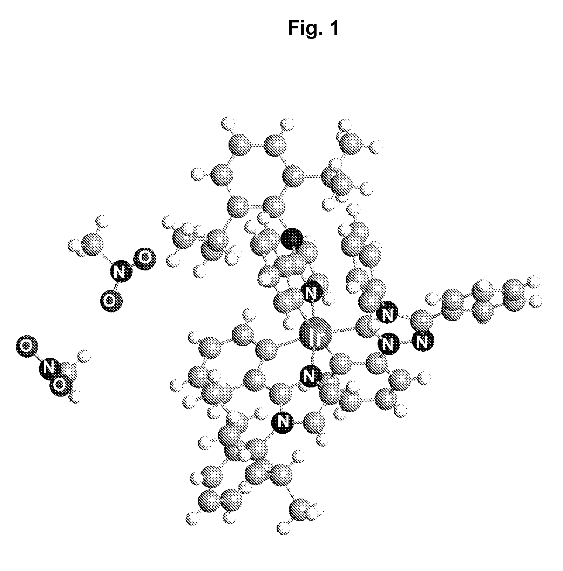

**Em1-s:** Die Konfiguration von **Em1-s** entspricht der Konfiguration des pseudomeridionalen Isomers S1a bzw. S1 b. Em1-s liegt als Racemat vor, Kristallstruktur siehe Figur 1, es ist nur ein Enantiomer abgebildet, große Kugel = C, kleine Kugel = H. Probe für die Röntgenstrukturanalyse wird aus Nitromethan kristallisiert (noch Nitromethan im Kristall enthalten).
¹H-NMR (CD₂Cl₂, 400 MHz):
δ= 0.88 (d, ³*J*_{H,H} = 6.8 Hz, 3H), 0.91 (d, ³*J*_{H,H} = 6.9 Hz, 9H), 1.14 (d, ³*J*_{H,H} = 6.9 Hz, 3H), 1.16 (d, ³*J*_{H,H} = 6.8 Hz, 3H), 1.20 (d, ³*J*_{H,H} = 6.9 Hz, 3H), 1.28 (d, ³*J*_{H,H} = 6.9 Hz, 3H), 2.08 (sept, ³*J*_{H,H} = 6.7 Hz, 1 H), 2.65-2.77 (m, 3H), 6.08-6.15 (m, 3H), 6.19-6.25 (m, 2H), 6.42-6.45 (m, 1 H), 6.50-6.52 (m, 2H), 6.67 (s, b, 2H), 6.71 (dt, ³*J*_{H,H} = 7.4 Hz, *J* = 1.2 Hz, 1 H), 6.75 (d, *J =* 1.5 Hz, 1 H), 6.79-6.87 (m, 6H), 7.00-7.07 (m, 2H), 7.28-7.43 (m, 9H), 7.50 (t, ³*J*_{H,H} = 7.8 Hz, 1 H), 7.56 (t, ³*J*_{H,H} = 7.8 Hz, 1 H), 7.71 (d, ³*J*_{H,H} = 7.5 Hz, 1 H).
Photolumineszenz (im Film, 2% in PMMA):
λₘₐₓ = 460, 490 nm, CIE: (0.19;0.34)

### Beispiel 2:

### Komplex Em1-i:

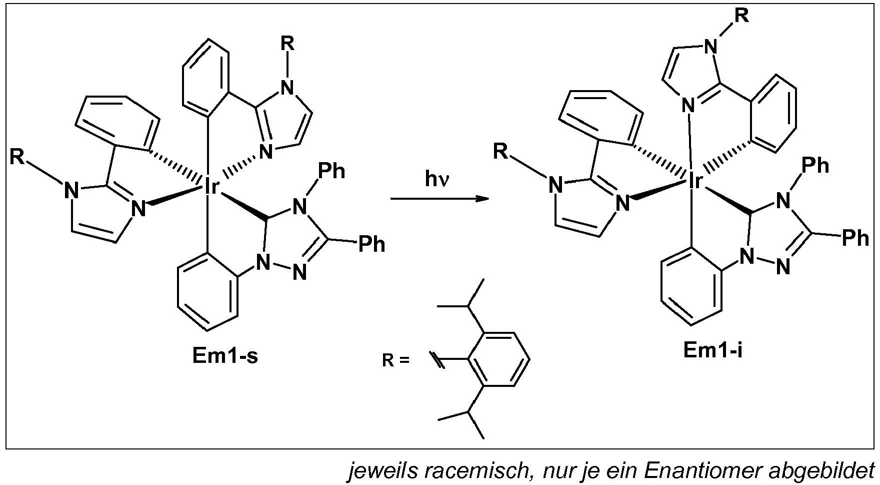

Eine Lösung von 1.6 g Komplex **Em1-s** in 200 ml 3-Methoxypropionitril wird bei Raumtemperatur 5 h mit einer Blacklight-Blue-Lampe bestrahlt (Osram, L18W/73, λₘₐₓ = 370-380 nm). Das Lösungsmittel wird im Vakuum entfernt. Der Rückstand wird mit Methanol gewaschen und aus Methylenchlorid/Methanol umkristallisiert. Man erhält 1.2 g **Em1-i** als zitronengelbes Pulver (75%).

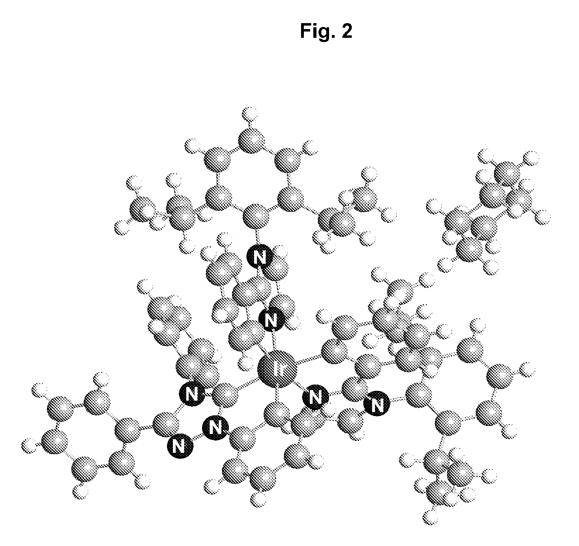

Die Konfiguration von **Em1-i** entspricht der Konfiguration **IVa** bzw. **IVb** des pseudofacialen Isomers **S4a** bzw. **S4b.** Em1-i liegt als Racemat vor, Kristallstruktur siehe Figur 2, **die** Probe für die Röntgenstrukturanalyse wird aus Cyclohexan/ Essigsäureethylester kristallisiert (noch Cyclohexan im Kristall enthalten).
¹H-NMR (CD₂Cl₂, 500 MHz):
δ= 0.46 (d, ³*J*_{H,H} = 6.8 Hz, 3H), 0.75 (d, ³*J*_{H,H} = 6.8 Hz, 3H), 0.81 (d, ³*J*_{H,H} = 6.8 Hz, 3H), 1.01 (d, ³*J*_{H,H} = 6.8 Hz, 3H), 1.09 (d, ³*J*_{H,H} = 6.9 Hz, 3H), 1.14 (d, ³*J*_{H,H} = 6.9 Hz, 3H), 1.17 (d, ³*J*_{H,H} = 6.9 Hz, 3H), 1.26 (d, ³*J*_{H,H} = 6.8 Hz, 3H), 1.50 (sept, ³*J*_{H,H} = 6.8 Hz, 1H), 2.49-2.60 (m, 3H), 6.01 (d, *J =* 1.3 Hz, 1H), 6.10 (t, ³*J*_{H,H} = 8.2 Hz, 2H), 6.34 (d, *J =* 1.4 Hz, 1 H), 6.38 (d, ³*J*_{H,H} = 7.2 Hz, 1 H), 6.41-6.45 (m, 2H), 6.57-6.73 (m, 5H), 6.85 (d, *J =* 1.4 Hz, 1H), 6.96-7.00 (m, 1H), 7.11 (d, *J* = 1.4 Hz, 1H), 7.17-7.42 (m, 14H), 7.46 (t, ³*J*_{H,H} = 7.8 Hz, 1H), 7.54 (t, ³*J*_{H,H} = 7.8 Hz, 1H), 7.68 (d, ³*J*_{H,H} = 8.2 Hz, 1H).
Photolumineszenz (im Film, 2% in PMMA):
λₘₐₓ = 456, 488 nm, CIE: (0.21 ;0.37)

Die Photolumineszenz-Quantenausbeute des facialen Isomers **Em1-i** hat den 1.36-fachen Wert der Quantenausbeute des meridionalen Isomers **Em1-s.**

### Beispiel 3:

### 4-Bromdibenzofuran

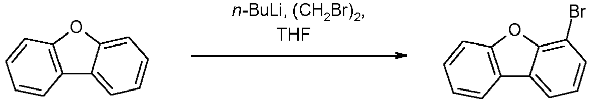

100.00 g (99%ig, 588.6 mmol) Dibenzofuran werden in 800 ml wasserfreiem THF gelöst und bei -40°C mit 400 ml (640.0 mmol) n-BuLi (1.6M in Hexan) versetzt. Das Kältebad wird entfernt. Man läßt die Reaktionslösung innerhalb von ca. 30 min im Wasserbad auf Raumtemperatur kommen und rührt zwei Stunden nach. Danach wird auf - 78°C gekühlt und eine Lösung von 160.34 g (99%ig, 844.9 mmol, 73.55 ml) 1,2-Dibromethan in 80 ml wasserfreiem THF zugetropft. Man entfernt das Kältebad, lässt innerhalb von ca. 30 min im Wasserbad auf Raumtemperatur kommen und rührt weitere 2 Stunden nach. Anschließend werden vorsichtig 60 ml gesättigte Natriumchloridlösung zugegeben (leicht exotherme Reaktion, 1-2 °C Temperaturanstieg). Die organische Phase wird abgetrennt und im Vakuum vom Lösungsmittel befreit. Der ölige rotbraune Rückstand wird in 900 ml Dichlormethan aufgenommen und nacheinander mit 500 ml HCl-Lösung (1 N) und 400 ml Wasser gewaschen. Die organische Phase wird über Magnesiumsulfat getrocknet und im Vakuum vom Lösungsmittel befreit. Beim Abkühlen kristallisiert ein gelblicher Festoff aus, der in einer Reibschale zerkleinert und auf einer Fritte mit 2 x 150 ml Isopropanol gewaschen wird. Nach dem Trocknen erhält man 120.36 g beige-farbenes Pulver (nach GC und NMR: Stoffmengenverhältnis DBF/Br-DBF = 10/90, entspricht 111.93 g Br-DBF/76% Ausbeute). Aus der Isopropanol-Lösung erhält man nach Entfernen des Lösungsmittels weitere 15.84 g eines Gemischs aus Dibenzofuran und 4-Bromdibenzofuran (enthält weitere ca. 7.8 g/5% Br-DBF). Dieses Gemisch kann ebenfalls in den weiteren Stufen eingesetzt werden.
¹H-NMR (CDCl₃, 500 MHz):
δ = 7.92 (d, ³*J*_{H,H} = 7.8 Hz, 1 H), 7.86 (dd, ³*J*_{H,H}= 7.7 Hz, ³*J*_{H,H}= 1.0 Hz, 1 H), 7.65 (d, ³*J*_{H,H}= 8.2 Hz, 1H), 7.61 (dd, ³*J*_{H,H}= 7.8 Hz, ³*J*_{H,H}= 1.1 Hz, 1H), 7.50 (dt, ³*J*_{H,H}= 8.2 Hz, ³*J*_{H,H}= 1.3 Hz, 1H), 7.37 (dt, ³*J*_{H,H}= 7.8 Hz, *J*_{H,H}= 0.8 Hz, 1H), 7.21 (t, ³*J*_{H,H}= 7.8 Hz, 1H).

### 1-Dibenzofuran-4-yl-1H-imidazol

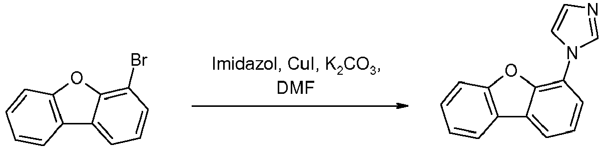

119.00 g der ersten Stufe (enthalten 110.66 g, 447.9 mmol 4-Brom-dibenzofuran) werden in 700 ml Dimethylformamid gelöst und nacheinander mit 37.15 g (545.7 mmol) Imidazol, 15.80 g (83.0 mmol) Kupfer(I)-iodid und 83.20 g (602.0 mmol) Kaliumcarbonat versetzt. Man rührt 48 h bei 150 °C, wobei nach 24 h weitere 3.75 g (55.1 mmol) und nach 44 h weitere 1.93 g (28.3 mmol) Imidazol zugegeben werden. Danach wird auf Raumtemperatur abgekühlt und die unlöslichen Bestandteile abfiltriert. Das Filtrat wird zur Trockene eingeengt. Der Rückstand wird in 500 ml Methylenchlorid aufgenommen, nacheinander mit 150 ml Ammoniaklösung (25%ig) und 150 ml Wasser gewaschen, über Magnesiumsulfat getrocknet und eingeengt. Man erhält 82.23 g Rohprodukt, welches ohne weitere Aufreinigung in der nächsten Stufe eingesetzt wird (78% Rohausbeute).

### 3-Dibenzofuran-4-yl-1-methyl-3H-imidazol-1-ium-iodid C2

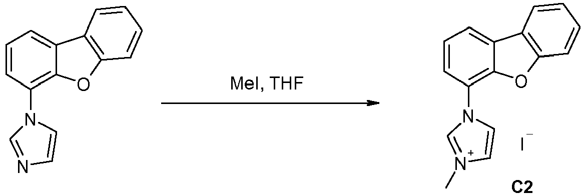

82.03 g (350.1 mmol) 1-Dibenzofuran-4-yl-1 H-imidazol (Rohprodukt) werden in 1 L Tetrahydrofuran gelöst und langsam mit 246.06 g (1.733 mol) Methyliodid versetzt. Man rührt 65 h bei Raumtemperatur. Der entstandene Niederschlag wird abfiltriert, mit 1 L Tetrahydrofuran gewaschen und getrocknet. Man erhält 98.41 g (261.6 mmol, 75%) beigefarbenes Pulver.
¹H-NMR (DMSO, 500 MHz):
δ = 10.00 (s, 1H, NCHN), 8.49 (t, *J* = 1.9 Hz, 1H, CH_{Aryl}), 8.41 (dd, ³*J*_{H,H}= 7.8 Hz, *J* = 1.0 Hz, 1H, CH_{Aryl}), 8.32-8.30 (m, 1H, CH_{Aryl}), 8.15 (t, *J =* 1.8 Hz, 1H, CH_{Aryl}), 7.96 (dd, ³*J*_{H,H}= 7.9 Hz, *J* = 1.0 Hz, 1 H, CH_{Aryl}), 7.84 (d, ³*J*_{H,H}= 8.4 Hz, 1 H, CH_{Aryl}), 7.69-7.65 (m, 2H, CH_{Aryl}), 7.53 (dt, ³*J*_{H,H}= 7.5 Hz, *J =* 0.9 Hz, 1 H, CH_{Aryl}), 4.12 (s, 3H, CH₃).

### Komplex Em2-s:

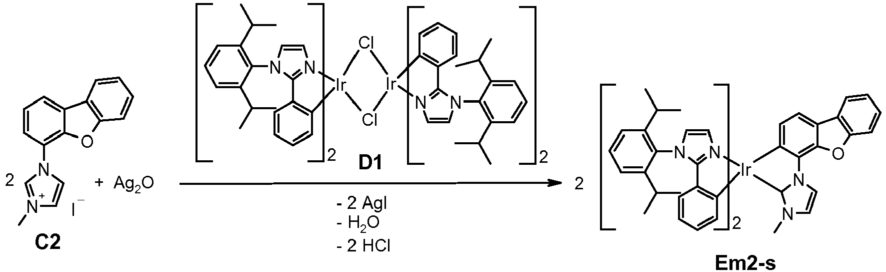

1.01 g (2.7 mmol) Imidazoliumiodid **C2** und 0.31 g (1.3 mmol) Ag₂O werden in 200 ml wasserfreiem Acetonitril 18 h bei Raumtemperatur gerührt. Dann wird das Lösungsmittel im Vakuum entfernt. Man nimmt den Rückstand in 300 ml wasserfreiem THF auf und gibt 1.50 g (0.9 mmol) Chlorodimer **D1** hinzu. Im Anschluss wird 24 h am Rückfluss erhitzt. Nach dem Abkühlen wird die Reaktionslösung filtriert. Das Filtrat wird im Vakuum vom Lösungsmittel befreit. Man wäscht den Rückstand mit Methanol und erhält nach dem Trocknen 1.2 g des Komplexes **Em2-s** als gelbes Pulver (64%).
¹H-NMR (CD₂Cl₂, 500 MHz):
δ= 0.86 (d, ³*J*_{H,H} = 6.9 Hz, 3H), 0.96 (d, ³*J*_{H,H} = 6.8 Hz, 3H), 1.00 (d, ³*J*_{H,H} = 6.7 Hz, 3H), 1.02 (d, ³*J*_{H,H} = 7.1 Hz, 3H), 1.03 (d, ³*J*_{H,H} = 7.1 Hz, 3H), 1.06 (d, ³*J*_{H,H} = 6.9 Hz, 3H), 1.21 (d, ³*J*_{H,H} = 7.0 Hz, 3H), 1.23 (d, ³*J*_{H,H} = 7.0 Hz, 3H), 2.15 (sept, ³*J*_{H,H} = 6.9 Hz, 1H), 2.39 (sept, ³*J*_{H,H} = 6.9 Hz, 1H), 2.77-2.85 (m, 2H), 3.34 (s, 3H), 6.17 (bd, ³*J*_{H,H} = 7.8 Hz, 1 H), 6.20 (bd, ³*J*_{H,H} = 7.8 Hz, 1 H), 6.41 (d, *J* = 1.5 Hz, 1 H), 6.44-6.52 (m, 2H), 6.54 (d, *J* = 1.5 Hz, 1 H), 6.67-6.79 (m, 5H), 6.89 (d, ³*J*_{H,H} = 7.4 Hz, 1 H), 6.95 (d, *J =* 1.9 Hz, 1 H), 7.16 (bd, ³*J*_{H,H} = 7.3 Hz, 1H), 7.29-7.41 (m, 7H), 7.51-7.55 (m, 2H), 7.61 (bd, ³*J*_{H,H} = 8.1 Hz, 1 H), 7.89 (bd, ³*J*_{H,H} = 8.3 Hz, 1 H), 8.46 (d, *J* = 1.9 Hz, 1 H).
Photolumineszenz (im Film, 2% in PMMA):
λₘₐₓ = 460, 491 nm, CIE: (0.18;0.33)

### Beispiel 4:

### Komplex Em2-i:

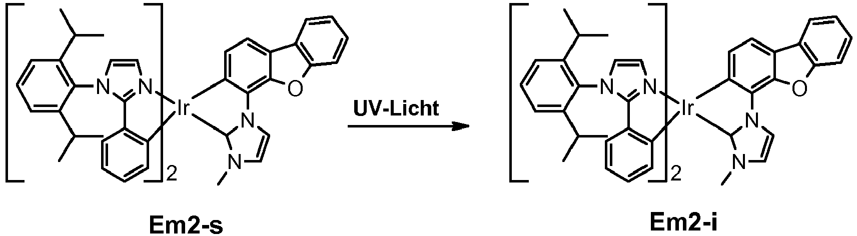

Eine Lösung von 0.90 g Komplex **Em2-s** in 200 ml 3-Methoxypropionitril wird bei Raumtemperatur 3 h mit einer Blacklight-Blue-Lampe bestrahlt (Osram, L18W/73, λₘₐₓ = 370-380 nm). Das Lösungsmittel wird im Vakuum entfernt. Der Rückstand wird sorgfältig mit Methanol gewaschen. Man erhält 0.63 g **Em2-i** als gelbes Pulver (70%).

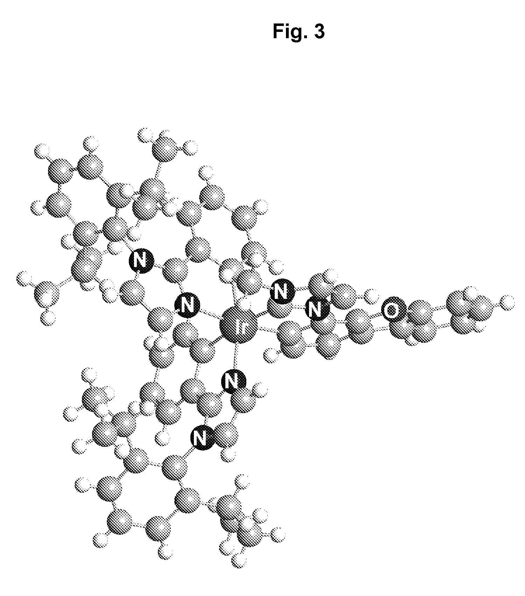

Die Konfiguration von **Em2-i** entspricht der Konfiguration **IVa** bzw. **IVb** des pseudofacialen Isomers S4a bzw. S4b. Em2-1 liegt als Racemat vor, Kristallstruktur siehe Figur 3, die Probe für die Röntgenstrukturanalyse wurde aus Tetrahydrofuran/n-Heptan kristallisiert.
¹H-NMR (CD₂Cl₂, 400 MHz):
δ= 0.72 (d, ³*J*_{H,H} = 6.8 Hz, 3H), 0.85 (d, ³*J*_{H,H} = 6.8 Hz, 3H), 0.90 (d, ³*J*_{H,H} = 6.8 Hz, 3H), 0.99 (d, ³*J*_{H,H} = 6.9 Hz, 3H), 1.02 (d, ³*J*_{H,H} = 6.8 Hz, 3H), 1.11 (d, ³*J*_{H,H} = 6.9 Hz, 3H), 1.19 (d, ³*J*_{H,H} = 7.1 Hz, 3H), 1.21 (d, ³*J*_{H,H} = 7.1 Hz, 3H), 1.90 (sept, ³*J*_{H,H} = 6.8 Hz, 1H), 2.46 (sept, ³*J*_{H,H} = 6.8 Hz, 1 H), 2.60 (sept, ³*J*_{H,H} = 6.9 Hz, 1 H), 2.77 (sept, ³*J*_{H,H} = 6.9 Hz, 1 H), 3.53 (s, 3H), 6.16 (bd, ³*J*_{H,H} = 7.7 Hz, 2H), 6.38-6.56 (m, 5H), 6.65-6.69 (m, 2H), 6.76-6.84 (m, 4H), 6.99 (d, *J =* 1.9 Hz, 1 H), 7.22 (d, ³*J*_{H,H} = 7.7 Hz, 1 H), 7.27-7.37 (m, 6H), 7.49-7.60 (m, 3H), 7.86 (bd, ³*J*_{H,H} = 7.2 Hz, 1H), 8.38 (d, *J =* 1.9 Hz, 1H).
Photolumineszenz (im Film, 2% in PMMA):
λₘₐₓ = 462, 490 nm, CIE: (0.17;0.29)

Die Photolumineszenz-Quantenausbeute des facialen Isomers **Em2-i** hat den 1.44-fachen Wert der Quantenausbeute des Isomers **Em2-s.**

### Beispiel 5: (Vergleichsbeispiel)

### Komplex Em3-s:

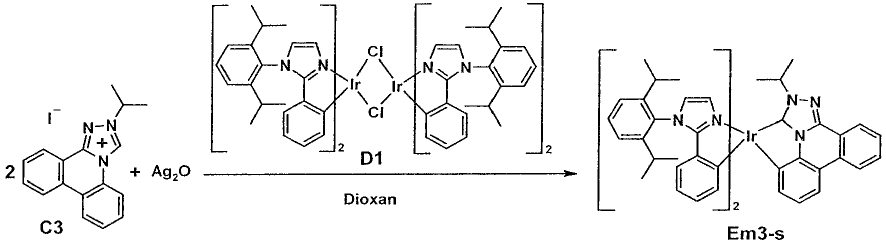

6.0 g (15.5 mmol) 1-Isopropyl-1,2,4-triazolo[4,3-f]phenanthridinium-iodid **C3** und 2.9 g (12.3 mmol) Ag₂O werden in 400 ml Dioxan 40 h bei Raumtemperatur gerührt. Anschließend gibt man 2.6 g (1.6 mmol) Chlorodimer **D1** hinzu und erhitzt die Mischung 24 h zum Rückfluss. Nach dem Abkühlen auf Raumtemperatur wird der Niederschlag abfiltriert und mit Dichlormethan gewaschen. Die vereinten Filtrate werden zur Trockene eingeengt und säulenchromatographisch (Kieselgel, Dichlormethan) aufgereinigt. Nach dem Trocknen erhält man 2.1 g **Em3-s** als gelbes Pulver (64%).
¹H-NMR (CD₂Cl₂, 500 MHz):
δ = 0.79 (d, 3H), 0.89 (d, 3H), 0.90 (d, 3H), 0.97 (d, 6H), 1.02 (d, 3H), 1.10 (d, 3H), 1.15 (d, 3H), 1.16 (d, 3H), 1.47 (d, 3H), 2.03 (sept, 1H), 2.47 (sept, 1H), 2.65 (sept, 1H), 2.76 (sept, 1H), 4.47 (sept, 1H), 6.13 (d, 1H), 6.21 (d, 1H), 6.35 (d, 1H), 6.46 (m*_{c}*, 3H), 6.58 (dd, 2H), 6.65-6.76 (m, 3H), 6.93 (dd, 1 H), 7.09 (dd, 1 H), 7.15 (d, 1 H), 7.25 (dd, 1H), 7.28-7.33 (m, 3H), 7.44-7.52 (m, 2H), 7.58 (dd, 1H), 7.67-7.76 (m, 2H), 8.39 (dd, 1 H), 8.43 (d, 1 H).
Photolumineszenz (im Film, 2% in PMMA):
λₘₐₓ = 457, 489 nm, CIE: (0.18;0.32)

### Beispiel 6: (Vergleichsbeispiel)

### Komplex Em3-i:

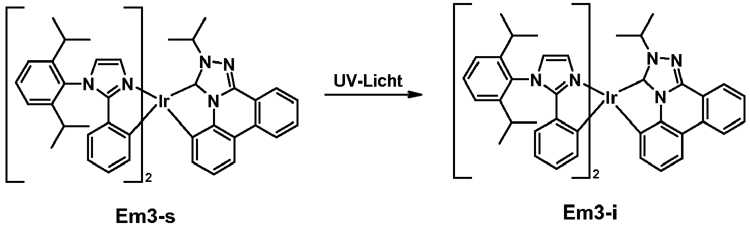

Eine Suspension von 2.1 g des **Em3-s** in 2000 ml Acetonitril wird bei Raumtemperatur 8 h mit einer Quecksilber-Mitteldruck-Tauchlampe bestrahlt (TQ150 mit Duranmantel). Anschließend wird das Lösungsmittel im Vakuum entfernt. Der Rückstand wurde zweimal mit Aceton verrührt und filtriert. Man erhielt 1.6 g des **Em3-i** als gelbes Pulver (76%).
¹H-NMR (CD₂Cl₂, 500 MHz):
δ = 0.68 (d, 3H), 0.75 (d, 3H), 0.82 (d, 3H), 0.96 (d, 3H), 0.99 (d, 3H), 1.05 (d, 3H), 1.13 (d, 3H), 1.20 (d, 3H), 1.24 (d, 3H), 1.60 (d, 3H), 1.79 (sept, 1 H), 2.42 (sept, 1 H), 2.51 (sept, 1 H), 2.76 (sept, 1 H), 4.56 (sept, 1 H), 6.10 (dd, 2H), 6.30-6.35 (m, 1 H), 6.38-6.45 (m, 2H), 6.53 (d, 1 H), 6.61 (dd, 1 H), 6.68 (d, 1 H), 6.73 (d, 1 H), 6.74-6.78 (m, 2H), 6.79 (d, 1H), 6.96 (dd, 1H), 7.07-7.15 (m, 1H), 7.19 (d, 1H), 7.22 (d, 1H), 7.27-7.34 (m, 3H), 7.47 (dd, 1 H), 7.49 (dd, 1 H), 7.66-7.72 (m, 2H), 8.34 (d, 1 H), 8.40 (d, 1 H).
Photolumineszenz (im Film, 2% in PMMA):
λₘₐₓ = 456, 487 nm, CIE: (0.19;0.32)

Die Photolumineszenz-Quantenausbeute des Isomers **Em3-i** hat den 1.21-fachen Wert der Quantenausbeute des Isomers **Em3-s.**

### Beispiel 7:

### 4-Methyl-1,3-diphenyl-1H-[1,2,4]-triazoliumiodid C4:

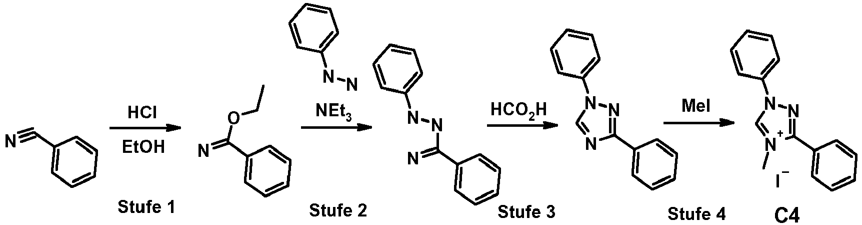

Stufe 1: Benzonitril (51.5 g, 0.50 mol) wird mit Ethanol (wasserfrei, 25 mL) versetzt. Darauf wird über 2 h ein konstanter Strom HCl-Gas eingeleitet und anschließend 48 h bei Raumtemp. nachgerührt, wobei ein Feststoff entsteht. Aus der Reaktionsmischung wird das Lösungsmittel unter reduziertem Druck abgezogen (95 g).

Stufe 2+3: 12 g der Stufe 1 (64.6 mmol) werden wiederum in EtOH (120 mL) gelöst und Phenylhydrazin (9.4 g, 84 mmol, 1.3 Äquiv.) zugefügt, wobei sich ein Feststoff bildet. Triethylamin (22 mL, 162 mmol, 2.5 Äquiv.) wird zugegeben und darauf 16 h bei Raumtemp. gerührt. Aus der Reaktionsmischung wird wiederum das Lösungsmittel unter reduziertem Druck bei Raumtemp. entfernt, so dass das entstandene Amidrazon noch feucht zurückbleibt. Nach der Zugabe von Ameisensäure (200 mL) wird 3.5 h zum Rückfluss erhitzt. Nach weiteren 48 h bei Raumtemp. wird vorsichtig auf eine wäßr. Kaliumcarbonat-Lösung (44 %, 900 mL), gekühlt auf 0°C, gegeben. Nach der Zugabe von CH₂Cl₂ (500 mL) werden die Phasen getrennt, die organische Phase wird über Na₂SO₄ getrocknet und unter reduziertem Druck eingeengt. Die Probe wird aus Dichlormethan/Petrolether umkristallisiert, woraus schwach verunreinigtes Produkt (5.5 g, 40 %) erhalten wird. Die Mutterlauge wird säulenfiltriert (CH₂Cl₂/*n*-Hexan), woraus eine weitere Charge sauberes Produkt erhalten wird (1.7 g, 12 %).

Stufe 4: Das Triazol der Vorstufe (1.5 g, 66 mmol) wird in THF (wasserfrei, 40 mL) gelöst, mit Mel (14 mL) versetzt und 5 Tage zum Rückfluss erhitzt. Der erhaltene Feststoff wird abfiltiert, mehrfach umkristallisiert (CH₂Cl₂/*n*-Hexan) und getrocknet (780 mg, 32%).
¹H-NMR (400 MHz, CD₂Cl₂):
δ = 4.26 (s, 3H), 7.53 - 7.71 (m, 6H), 7.74 - 7.76 (m, 2H), 8.09 - 8.11 (m, 2H), 12.27 (s, 1 H).

### Komplex Em4-s:

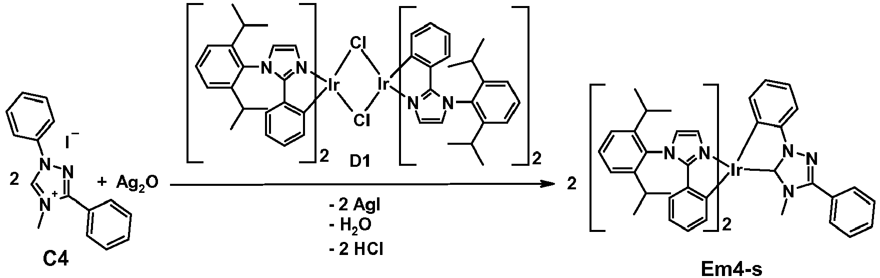

0.40 g (1.1 mmol) Imidazoliumiodid **C4** und 0.13 g (0.56 mmol) Ag₂O werden in 50 ml wasserfreiem Acetonitril 18 h bei Raumtemperatur gerührt. Dann wird eine Lösung von 0.61 g (0.37 mmol) Chlorodimer **D1** in 25 ml wasserfreiem Acetonitril zugegeben. Im Anschluss wird 6 h zum Rückfluss erhitzt und danach noch 16 h bei Raumtemperatur gerührt. Nach dem Abkühlen wird die Reaktionslösung filtriert. Das Filtrat wird im Vakuum vom Lösungsmittel befreit. Nach Waschen des Rückstandes mit Methanol erhält man 0.2 g des Komplexes **Em4-s** als gelbes Pulver (26%).
¹H-NMR (500 MHz, CD₂Cl₂):
δ = 0.91 (d, ³*J*_{H,H} = 6.9 Hz, 3H), 0.95 (d, ³*J*_{H,H} = 7.1 Hz, 3H), 0.97 (d, ³*J*_{H,H} = 7.1 Hz, 3H), 0.98(d, ³*J*_{H,H} = 6.8 Hz, 3H), 1.00 (d, ³*J*_{H,H} = 6.9 Hz, 3H), 1.05 (d, ³*J*_{H,H} = 6.9 Hz, 3H), 1.20 (d, ³*J*_{H,H} = 6.9 Hz, 3H), 1.21 (d, ³*J*_{H,H} = 6.9 Hz, 3H), 2.17 (sept, ³*J*_{H,H} = 6.8 Hz, 1 H), 2.40 (sept, ³*J*_{H,H} = 6.9 Hz, 1 H), 2.75-2.82 (m, 2H), 3.36 (s, 3H), 6.17 (bt, ³*J*_{H,H} = 7.0 Hz, 2H), 6.43-6.50 (m, 3 H), 6.62 (d, *J =* 1.5 Hz, 1 H), 6.66-6.82 (m, 6 H), 6.88 (dd, ³*J*_{H,H} = 7.1 Hz, *J* = 1.3 Hz, 1 H), 6.96 (dt, ³*J*_{H,H} = 7.4 Hz, *J =* 1.5 Hz, 1 H), 7.08 (bd, ³*J*_{H,H} = 6.7 Hz, 1 H), 7.31-7.37 (m, 4H), 7.51-7.59 (m, 6H), 7.69-7.72 (m, 2H).
Photolumineszenz (im Film, 2% in PMMA):
λₘₐₓ = 458, 488 nm, CIE: (0.19;0.33)

### Beispiel 8:

### Komplex Em4-i:

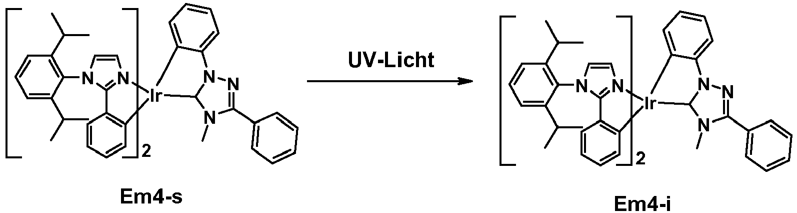

Eine Lösung von 0.15 g Komplex **Em4-s** in 200 ml 3-Methoxypropionitril wird bei Raumtemperatur 2 h mit einer Blacklight-Blue-Lampe bestrahlt (Osram, L18W/73, λₘₐₓ = 370-380 nm). Das Lösungsmittel wird im Vakuum entfernt. Der Rückstand wird sorgfältig mit Methanol gewaschen. Man erhält 0.05 g **Em4-i** als gelbes Pulver (33%).
¹H-NMR (500 MHz, CD₂Cl₂):
δ = 0.71 (d, ³*J*_{H,H} = 6.9 Hz, 3H), 0.84 (d, ³*J*_{H,H} = 6.8 Hz, 3H), 0.88 (d, ³*J*_{H,H} = 6.9 Hz, 3H), 1.03 (d, ³*J*_{H,H} = 6.8 Hz, 3H), 1.06 (d, ³*J*_{H,H} = 6.7 Hz, 3H), 1.07 (d, ³*J*_{H,H} = 6.8 Hz, 3H), 1.18 (d, ³*J*_{H,H} = 6.9 Hz, 3H), 1.19 (d, ³*J*_{H,H} = 6.9 Hz, 3H), 1.89 (sept, ³*J*_{H,H} = 6.8 Hz, 1 H), 2.50 (sept, ³*J*_{H,H} = 6.9 Hz, 1 H), 2.58 (sept, ³*J*_{H,H} = 6.9 Hz, 1 H), 2.73 (sept, ³*J*_{H,H} = 6.9 Hz, 1 H), 6.17 (bd, ³*J*_{H,H} = 7.8 Hz, 2H), 6.42-6.52 (m, 3H), 6.60 (dt, ³*J*_{H,H} = 7.6 Hz, *J* =1.3 Hz, 1H), 6.64-6.70 (m, 4H), 6.76-6.78 (m, 2H), 6.81 (d, *J* = 61.4 Hz, 1 H), 6.91-6.94 (m, 2H), 7.27-7.38 (m, 4H), 7.50-7.56 (m, 6H), 7.75-7.77 (m, 2H).
Photolumineszenz (im Film, 2% in PMMA):
λₘₐₓ = 456, 488 nm, CIE: (0.19;0.33)

Die Photolumineszenz-Quantenausbeute des Isomers **Em4-i** hat den 1.40-fachen Wert der Quantenausbeute des Isomers **Em4-s.**

### Beispiel 9:

### 3,4-Diphenyl-1-o-tolyl-4H-[1,2,4]-triazoliumiodid C5:

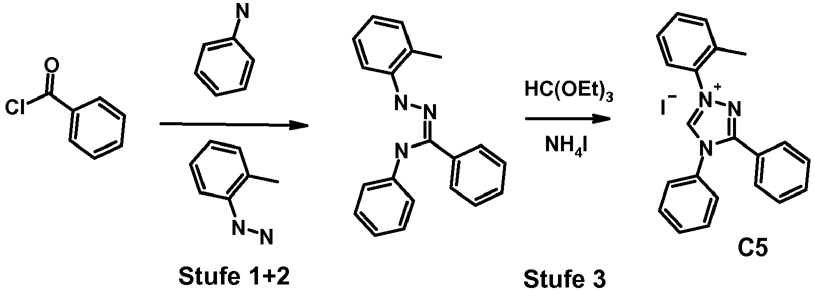

Stufe 1: Zu einer Suspension von o-Tolylhydrazin-Hydrochlorid (15 g, 97 mmol) in Methylchlorid (450 ml) wird bei Raumtemp. wäßr. NaHCO₃-Lösung (5%, 330 g, 190 mmol, 2.0 Äquiv.) gegeben. Nach 30 minütigem Rühren wird die 2-phasige Lösung phasengetrennt. Die organische Phase wird über Na₂SO₄ getrocknet, vom Lösungsmittel befreit und bei 60°C unter reduziertem Druck getrocknet, wobei Tolylhydrazin als hellgelber Feststoff isoliert wird (7.3 g, 62%).

Stufe 2: Benzoylchlorid (8.4 g, 60 mmol, 1.0 Äquiv.) wird in Toluol (wasserfrei, 60 mL) vorgelegt und auf 5°C abgekühlt. Darauf wird Anilin (5.6 g, 60 mmol, 1.0 Äquiv.) zugegeben, die Reaktionsmischung für 16 h zum Rückfluss erhitzt und anschließend 48 h bei Raumtemp. nachgerührt. Darauf wird auf 80°C erwärmt, bei dieser Temperatur Thionylchlorid (21.4 g, 180 mmol, 3.0 Äquiv.) zugegeben und 2 h nachgerührt. Darauf wird auf Raumtemp. abgekühlt und das überschüssige Thionylchlorid unter reduziertem Druck abgezogen. Die Reaktionsmischung wird mit THF (wasserfrei, 180 mL) und Triethylamin (9.1 g, 90 mmol, 1.5 Äquiv.) versetzt und auf 5°C abgekühlt, worauf das Tolylhydrazin der Stufe 1 (7.3 g, 60 mmol), gelöst in THF (20 mL), zugegeben wird. Die Mischung wird 16 h bei Raumtemperatur gerührt. Nach dem Entfernen des Lösungsmittels wird der Rückstand aus Essigsäure (2%, 150 mL) umkristallisiert, mit *i*PrOH (80 mL, 20 mL) gewaschen und getrocknet (10.3 g, 57%).

Stufe 3: Triethylorthoformiat (9.0 mL, 8.1 g, 56 mmol, 5.6 Äquiv.) und 3 g des Hydrazons der Stufe 2 (10 mmol) werden vorgelegt, Ammoniumiodid (1.4 g, 10 mmol, 1.0 Äquiv.) zugegeben und die Suspension für 7 h zum Rückfluss erhitzt. Nach dem Abkühlen wird der Feststoff abgesaugt und mit n-Hexan sowie Essigester mehrfach gewaschen, woraus das Iodid-Salz als graues Pulver erhalten wird (3.2 g, 73%).
¹H-NMR (400 MHz, DMSO):
δ = 2.55 (s, 3H), 7.47 - 7.90 (m, 14 H), 11.07 (s, 1 H).

### Komplexgemisch Em5-s:

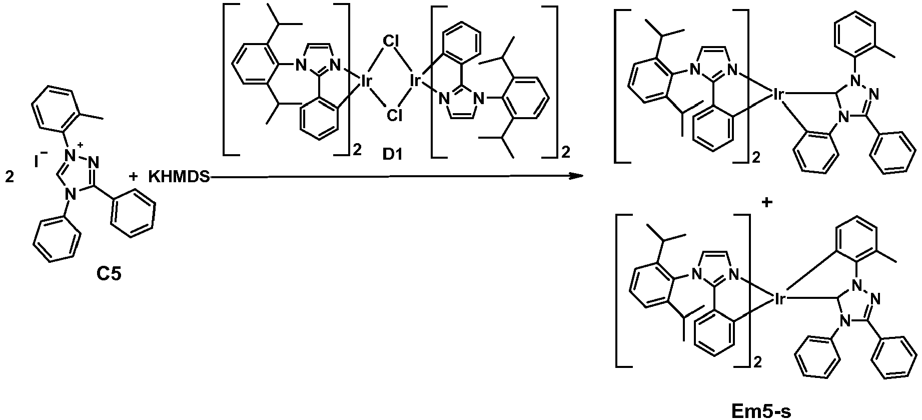

1.12 g (2.5 mmol) Imidazoliumiodid **C5** werden in 100 ml wasserfreiem Toluol suspendiert. Bei 0°C werden 8.2 ml (4.1 mmol) Kalium-bis-(trimethylsilyl)-amid (0.5M in Toluol) innerhalb von 5 min zugetropft. Die entstandene Lösung wird auf 10 °C aufwärmen gelassen und mit einer Suspension aus 1.42 g (0.85 mmol) Chlorodimer **D1** und 75 ml wasserfreiem Toluol versetzt. Das Reaktionsgemisch wird auf 90°C erhitzt und 2 h bei dieser Temperatur gerührt. Nach dem Abkühlen wird der Niederschlag abgetrennt. Das Filtrat wird nacheinander mit 3x30 ml wäßriger NaHCO₃-Lösung und 1x30 ml Wasser gewaschen, über MgSO₄ getrocknet und im Vakuum vom Lösungsmittel befreit. Der Rückstand wird säulenchromatographisch (Laufmittel: Cyclohexan/Aceton = 4/1) gereinigt. Man erhält 1.2 g (63%) **Em5-s** als Gemisch zweier Cyclometallierungsisomere.
Photolumineszenz (im Film, 2% in PMMA):
λₘₐₓ = 461, 489 nm, CIE: (0.19;0.33)

### Beispiel 10:

### Komplexgemisch Em5-i:

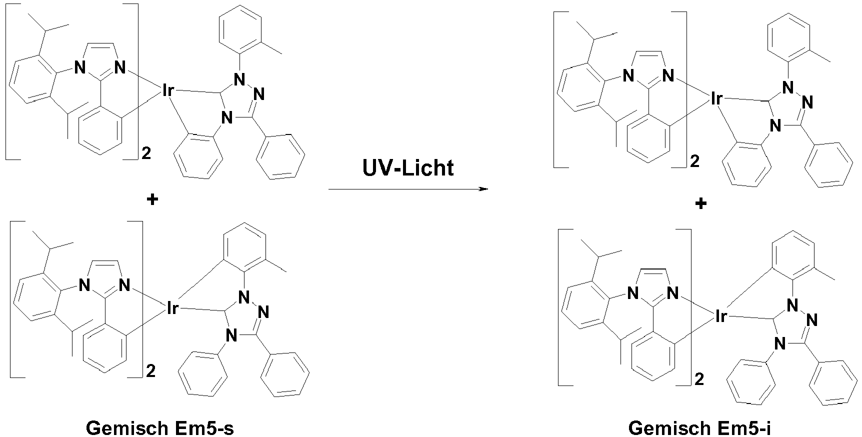

Eine Lösung von 0.60 g Komplexgemisch **Em5-s** in 200 ml 3-Methoxypropionitril wird bei Raumtemperatur 7 h mit einer Blacklight-Blue-Lampe bestrahlt (Osram, L18W/73, λₘₐₓ = 370-380 nm). Das Lösungsmittel wird im Vakuum entfernt. Der Rückstand wird sorgfältig mit Methanol gewaschen. Man erhält 0.10 g **Em5-i** als hellgelbes Pulver (17%, wiederum Gemisch zweier Cyclometallierungsisomere).
MS (Maldi):
m/e = 1110 (M+H)⁺
Photolumineszenz (im Film, 2% in PMMA):
λₘₐₓ = 456, 487 nm, CIE: (0.20;0.34)

Die Photolumineszenz-Quantenausbeute des isomerisierten Komplex-gemisches **Em5-i** hat den 1.50-fachen Wert der Quantenausbeute des Komplexgemisches **Em5-s.**

### Beispiel 11:

### 1-Methyl-2-phenyl-1H-imidazol L2:

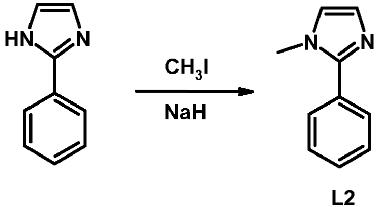

13.0 g (90 mmol) 2-Phenylimidazol werden in 600 ml DMF gelöst, langsam mit 4.0 g (100 mmol) Natriumhydrid (60%ig in Mineralöl) versetzt und 30 min bei Raumtemperatur gerührt. Dann werden 14.0 g (99 mmol) Methyliodid zugegeben. Das Reaktionsgemisch wird 1.5 h bei Raumtemperatur gerührt und dann vorsichtig mit 350 ml Wasser versetzt. Das Gemisch wird mit 2 x 200 ml Essigsäureethylester extrahiert. Der Extrakt wird über Natriumsulfat getrocknet und eingeengt. Man erhält 12.0 g (84%) **L2**.
¹H-NMR (400 MHz, CD₂Cl₂):
δ = 3.74 (s, 3H), 7.00 (s, 1 H), 7.05 (s, 1 H), 7.40-7.43 (m, 1 H), 7.45-7.48 (m, 2H), 7.62-7.63 (m, 2H).

### µ-Dichlorodimer D2:

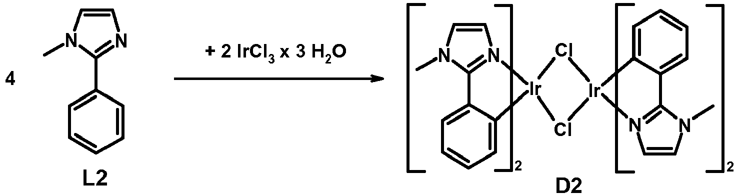

Die Synthese wird analog zu **D1** durchgeführt. Der erhaltene Niederschlag wird mit Dichlormethan extrahiert. Aus dem Extrakt erhält man nach Entfernen des Lösungsmittel **D2** in einer Ausbeute von 36%.
¹H-NMR (CD₂Cl₂, 400 MHz):
δ= 4.13 (s, 12H), 6.05 (d, ³*J*_{H,H} = 7.7 Hz, 4H), 6.55 (t, ³*J*_{H,H} = 7.5 Hz, 4H), 6.74 (t, ³*J*_{H,H} = 7.5 Hz, 4H), 6.94 (s, 4H), 7.27 (s, 4H), 7.37 (d, ³*J*_{H,H} = 7.7 Hz, 4H).

### Komplex Em6-s:

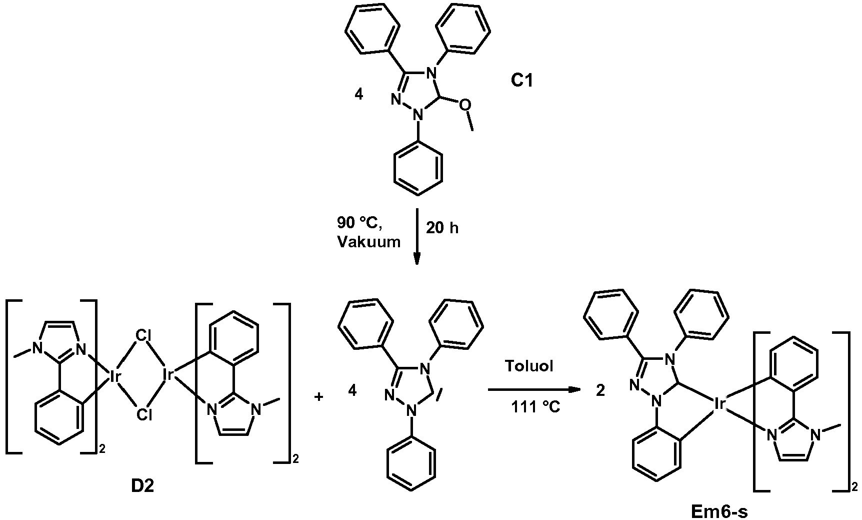

1.20 g (3.6 mmol) 5-Methoxy-1,3,4-triphenyl-4,5-dihydro-1H-1,2,4-triazol **C1** werden 20 h im Vakuum auf 90°C erhitzt. Nach dem Abkühlen auf Raumtemperatur werden zunächst 1.2 L wasserfreies Toluol und anschließend 0.99 g (0.9 mmol) Chlorodimer **D2** zugegeben. Es wird 8 h zum Rückfluss erhitzt. Der entstandene Niederschlag wird abfiltriert. Das Filtrat wird auf ca. 800 ml eingeengt und nacheinander mit 3 x 500 ml gesättigter NaHCO₃-Lösung und 1 x 500 ml destilliertem Wasser gewaschen, über Na₂SO₄ getrocknet und im Vakuum vom Lösungsmittel befreit. Der Rückstand wird säulenchromatographisch (Cyclohexan/Aceton = 5/1) aufgereinigt. Man erhält 118 mg des Komplexes **Em6-s** (8%).
¹H-NMR (CD₂Cl₂, 400 MHz):
δ= 3.95 (s, 3H), 4.03 (s, 3H), 6.00 (bd, ³*J*_{H,H} = 7.3 Hz, 1 H), 6.23 (bt, ³*J*_{H,H} = 7.3 Hz, 1 H), 6.27 (d, *J* = 1.5 Hz, 1 H), 6.47 (bd, ³*J*_{H,H} = 7.1 Hz, 1 H), 6.51 (d, *J* = 1.5 Hz, 1 H), 6.60 (bt, ³*J*_{H,H} = 7.5 Hz, 1 H), 6.67-6.72 (m, 4H), 6.79-6.88 (m, 6H), 6.95 (dt, ³*J*_{H,H} = 7.5 Hz, *J =* 1.5 Hz, 1 H), 7.05 (bt, ³*J*_{H,H} = 7.5 Hz, 1 H), 7.24-7.27 (m, 2H), 7.33-7.36 (m, 4H), 7.47 (bd, ³*J*_{H,H} = 6.8 Hz, 1H), 7.61 (bd, ³*J*_{H,H} = 6.9 Hz, 1H).
Photolumineszenz (im Film, 2% in PMMA):
λₘₐₓ = 456, 486 nm, CIE: (0.21 ;0.33)

### Beispiel 12:

### Komplex Em7-s:

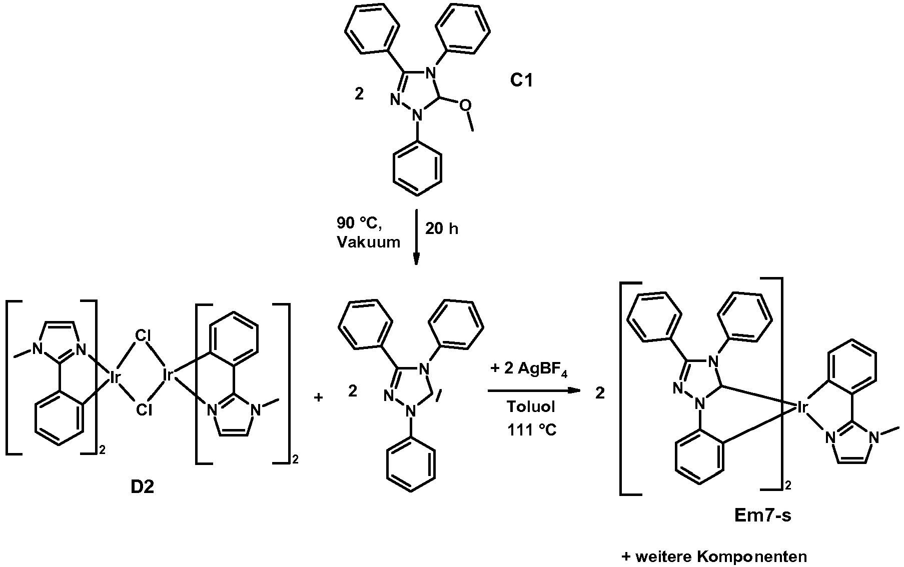

0.67 g (2.0 mmol) 5-Methoxy-1,3,4-triphenyl-4,5-dihydro-1H-1,2,4-triazol **C1** werden 20 h im Vakuum auf 90°C erhitzt. Nach dem Abkühlen auf Raumtemperatur wird der Rückstand in 50 ml wasserfreiem Toluol gelöst und zu einer Suspension aus 1.00 g (0.9 mmol) Chlorodimer **D2** und 0.36 g (1.9 mmol) AgBF₄ in 1.2 L wasserfreiem Toluol gegeben. Es wird 8 h unter Rückfluss gerührt. Der entstandene Niederschlag wird abfiltriert. Das Filtrat wird auf ca. 800 ml eingeengt und nacheinander mit 3 x 500 ml gesättigter NaHCO₃-Lösung und 1 x 500 ml destilliertem Wasser gewaschen, über Na₂SO₄ getrocknet und im Vakuum vom Lösungsmittel befreit. Der Rückstand wird säulenchromatographisch (Cyclohexan/Aceton = 5/1) aufgereinigt. Man erhält 70 mg des Komplexes **Em7-s** (5%).
MS (Maldi):
m/e = 943 (M+H)⁺
¹H-NMR (CD₂Cl₂, 400 MHz):
δ= 3.70 (s, 3H), 5.86 (d, *J =* 1.3 Hz, 1H), 5.96 (bd, ³*J*_{H,H} = 8.1 Hz, 2H), 6.10 (d, *J =* 1.3 Hz, 1 H), 6.56 (bd, ³*J*_{H,H} = 7.2 Hz, 1 H), 6.72-6.75 (m, 4H), 6.80 (bt, ³*J*_{H,H} = 7.3 Hz, 1 H), 6.86-6.92 (m, 3H), 6.94 (bt, ³*J*_{H,H} = 7.5 Hz, 1H), 7.02-7.12 (m, 5H), 7.19-7.40 (m, 13H), 7.56 (bd, ³*J*_{H,H} = 7.7 Hz, 1 H), 7.70 (bd, ³*J*_{H,H} = 7.0 Hz, 1 H).
Photolumineszenz (im Film, 2% in PMMA):
λₘₐₓ = 476, 502 nm, CIE: (0.22;0.37)

### Beispiel 13:

### Komplex Em7-s*:

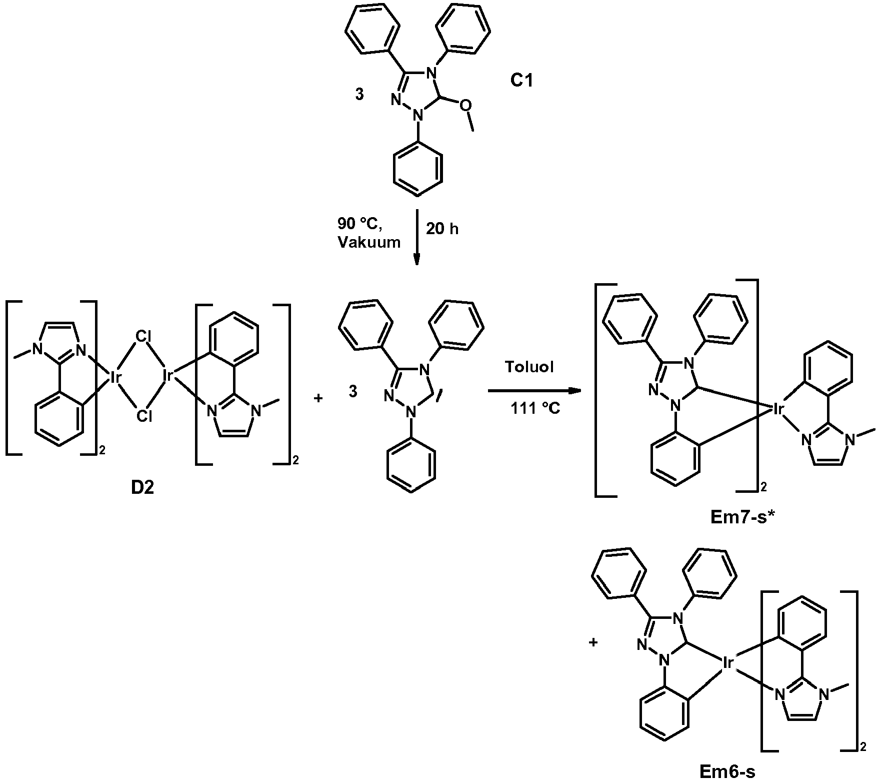

0.90 g (2.7 mmol) 5-Methoxy-1,3,4-triphenyl-4,5-dihydro-1H-1,2,4-triazol **C1** werden 20 h im Vakuum auf 90°C erhitzt. Nach dem Abkühlen auf Raumtemperatur werden zunächst 800 ml wasserfreies Toluol und anschließend 0.99 g (0.9 mmol) Chlorodimer **D2** zugegeben. Es wird 3 h unter Rückfluss gerührt. Der entstandene Niederschlag wird abfiltriert. Das Filtrat wird nacheinander mit 3 x 50 ml gesättigter NaHCO₃-Lösung und 1 x 50 ml destilliertem Wasser gewaschen, über MgSO₄ getrocknet und im Vakuum vom Lösungsmittel befreit. Der Rückstand wird säulenchromatographisch (Cyclohexan/Aceton = 2/1) aufgereinigt. Neben 50 mg des Komplexes **Em6-s** erhält man150 mg des Komplexes **Em7-s*.**
¹H-NMR (CD₂Cl₂, 500 MHz):
δ= 3.86 (s, 3H), 5.95 (bd, ³*J*_{H,H} = 7.3 Hz, 2H), 6.23 (bd, *J* = 1.4 Hz, 1H), 6.38 (bt, ³*J*_{H,H} = 7.3 Hz, 1 H), 6.44 (bd, ³*J*_{H,H} = 7.3 Hz, 1 H), 6.54 (bt, ³*J*_{H,H} = 7.5 Hz, 1 H), 6.61-6.67 (m, 4H), 6.78-6.91 (m, 5H), 6.96 (bt, ³*J*_{H,H} = 7.5 Hz, 1H), 7.07-7.13 (m, 4H), 7.19-7.36 (m, 12H), 7.53 (bd, ³*J*_{H,H} = 7.0 Hz, 1 H), 7.76 (bd, ³*J*_{H,H} = 7.3 Hz, 1 H).
Photolumineszenz (im Film, 2% in PMMA):
λₘₐₓ = 482, 508 nm, CIE: (0.24;0.40)

### Beispiel 14:

### µ-Dichlorodimer D3:

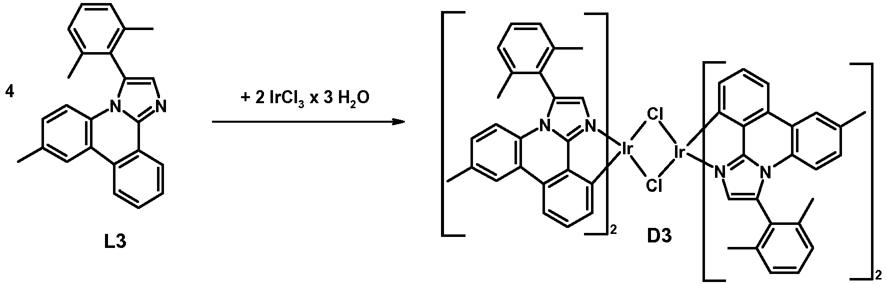

Die Synthese wird analog zu D1 durchgeführt. Ausbeute: 87%.
¹H-NMR (CD₂Cl₂, 400 MHz):
δ= 2.21 (s, 12H), 2.28 (s, 12H), 2.44 (s, 12H), 6.38 (d, ³*J*_{H,H} = 7.4 Hz, 4H), 7.09 (d, ³*J*_{H,H} = 8.7 Hz, 4H), 7.19 (m, 4H), 7.30 (bd, ³*J*_{H,H} = 8.7 Hz, 4H), 7.42 (m, 8H), 7.55 (m, 4H), 7.86 (s, 4H), 8.00 (d, ³*J*_{H,H} = 8.4 Hz, 4H), 8.48 (bs, 4H).

### Komplex Em8-s:

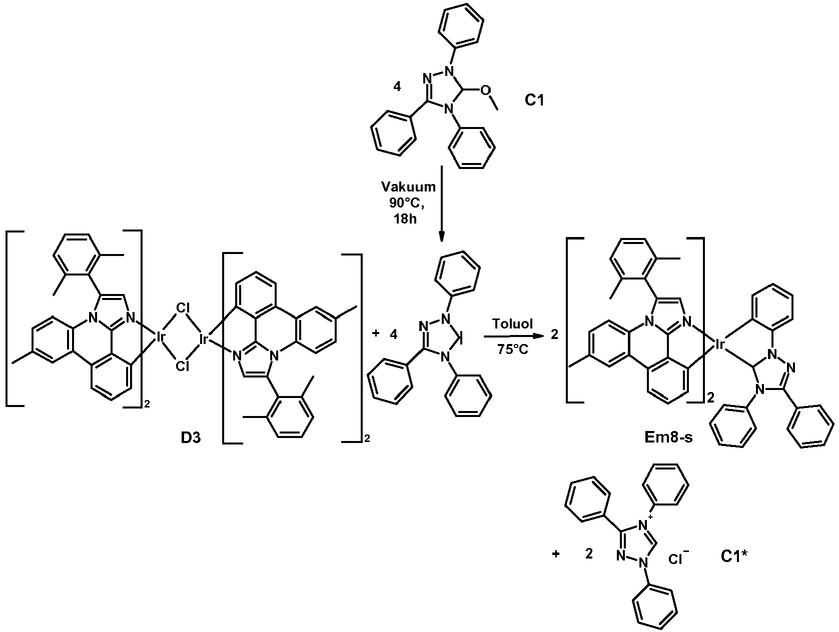

0.37 g (1.1 mmol) 5-Methoxy-1,3,4-triphenyl-4,5-dihydro-1H-1,2,4-triazol **C1** werden 18 h im Vakuum auf 90°C erhitzt. Nach dem Abkühlen auf Raumtemperatur werden zunächst 120 ml wasserfreies Toluol und anschließend 0.50 g (0.28 mmol) Chlorodimer **D3** zugegeben. Es wird 3 h auf 75°C erhitzt. Der entstandene weiße Niederschlag wird abfiltriert. Das Filtrat wird mit 3 x 30 ml gesättigter NaHCO₃-Lösung und 1 x 30 ml destilliertem Wasser gewaschen, über MgSO₄ getrocknet und im Vakuum vom Lösungsmittel befreit. Der Rückstand wird säulenchromatographisch aufgereinigt (Kieselgel, Essigsäureethylester:Cyclohexan = 1:5). Man erhält 0.19 g des Komplexes **Em8-s** (28%).
¹H-NMR (CD₂Cl₂, 500 MHz):
δ= 2.03 (s, 3H), 2.10 (s, 3H), 2.20 (s, 3H), 2.28 (s, 3H), 2.44 (s, 3H), 2.48 (s, 3H), 6.21 (d, ³*J*_{H,H} = 7.6 Hz, 1 H), 6.63-7.39 (m, 28H), 7.45 (d, ³*J*_{H,H} = 7.9 Hz, 1 H), 7.67 (d, ³*J*_{H,H} = 7.9 Hz, 1 H), 7.70 (d, ³*J*_{H,H} = 7.6 Hz, 1 H), 8.21 (bs, 2H).
Photolumineszenz (im Film, 2% in PMMA):
λₘₐₓ = 456 nm, CIE: (0.24;0.29)

### Beispiel 15 (Vergleichsbeispiel, nicht erfindungsgemäß):

### Komplex CEm1:

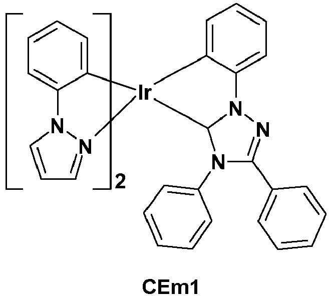

CEm1 entspricht Verbindung **(N-3)** aus WO 2006067074

Die Synthese erfolgt analog zu WO 2006067074.
λ_{PL} (PMMA): 472 nm, 491 nm, Quantenausbeute_{PL}: 2%

Der Komplex **CEm1** ist aufgrund seiner sehr geringen Phosphoreszenz-Quantenausbeute nicht als Emitter in OLEDs geeignet.

### Beispiel 16 (Vergleichsbeispiel, nicht erfindungsgemäß):

### Komplex CEm2:

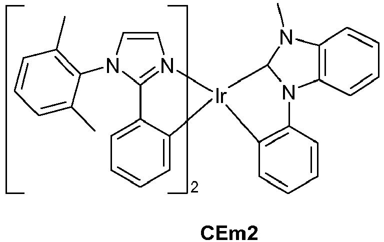

**CEm2** entspricht der Verbindung **"Compound** 3" aus WO 2006121811. Die Synthese erfolgte analog WO 2006121811.

### Beispiel 17:

### Herstellung einer OLED - Vergleich verschiedener Emitter

Das als Anode verwendete ITO-Substrat wird zuerst mit kommerziellen Reinigungsmitteln für die LCD-Produktion (Deconex^{®} 20NS und Neutralisationsmittel 25ORGAN-ACID^{®}) und anschließend in einem Aceton/Isopropanol-Gemisch im Ultraschallbad gesäubert. Zur Beseitigung möglicher organischer Rückstände wird das Substrat in einem Ozonofen weitere 25 Minuten einem kontinuierlichen Ozonfluss ausgesetzt. Diese Behandlung verbessert auch die Lochinjektionseigenschaften des ITOs. Als nächstes wird die Lochinjektionsschicht AJ20-1000 der Firma Plexcore bzw. PEDT:PSS (CLEVIOS P AI 4083) der Firma H.C. Starck aus Lösung aufgesponnen.

Danach werden die nachfolgend genannten organischen Materialien mit einer Rate von ca. 0.5-5 nm/min bei etwa 10⁻⁷-10⁻⁹ mbar auf das gereinigte Substrat aufgedampft. Als Lochleiter und Excitonenblocker wird Ir(DPBIC)₃ mit einer Dicke von 45 nm auf das Substrat aufgebracht, wovon die ersten 35 nm zur Verbesserung der Leitfähigkeit mit MoOₓ dotiert sind. 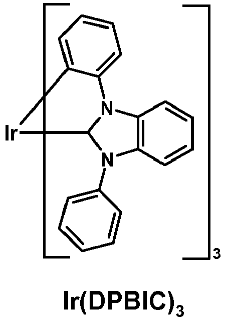 (zur Herstellung siehe Ir-Komplex (7) in der Anmeldung PCT/EP/04/09269).

Anschließend wird eine Mischung aus Emitter und der Verbindung **Ma1** mit einer Dicke von 40 nm aufgedampft, wobei letztere Verbindung als Matrixmaterial fungiert. Anschließend wird das Material **Ma1** mit einer Dicke von 10 nm als Excitonen- und Lochblocker aufgedampft.

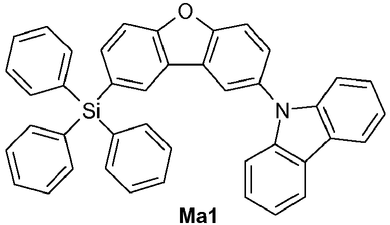

Als nächstes wird ein Elektronentransporter BCP (2,9-Dimethyl-4,7-diphenyl-1,10-phenantrolin) in einer Dicke von 20 nm, eine 0,75 nm dicke Lithiumfluorid-Schicht und abschließend eine 100 nm dicke Al-Elektrode aufgedampft. Alle Bauteile werden in einer inerten Stickstoffatmosphäre mit einem Glasdeckel verklebt.

Zur Charakterisierung des OLEDs werden Elektrolumineszenz-Spektren bei verschiedenen Strömen bzw. Spannungen aufgenommen. Weiterhin wird die Strom-Spannungs-Kennlinie in Kombination mit der abgestrahlten Lichtleistung gemessen. Die Lichtleistung kann durch Kalibrierung mit einem Luminanzmeter in photometrische Größen umgerechnet werden. Die Lebensdauer t_{1/2} der Diode ist definiert durch die Zeit, die vergeht bis die Luminanz auf 50% ihres initialen Werts abgesunken ist. Die Lebensdauermessung wird bei einem konstanten Strom durchgeführt.

Für die verschiedenen Emitter in dem oben beschriebenen OLED-Aufbau ergeben sich die folgenden elektrooptischen Daten:

| Emitter | CIE | Cd/A @ 300nits | t_{1/2} @ 1000nits (normiert auf den Wert von **CEm2**) |
|---|---|---|---|
| **Em1-i** | 0.22/0.37 | 23.2 cd/A | 594% |
| **Em3-i*** | 0.18/0.28 | 19.5 cd/A | 135% |
| **Em2-i** | 0.17/0.25 | 24.5 cd/A | 245% |
| **CEm2** | 0.20/0.35 | 10.3 cd/A | 100% |

| | | | |
|---|---|---|---|
| *Vergleichsbeispiel | | | |

### Beispiel 18:

### Vergleich verschiedener Isomere eines Emitters

Beispielhaft ist in zwei Fällen der Einfluss der verschiedenen Isomere auf die OLED-Leistung dargestellt. Für die verschiedenen Emitter und Isomere in dem oben beschriebenen OLED-Aufbau ergeben sich die folgenden elektrooptischen Daten:

| Emitter | CIE | Cd/A @ 300nits | t_{1/2} @ 1000nits (normiert auf den Wert von **Em1-s**) |
|---|---|---|---|
| **Em1-s** | 0.19/0.31 | 18.2 cd/A | 100% |
| **Em1-i** | 0.22/0.37 | 23.2 cd/A | 406% |

| Emitter | CIE | Cd/A @ 300nits | t_{1/2} @ 1000nits (normiert auf den Wert von **Em2-s**) |
|---|---|---|---|
| **Em2-s** | 0.21/0.35 | 15.4 cd/A | 100% |
| **Em2-i** | 0.17/0.25 | 24.5 cd/A | 178% |

### Beispiel 19:

### Einfluss einer gemischten Elektronenleiterschicht

Das folgende Beispiel zeigt den Einfluss der Dotierung der BCP Elektronenleiterschicht mit Liq.

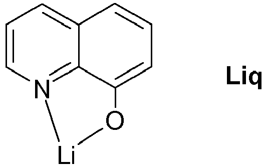

### Folgender OLED-Aufbau wird verwendet:

ITO - 40nm AJ20 - 1000 - 35nm Ir(DPBIC)₃ gemischt mit MoOₓ-10nm Ir(DPBIC)₃-40nm **Ma1** gemischt mit 20.wt% **Em1-i -** 5nm **Ma1** - 40 nm Elektronenleiter- 1 nm Liq - 100nm AI. Die Herstellung der OLED erfolgt analog zu Beispiel 17.

| Elektronenleiter | CIE | Cd/A @ 300nits | t_{1/2} @ 1000nits (normiert auf den Wert von BCP) |
|---|---|---|---|
| BCP | 0.22/0.36 | 16.8 cd/A | 100% |
| BCP:Liq 50% | 0.21/0.36 | 21.7 cd/A | 170% |

### Beispiel 20:

### Komplex Em9-s:

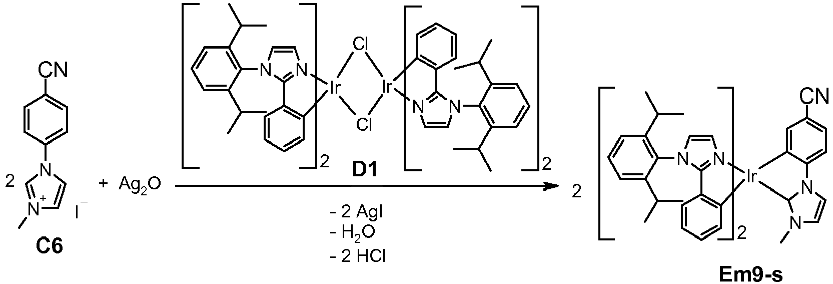

Imidazoliumiodid **C6** entspricht einer Vorstufe der Verbindung **"Beispiel** 1" aus WO 2006056418. Die Synthese erfolgt analog der Synthese der Verbindung **"Beispiel 1"** WO 2006056418.

2.0 g (6.4 mmol) Imidazoliumiodid **C6** und 0.75 g (3.2 mmol) Ag₂O werden in 170 ml wasserfreiem Acetonitril 4 h bei 50°C gerührt. Dann wird das Lösungsmittel im Vakuum entfernt. Man nimmt den Rückstand in 170 ml wasserfreiem Toluol auf und gibt 3.6 g (2.1 mmol) Chlorodimer **D1** hinzu. Im Anschluss wird 24 h zum Rückfluss erhitzt. Nach dem Abkühlen wird die Reaktionslösung filtriert. Das Filtrat wird im Vakuum vom Lösungsmittel befreit. Der Rückstand wird in Methylenchlorid aufgenommen, mit Wasser gewaschen, nach dem Trocknen eingeengt und per Chromatographie (Cyclohexan/Essigester) gereinigt, woraus 0.26 g **Em9-s** isoliert werden (6%) und 0.63 g einer Mischfraktion des Komplexes **Em9-s** mit nicht komplexiertem Phenylimidazol-Liganden sowie 0.10 mg eines weiteren Komplexes mit umgekehrter Liganden-Stöchiometrie. Des Weiteren werden 1.3 g Chlorodimer **D1** (36%) reisoliert.
¹H-NMR (CD₂Cl₂, 400 MHz):
δ= 0.83 (d, 3H), 0.89 - 0.96 (m, ggf. auswertbar als 4 x d, 12H), 1.00 (d, 3H), 1.13 (d , 3H), 1.15 (d, 3H), 1.98 (sept, 1H), 2.31 (sept, 1H), 2.70 (sept, 1H), 2.74 (sept, 1H), 3.21 (s, 3H), 6.10 (dd, 2H), 6.37 - 6.45 (m, 4H), 6.56-6.65 (m, 4H), 6.70 (dd, 1 H), 6.83 (m_{c}, 1H), 6.95 (d, 1H), 7.06 (m_{c}, 1H), 7.19 (m_{c}, 2H), 7.25 - 7.31 (m, 4H), 7.44-7.50 (m, 3H).
MS (Maldi):
m/e=979 (M+H)⁺
Photolumineszenz (im Film, 2% in PMMA):
λₘₐₓ = 456, 487 nm, CIE: (0.20;0.30)

### Beispiel 21:

### Komplex Em9-i:

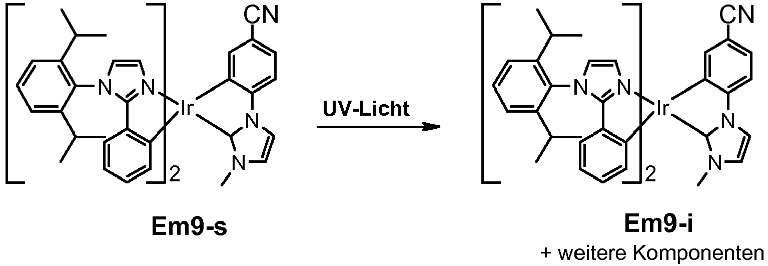

Eine Lösung von 0.17 g Komplex **Em9-s** in 2000 ml Acetonitril wird bei 15°C 9.5 h mit einer Blacklight-Blue-Lampe bestrahlt (Osram, L18W/73, λₘₐₓ = 370-380 nm). Das Lösungsmittel wird im Vakuum entfernt. Der Rückstand wird per Chromatographie (Cyclohexan/Essigester) gereinigt. Man erhält 0.055 g **Em9-i** (32%, verunreinigt mit Spuren eines weiteren Komplexes) sowie reisoliert 0.075 g reisoliertem **Em9-s** (44%).
¹H-NMR [CD₂Cl₂, 400 MHz, Probe enthält Spuren eines weiteren Komplexes, erkennbar z.B. an 0.77 (m), 0.83 (d), 1.04 (d), 1.21 (m), 1.92 (sept), 2.34 (sept), 7.20 - 7.23 (m), 7.31 - 7.34 (m)]:
δ= 0.65 (d, 3H), 0.77 (d, 3H), 0.85 (d , 3H), 0.97 (d, 3H), 0.98 (d, 3H), 1.02 (d, 3H), 1.13 (d, 6H), 1.82 (sept, 1H), 2.33 (sept, 1H), 2.54 (sept, 1H), 2.67 (sept, 1H), 3.04 (s, 3H), 6.09 (dd, 2H), 6.37 (td, 1 H), 6.40 - 6.44 (m, 3H), 6.50 (m, 1 H), 6.59 (d, 1 H), 6.61 (td, 1H), 6.68 (d, 1H), 6.70 (d, 1H), 6.72 (d, 1H), 6.86 (d, 1H), 6.96 (br.s, 1H), 7.14 (m_{c}, 2H), 7.20 - 7.23 (m, 1 H), 7.23 -7.31 (m, 3H), 7.44 - 7.50 (m, 3H).
MS (Maldi):
m/e=979 (M+H)⁺
Photolumineszenz (im Film, 2% in PMMA):
λₘₐₓ = 457, 485 nm, CIE: (0.17;0.26)

Die Photolumineszenz-Quantenausbeute des Isomers **Em9-i** hat den 1.14-fachen Wert der Quantenausbeute des Isomers **Em9-s.**

### Beispiel 22:

### Komplex Em10-s:

### 1,3-Diphenyl-4,5-di-o-tolyl-imidazolium-tetrafluoroborat C7

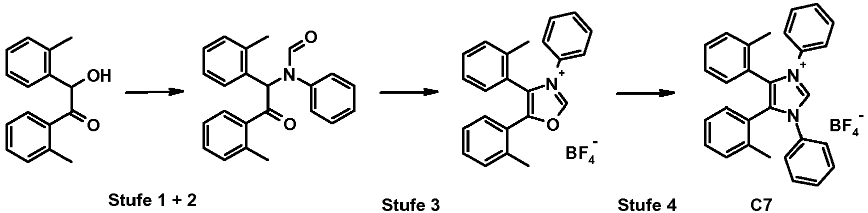

### Stufe 1: Herstellung von 2-Anilino-1,2-di-o-tolyl-ethanon

Eine Lösung von 18,00 g (74,91 mmol) o-Toluoin wird in 100 ml wasserfreiem Toluol gelöst und mit 21,00 g (224,9 mmol) Anilin und 0,2 g konz. HCl bei Raumtemperatur versetzt. Das Reaktionsgemisch wird 10 Stunden zum Sieden unter Rückfluss erhitzt, wobei das entstehende Wasser ausgekreist wird. Nach dem Abkühlen auf Raumtemperatur wird die Reaktionslösung mit 100 ml Essigester verdünnt und dann zweimal mit jeweils 70 ml 1 n HCl ausgeschüttelt. Anschließend wird die organische Phase mit 100 ml Wasser und 70 ml ges. Kochsalzlösung gewaschen, über Magnesiumsulfat getrocknet und bis zu einem gelben Harz eingeengt. Das Rohprodukt wird an Kieselgel mit Methylenchlorid als Laufmittel chromatographisch gereinigt. Nach Entfernen des Lösungsmittels werden 19,6 g (83 %) gelbes Öl erhalten.

### Stufe 2: Herstellung von N-(2-oxo-1,2-di-o-tolyl-ethyl)-N-phenyl-formamid

Eine Lösung von 19,50 g (58,7 mmol) 2-Anilino-1,2-di-o-tolyl-ethanon in 80 ml Tetrahydrofuran wird mit 7,80 g (88,1 mmol) Acetformylanhydrid versetzt und 17 Stunden bei Raumtemperatur gerührt. Die Reaktionslösung wird am Rotationsverdampfer bis zu einem Sirup eingeengt und an Kieselgel mit Petrolether-Essigester-Lösung zunächst im Verhältnis 10 : 1, dann 1 : 1 als Laufmittel gereinigt. Nach Entfernen des Lösungsmittels werden 18,4 g (91 %) fast farbloser Sirup erhalten.

### Stufe 3: Herstellung von 3-Phenyl-4,5-di-o-tolyl-oxazolium-tetrafluoroborat

Zu 9,80 g (55,9 mmol) 50 %ige Tetrafluorborsäure werden bei 5 - 10 °C innerhalb von 15 min 63 g Trifluoressigsäureanhydrid mit einer Spritze zudosiert (exotherm!). Die gekühlte Lösung wird anschließend zu einer Suspension von 20,00 g (55,3 mmol) N-(2-oxo-1,2-di-o-tolyl-ethyl)-N-phenyl-formamid in 60 g Trifluoressigsäureanhydrid bei Raumtemperatur innerhalb von 10 min getropft, wobei die Temperatur bis auf 28 °C stieg. Die Reaktionslösung wird 3 Stunden bei 20 - 25 °C gerührt und dann bis zu einem Öl am Rotationsverdampfer eingeengt. Nach der Zugabe von 100 ml Diethylether werden 9,7 g (55,3 mmol) 50 %ige Tetrafluorborsäure unter Rühren zugetropft, wobei ein Niederschlag gebildet wird. Nach einstündigem Rühren wird der Niederschlag abgesaugt, dreimal mit jeweils 10 ml Diethylether gewaschen und getrocknet. Es werden 22,55 g (99 %) farbloses Pulver erhalten.

### Stufe 4: Herstellung von 1,3-Diphenyl-4,5-di-o-tolyl-imidazolium-tetrafluoroborat C7

Zu einer Suspension von 3,50 g (8,47 mmol) 3-Phenyl-4,5-di-o-tolyl-oxazolium-tetrafluoroborat in 35 ml Ethanol werden 1,58 g (16,9 mmol) Anilin gegeben. Nach 45 min Rühren bei Raumtemperatur wird die Lösung zu einem orangefarbenen Harz eingeengt und anschließend mit 15 ml Schwefelsäure versetzt. Die Lösung wird 2 Stunden bei Raumtemperatur gerührt. Die Reaktionslösung wird in 300 ml Eiswasser eingerührt, wobei ein Niederschlag ausfiel. Die Suspension wird noch eine Stunde gerührt und dann über eine Nutsche filtriert. Der Rückstand wurde mit Wasser gewaschen und weitgehend trockengesaugt. Der Rückstand wird in einem Erlenmeyerkolben mit 40 ml Diethylether verrührt, abgesaugt und mit 10 ml Diethylether gewaschen. Das Verrühren in Diethylether mit anschließendem Absaugen wird noch zweimal wiederholt. Nach dem Trocknen werden 3,10 g (71 % d. Th.) farbloses Pulver erhalten.

### Komplex Em10-s:

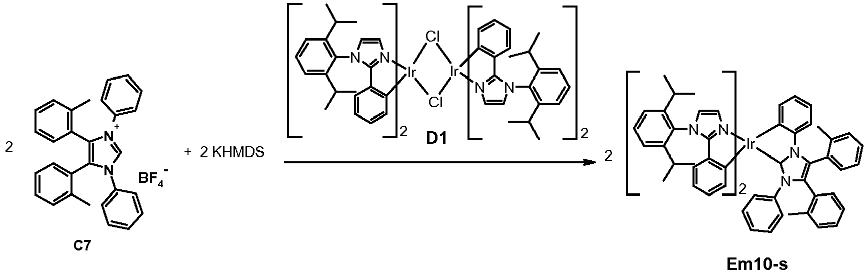

Eine Suspension von 1,61 g (3,30 mmol) 1,3-Diphenyl-4,5-di-o-tolyl-imidazolium-tetrafluoroborat in 25 ml Toluol wird unter Argon 15 min bei Raumtemperatur gerührt und dann auf 0 °C abgekühlt. 12,6 ml (6,29 mmol) 0,5 M Kalium-bis(trimethylsilyl)-amid in Toluol werden innerhalb von 1 min zudosiert. Die Reaktionslösung wird 15 min bei 0 - 12 °C gerührt und anschließend mit 2,50 g (1,50 mmol) Bis(iridium-µ-chloro-komplex) **D1** versetzt. Es wird mit 5 ml Toluol nachgespült. Die orangegelbe Suspension wird unter Rückfluss zum Sieden erhitzt. Nach 75 min wird die Reaktionslösung auf Raumtemperatur abgekühlt, mit 20 ml Essigester verdünnt und dann zweimal mit je 20 ml Phosphatpufferlösung (pH 7) ausgeschüttelt. Die organische Phase wird abgetrennt, über Magnesiumsulfat getrocknet und dann bis zur Trockne eingeengt. Der Feststoff wird in 150 ml Methanol kurz unter Rückfluss zum Sieden erhitzt. Nach Abkühlen der Suspension auf 50 °C wird der Feststoff abgesaugt, zweimal mit je 10 ml Methanol gewaschen und getrocknet. Es werden 2,52 g gelblicher Feststoff erhalten. Das Filtrat wird auf 40 ml eingeengt und über Nacht bei Raumtemperatur gerührt. Der Niederschlag wird abgesaugt, mit wenig Methanol gewaschen und getrocknet. Es werden 0,28 g gelblicher Feststoff erhalten, der mit dem Rückstand vereinigt wird. Es werden also insgesamt 2,80 g (78 % d. Th.) gelblicher Feststoff erhalten, der bei 282 - 283 °C schmilzt.
MS (Maldi):
m/e= 1197.4 (M+H)⁺
Photolumineszenz (im Film, 2 % in PMMA):
λₘₐₓ = 464, 493 nm, CIE: (0.19; 0.35)

### Beispiel 23:

### Komplexe Em10-i und Em10-i*:

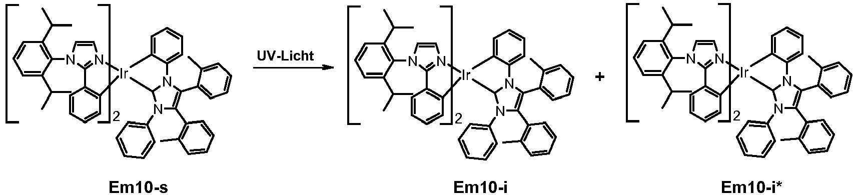

0,50 g (0,42 mmol) **Em10-s** werden in 300 ml Acetonitril gelöst und mit einer Quecksilbermitteldruck-Tauchlampe TQ 150 (365 nm, 150 W) 5,5 Stunden bestrahlt. Die Lösung wird vom Lösungsmittel befreit. Der Rückstand wird in 30 ml Methanol in der Hitze gelöst. Nach dem Abkühlen wird der Niederschlag abgesaugt, mit Methanol gewaschen und getrocknet. Das Komplexisomer **Em10-i** [0,19 g (38 %)] wird als gelbes Pulver erhalten, das bei 316 - 317 °C schmilzt.
MS (Maldi):
m/e = 1196.7 (M)⁺
Photolumineszenz (im Film, 2 % in PMMA):
λₘₐₓ = 460, 491 nm, CIE: (0.18; 0.32)

Das Filtrat wird zur Trockne eingeengt, mit 10 ml n-Pentan verrührt, abgesaugt, mit Pentan gewaschen und getrocknet. Das Komplexisomer **Em10-i*** [0,16 g (32 %)] wird als ockergelber Feststoff erhalten, der bei 207 - 209 °C schmilzt.
MS (Maldi):
m/e = 1197.8 (M+H)⁺
Photolumineszenz (im Film, 2 % in PMMA):
λₘₐₓ = 458, 490 nm, CIE: (0.19; 0.33)

### Beispiel 24 - Einfluss der Matrixmaterialien auf Em1-s:

### Diodenaufbau:

ITO - PEDT:PSS - 35nm Ir(DPBIC)₃ gemischt mit 10 Gew.-% MoOₓ- 10nm Ir(DPBIC)₃ - 40nm **Matrix "MaX"** gemischt mit 15 Gew.-% **Em1-s -** 10nm **LB1 -** 20 nm Elektronenleiter BCP - 0.70 nm LiF - 100nm Al. Die Herstellung der Diode erfolgt analog zu Beispiel 17.

### Excitonen- und Lochblocker LB1:

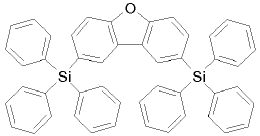

| Matrix **"MaX"** | CIE | Spannung | Cd/A | EQE |
|---|---|---|---|---|
| | | @ 300nits und normiert auf den Wert von **Ma2** | | |
| **Ma2¹** | 0.20/0.36 | 100% | 100% | 100% |
| **Ma3** | 0.20/0.32 | 63% | 203% | 166% |
| **Ma4²** | 0.19/0.32 | 74% | 161% | 134% |
| **Ma5** | 0.20/0.31 | 70% | 137% | 115% |
| **Ma6³** | 0.19/0.30 | 70% | 226% | 195% |

| | | | | |
|---|---|---|---|---|
| ¹ In diesem Fall wurden 40 nm BCP als Elektronenleiter verwendet. ² In diesem Fall wurden 30 nm BCP als Elektronenleiter verwendet. ³ In diesem Fall wurde als Lochinjektionsschicht AJ20 - 1000 der Firma Plexcore statt PEDT:PSS verwendet. | | | | |

### Strukturen der Matrices "MaX" (= Ma2 - Ma6) und Beschreibung von deren Synthese in WO2010/079051:

| Matrix **"MaX"** | Synthese beschrieben in WO2010/079051 als | Struktur |
|---|---|---|
| **Ma2** | BS 10 | 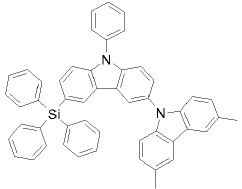 |
| **Ma3** | BS15 | 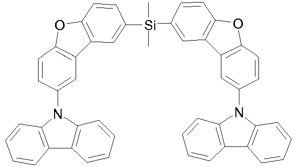 |
| **Ma4** | BS18 | 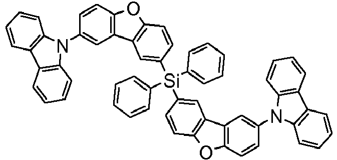 |
| **Ma5** | BS20 | 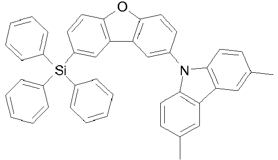 |
| **Ma6** | BS 31 | 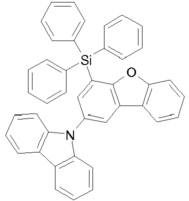 |

### Beispiel 25 - Einfluss der Matrixmaterialien auf Em1-i:

**Aufbau A:** ITO - AJ20 - 1000 - 35nm Ir(DPBIC)₃ gemischt mit 50 Gew.-% MoO₃ - 10nm Ir(DPBIC)₃ - 40nm **"MaY"** gemischt mit 20 Gew.-% **Em1-i -** 5nm **"MaY" -** 40 nm Elektronenleiter BCP : Liq 50 Gew.-% - 1 nm Liq - 100nm Al. Die Herstellung der Diode erfolgt analog zu Beispiel 17.
**Aufbau B:** ITO - AJ20 - 1000 - 35nm Ir(DPBIC)₃ gemischt mit 10 Gew.-% MoO₃ - 10nm Ir(DPBIC)₃ - 40nm **"MaY"** gemischt mit 15 Gew.-% **Em1-i -** 10nm **LB1 -** 20 nm Elektronenleiter BCP - 0.70 nm LiF - 100nm Al. Die Herstellung der Diode erfolgt analog zu Beispiel 17.

| Matrix **"MaY"** | Diodenaufbau | CIE | Spannung | Cd/A | EQE |
|---|---|---|---|---|---|
| | | | @ 300 nits und normiert auf den Wert von **Ma7** | | |
| **Ma7** | **Aufbau A** | 0.22/0.36 | 100% | 100% | 100% |
| **Ma8** | **Aufbau B** | 0.23/0.38 | 120% | 92% | 91% |
| **Ma9** | **Aufbau A¹** | 0.23/0.38 | 74% | 95% | 95% |

| | | | | | |
|---|---|---|---|---|---|
| ¹ In diesem Fall wurden 5 nm **Ma1** als Excitonen- und Lochblocker verwendet. | | | | | |

### Strukturen der Matrices "MaY" (= Ma7 - Ma9) und Beschreibung deren Synthese in WO2010/079051:

| Matrix **"MaY"** | Verbindung in WO2010/079051 | Struktur |
|---|---|---|
| **Ma7** | BS26 | 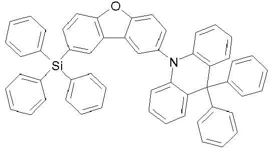 |
| **Ma8** | BS29 | 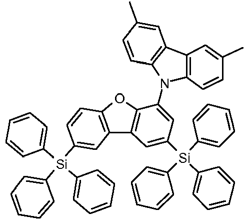 |
| **Ma9** | BS28 | 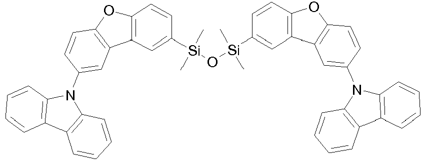 |

### Beispiel 26 - Einfluss des Matrixmaterials auf Em1-i:

ITO - AJ20 - 1000 - 10 nm **Ma1** gemischt mit 10 Gew.-% MoOₓ - 10 nm **Ma10** gemischt mit 15 Gew.-% **Em1-i** und 15 Gew.-% **Ma1** - 5 nm **Ma1** - 20 nm Elektronenleiter BCP gemischt mit 20 Gew.-% **Ma1** - 1 nm Cs₂CO₃ - 100 nm Al. Die Herstellung der Diode erfolgt analog zu Beispiel 17.

Die Synthese von Matrixmaterial **Ma10** wird in JP2009046408, Verbindung B, [0039], S.13 beschrieben.

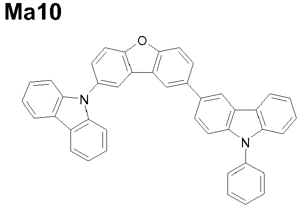

Es wird eine leuchtende Diode mit den folgenden CIE Werten erhalten: 0.19; 0.35 (Spannung in V @ 300nits: 3,8).

## Patentansprüche

1. Heteroleptische Komplexe der allgemeinen Formel (I) 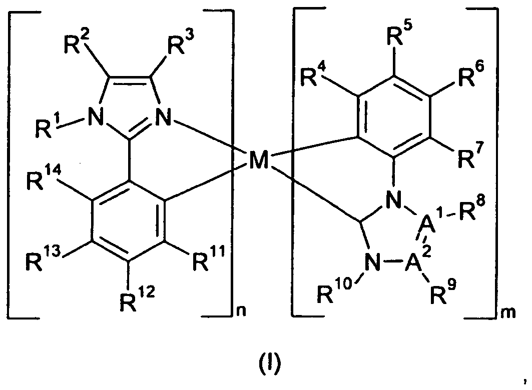 worin M, A¹, A² n, m, R¹, R², R³, R⁴, R⁵, R⁶, R⁷, R⁸, R⁹, R¹⁰, R¹¹, R¹², R¹³ und R¹⁴ die folgenden Bedeutungen aufweisen:
M Ir,
A¹, A² C,
n, m unabhängig voneinander 1 oder 2, wobei die Summe von n und m 3 beträgt,
R¹ linearer oder verzweigter Alkylrest mit 1 bis 20 Kohlenstoffatomen, substituierter oder unsubstituierter Arylrest mit 6 bis 30 Kohlenstoffatomen, substituierter oder unsubstituierter Heteroarylrest mit 5 bis 18 Kohlenstoff- und/oder Heteroatomen,
R², R³ unabhängig voneinander Wasserstoff, linearer oder verzweigter Alkylrest mit 1 bis 20 Kohlenstoffatomen, substituierter oder unsubstituierter Arylrest mit 6 bis 30 Kohlenstoffatomen, substituierter oder unsubstituierter Heteroarylrest mit 5 bis 18 Kohlenstoff- und/oder Heteroatomen,
R⁴, R⁵, R⁶, R⁷ Wasserstoff
und
R⁴ und R⁵ oder R⁵ und R⁶ oder R⁶ und R⁷ bilden zusammen einen Cyclus der allgemeinen Formel **(IIa)** oder **(IIb)** 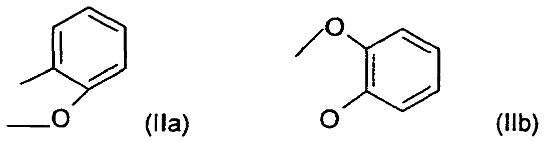
R⁸, R⁹ Wasserstoff,
R¹⁰ linearer oder verzweigter Alkylrest mit 1 bis 20 Kohlenstoffatomen, substituierter oder unsubstituierter Arylrest mit 6 bis 30 Kohlenstoffatomen, und
R¹¹, R¹², R¹³, R¹⁴ unabhängig voneinander Wasserstoff oder linearer oder verzweigter Alkylrest mit 1 bis 20 Kohlenstoffatomen,
und/oder
R¹ und R¹⁴ bilden zusammen eine gesättigte oder ungesättigte, lineare oder verzweigte, gegebenenfalls Heteroatome, aromatische Einheiten, heteroaromatische Einheiten und/oder funktionelle Gruppen enthaltende Verbrückung mit insgesamt 1 bis 30 Kohlenstoff- und/oder Heteroatomen, an die gegebenenfalls ein substituierter oder unsubstituierter, fünf- bis achtgliedriger, Kohlenstoff- und/oder Heteroatome enthaltender Ring, bevorzugt ein sechsgliedriger aromatischer Ring, annelliert ist,
und/oder
R⁷ und R⁸ bilden zusammen eine gesättigte oder ungesättigte, lineare oder verzweigte, gegebenenfalls Heteroatome, aromatische Einheiten, heteroaromatische Einheiten und/oder funktionelle Gruppen enthaltende Verbrückung mit insgesamt 1 bis 30 Kohlenstoff- und/oder Heteroatomen, an die gegebenenfalls ein substituierter oder unsubstituierter, fünf- bis achtgliedriger, Kohlenstoff- und/oder Heteroatome enthaltender Ring, bevorzugt ein sechsgliedriger aromatischer Ring, anelliert ist.

2. Heteroleptische Komplexe der allgemeinen Formel (I) 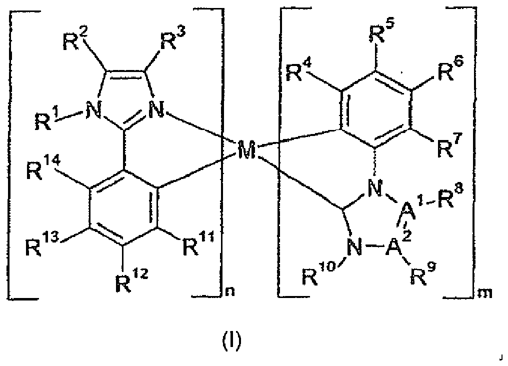 worin M, A¹, A², n, m, R¹, R², R³, R⁴, R⁵, R⁶, R⁷, R⁸, R⁹, R¹⁰, R¹¹, R¹², R¹³ und R¹⁴ die folgenden Bedeutungen aufweisen:
M Ir,
A¹ = N, und A² = C,
n, m unabhängig voneinander 1 oder 2, wobei die Summe von n und m 3 beträgt,
R¹ linearer oder verzweigter Alkylrest mit 1 bis 20 Kohlenstoffatomen, substituierter oder unsubstituierter Arylrest mit 6 bis 30 Kohlenstoffatomen, substituierter oder unsubstituierter Heteroarylrest mit 5 bis 18 Kohlenstoff- und/oder Heteroatomen,
R², R³ unabhängig voneinander Wasserstoff, linearer oder verzweigter Alkylrest mit 1 bis 20 Kohlenstoffatomen, substituierter oder unsubstituierter Arylrest mit 6 bis 30 Kohlenstoffatomen, substituierter oder unsubstituierter Heteroarylrest mit 5 bis 18 Kohlenstoff- und/oder Heteroatomen,
R⁴, R⁵, R⁶, R⁷ Wasserstoff
oder
R⁴ und R⁵ oder R⁵ und R⁶ oder R⁶ und R⁷ bilden zusammen einen gegebenenfalls von wenigstens einem Heteroatom unterbrochenen gesättigten, ungesättigten oder aromatischen Ring mit insgesamt 5 bis 30 Kohlenstoff- und/oder Heteroatomen,
R8: freies Elektronenpaar,
R9: Wasserstoff, linearer oder verzweigter Alkylrest mit 1 bis 20 Kohlenstoffatomen, substituierter oder unsubstituierter Arylrest mit 6 bis 30 Kohlenstoffatomen, substituierter oder unsubstituierter Heteroarylrest mit 5 bis 18 Kohlenstoff- und/oder Heteroatomen,
R¹⁰ linearer oder verzweigter Alkylrest mit 1 bis 20 Kohlenstoffatomen, substituierter oder unsubstituierter Arylrest mit 6 bis 30 Kohlenstoffatomen, und
R¹¹, R¹², R¹³, R¹⁴ Wasserstoff oder linearer oder verzweigter Alkylrest mit 1-20 Kohlenstoffatomen
und/oder
R¹ und R¹⁴ bilden zusammen eine gesättigte oder ungesättigte, lineare oder verzweigte, gegebenenfalls Heteroatome, aromatische Einheiten, heteroaromatische Einheiten und/oder funktionelle Gruppen enthaltende Verbrückung mit insgesamt 1 bis 30 Kohlenstoff- und/oder Heteroatomen, an die gegebenenfalls ein substituierter oder unsubstituierter, fünf- bis achtgliedriger, Kohlenstoff- und/oder Heteroatome enthaltender Ring, bevorzugt ein sechsgliedriger aromatischer Ring, annelliert ist.

3. Heteroleptischer Komplex nach Anspruch 1 oder 2, **dadurch gekennzeichnet, dass** R¹ ein Arylrest mit 6 bis 30 Kohlenstoffatomen ist, der in ortho,ortho'-Position jeweils mit einem linearen oder Verzweigten Alkylrest mit 1 bis 10 Kohlenstoffatomen substituiert ist.

4. Heteroleptischer Komplex nach einem der Ansprüche 1 bis 3, **dadurch gekennzeichnet, dass** R¹ und R¹⁴ zusammen eine gesättigte oder ungesättigte, lineare oder verzweigte, gegebenenfalls Heteroatome, aromatische Einheiten, heteroaromatische Einheiten und/oder funktionelle Gruppen enthaltende Verbrückung mit insgesamt 1 bis 30 Kohlenstoff- und/oder Heteroatomen, an die gegebenenfalls ein substituierter oder unsubstituierter, fünf- bis achtgliedriger, Kohlenstoff-und/oder Heteroatome enthaltender Ring, bevorzugt ein sechsgliedriger aromatischer Ring, annelliert ist, bilden.

5. Heteroleptischer Komplex nach Anspruch 2 oder 3, **dadurch gekennzeichnet, dass** R⁴ und R⁵, R⁵ und R⁶ oder R⁶ und R⁷ zusammen einen Cyclus der allgemeinen Formel (IIa) oder (IIb) bilden

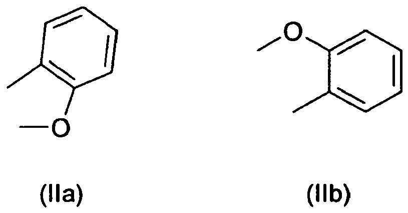

6. Heteroleptischer Komplex nach einem der Ansprüche 1 bis 5 mit den genannten Bedeutungen für M, A¹, A², n, m, R¹, R², R³, R⁴, R⁵, R⁶, R⁷, R⁸, R⁹, R¹⁰, R¹¹, R¹², R¹³ und R¹⁴, **dadurch gekennzeichnet, dass** er eine der folgenden Konfigurationen IIIa, IIIb, IVa oder IVb aufweist: 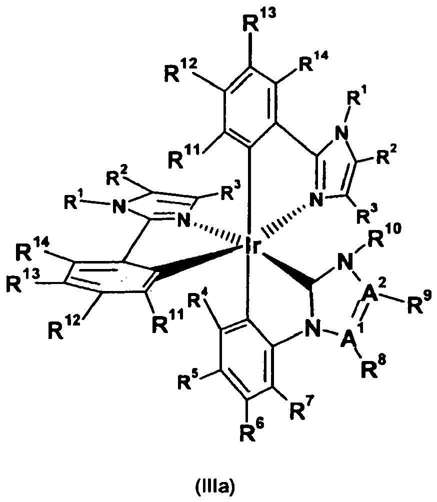 oder 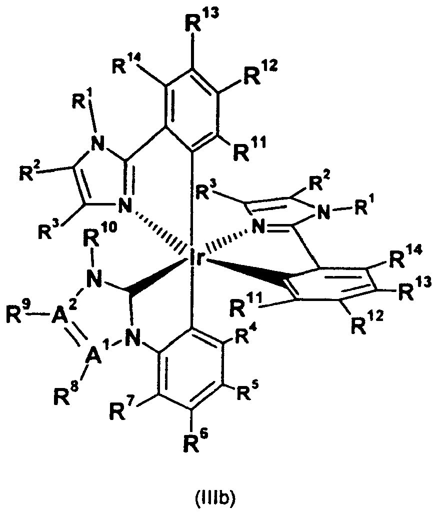 oder 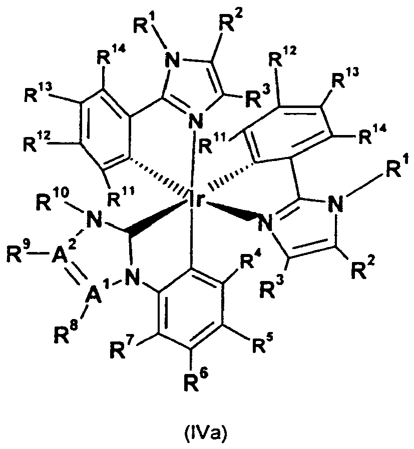 oder

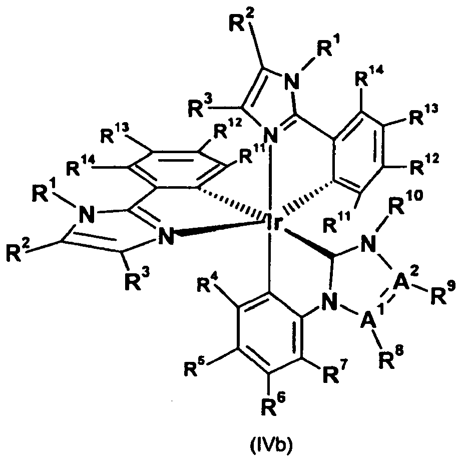

7. Verfahren zur Herstellung eines heteroleptischen Komplexes gemäß einem der Ansprüche 1 bis 6 durch
Inkontaktbringen wenigstens einer Vorläuferverbindung, enthaltend das Metall M und den wenigstens einen Liganden, der in den Komplexen der allgemeinen Formel (I) über Nichtcarbenbindungen an M angebunden ist, mit wenigstens einem Liganden, der in den Komplexen der allgemeinen Formel (I) über wenigstens eine Carbenbindung an M angebunden ist, bzw. dessen Ligandvorläufer wie z. B. einem entsprechenden Imidazoliumsalz,
oder
durch Inkontaktbringen wenigstens einer Vorläuferverbindung, enthaltend das Metall M sowie einen Liganden, der in den Komplexen der allgemeinen Formel (I) über wenigstens eine Carbenbindung an M gebunden ist, mit wenigstens einem Liganden, der in den Komplexen der allgemeinen Formel (I) über Nichtcarbenbindungen an M angebunden ist.

8. OLED, enthaltend wenigstens einen heteroleptischen Komplex nach einem der Ansprüche 1 bis 6.

9. OLED enthaltend einen heteroleptischen Komplex nach einem der Ansprüche 1 bis 6, sowie mindestens eine Verbindung der Formel (X) 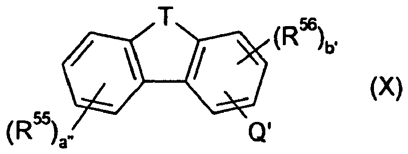 worin bedeuten
T NR⁵⁷, S, O oder PR⁵⁷, bevorzugt S oder O, besonders bevorzugt O;
R⁵⁷ Aryl, Heteroaryl, Alkyl, Cycloalkyl oder Heterocycloalkyl;
Q' -NR⁵⁸R⁵⁹, -P(O)R⁶⁰R⁶¹, -PR⁶²R⁶³, -S(O)₂⁶⁴, -S(O)R⁶⁵, -SR⁶⁶ oder -OR⁶⁷, bevorzugt -NR⁵⁸R⁵⁹; besonders bevorzugt 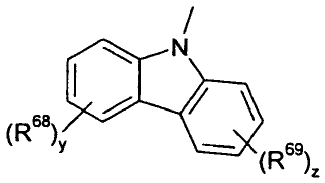 worin bedeuten
R⁶⁸, R⁶⁹ unabhängig voneinander Alkyl, Cycloalkyl, Heterocycloalkyl, Aryl oder Heteroaryl; bevorzugt Methyl, Carbazolyl, Dibenzofuryl oder Dibenzothienyl;
y, z unabhängig voneinander 0, 1, 2, 3 oder 4, bevorzugt 0 oder 1;
R⁵⁵, R⁵⁶ unabhängig voneinander Alkyl, Cycloalkyl, Heterocycloalkyl, Aryl, Heteroaryl, SiR⁷⁰R⁷¹R⁷², eine Gruppe Q' oder eine Gruppe mit Donor- oder Akzeptorwirkung;
a" 0, 1, 2, 3 oder 4;
b' 0, 1, 2 oder 3;
R⁵⁸, R⁵⁹ bilden gemeinsam mit dem N-Atom einen cyclischen Rest mit 3 bis 10 Ringatomen, der unsubstituiert oder mit einem oder mehreren Substituenten ausgewählt aus Alkyl, Cycloalkyl, Heterocycloalkyl, Aryl, Heteroaryl und einer Gruppe mit Donor-oder Akzeptorwirkung substituiert sein kann und/oder mit einem oder mehreren weiteren cyclischen Resten mit 3 bis 10 Ringatomen anelliert sein kann, wobei die anellierten Reste unsubstituiert oder mit einem oder mehreren Substituenten ausgewählt aus Alkyl, Cycloalkyl, Heterocycloalkyl, Aryl, Heteroaryl, und einer Gruppe mit Donor- oder Akzeptorwirkung substituiert sein können;
R⁷⁰ R⁷¹ R⁷², R⁶⁰, R⁶¹, R⁶², R⁶³, R⁶⁴, R⁶⁵, R⁶⁶, R⁶⁷ unabhängig voneinander Aryl, Heteroaryl, Alkyl, Cycloalkyl oder Heterocycloalkyl,
oder
zwei Einheiten der allgemeinen Formel (X) sind über eine lineare oder verzweigte, gesättigte oder ungesättigte, gegebenenfalls durch wenigstens ein Heteroatom unterbrochene Verbrückung, über eine Bindung oder über O miteinander verbrückt.

10. OLED nach Anspruch 9 enthaltend mindestens eine Verbindung der Formel (XI) oder (XI*) 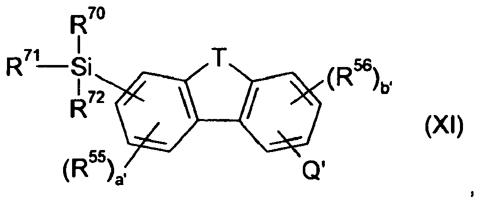 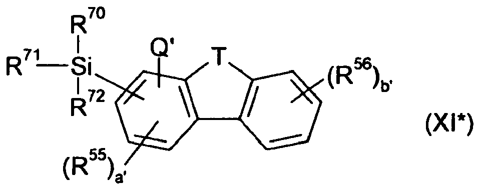 worin bedeuten
T NR⁵⁷, S O oder PR⁵⁷;
R⁵⁷ Aryl, Heteroaryl, Alkyl, Cycloalkyl oder Heterocycloalkyl;
Q' -NR⁵⁸R⁵⁹, -P(O)R⁶⁰R⁶¹, -PR⁶²R⁶³, -S(O)₂R⁶⁴, -S(O)R⁶⁵, -SR⁶⁶ oder -OR⁶⁷;
R⁷⁰, R⁷¹, R⁷² unabhängig voneinander Aryl, Heteroaryl, Alkyl, Cycloalkyl, Heterocycloalkyl, wobei wenigstens einer der Reste R⁷⁰, R⁷¹, R⁷² mindestens zwei Kohlenstoffatome enthält oder OR⁷³,
R⁵⁵, R⁵⁶ unabhängig voneinander Alkyl, Cycloalkyl, Heterocycloalkyl, Aryl, Heteroaryl, eine Gruppe Q oder eine Gruppe mit Donor-oder Akzeptorwirkung;
a', b' für die Verbindung der Formel (XI): unabhängig voneinander 0, 1, 2, 3; für die Verbindung der Formel (XI*) bedeuten a' 0, 1, 2 und b' 0, 1, 2, 3, 4;
R⁵⁸, R⁵⁹ bilden gemeinsam mit dem N-Atom einen cyclischen Rest mit 3 bis 10 Ringatomen, der unsubstituiert oder mit einem oder mehreren Substituenten ausgewählt aus Alkyl, Cycloalkyl, Heterocycloalkyl, Aryl, Heteroaryl und einer Gruppe mit Donor-oder Akzeptorwirkung substituiert sein kann und/oder mit einem oder mehreren weiteren cyclischen Resten mit 3 bis 10 Ringatomen anelliert sein kann, wobei die anellierten Reste unsubstituiert oder mit einem oder mehreren Substituenten ausgewählt aus Alkyl, Cycloalkyl, Heterocycloalkyl, Aryl, Heteroaryl, und einer Gruppe mit Donor- oder Akzeptorwirkung substituiert sein können;
R⁷³ unabhängig voneinander SiR⁷⁴R⁷⁵R⁷⁶, Aryl, Heteroaryl, Alkyl, Cycloalkyl oder Heterocycloalkyl, gegebenenfalls substituiert mit einer Gruppe OR⁷⁷
R⁷⁷ unabhängig voneinander SiR⁷⁴R⁷⁵R⁷⁶, Aryl, Heteroaryl, Alkyl, Cycloalkyl oder Heterocycloalkyl,
R⁶⁰, R⁶¹, R⁶², R⁶³, R⁶⁴, R⁶⁵, R⁶⁶, R⁶⁷, R⁷⁴, R⁷⁵, R⁷⁶ unabhängig voneinander Aryl, Heteroaryl, Alkyl, Cycloalkyl oder Heterocycloalkyl,
oder
zwei Einheiten der allgemeinen Formeln (XI) und/oder (XI*) sind über eine lineare oder verzweigte, gesättigte oder ungesättigte, gegebenenfalls durch wenigstens ein Heteroatom unterbrochene Verbrückung oder über O miteinander verbrückt, wobei diese Verbrückung in den allgemeinen Formeln (XI) und/oder (XI*) jeweils anstelle von R⁷¹ an die Si-Atome angebunden ist.

11. OLED nach Anspruch 10, **dadurch gekennzeichnet, dass** in den Verbindungen der allgemeinen Formeln (XI) oder (XI*) R⁷⁰ und/oder R⁷¹ und/oder R⁷² aromatische Einheiten der allgemeinen Formeln (XIi) und/oder (XIi*) bedeuten 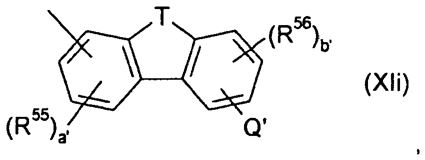 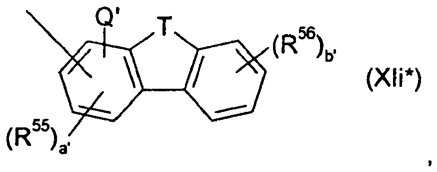 wobei R⁵⁵, R⁵⁶, Q', T, a' und b' die gleichen Bedeutungen wie in Anspruch 12 haben.

12. Licht-emittierende Schicht, enthaltend wenigstens einen heteroleptischen Komplex nach einem der Ansprüche 1 bis 6.

13. OLED, enthaltend einen Licht-emittierende Schicht nach Anspruch 12.

14. OLED nach einem der Ansprüche 8 bis 11 oder 13, **dadurch gekennzeichnet, dass** sie eine Elektronen-transportierende Schicht enthaltend mindestens zwei verschiedene Materialien, wovon mindestens ein Material elektronenleitend ist, enthält.

15. OLED nach Anspruch 14, **dadurch gekennzeichnet, dass** die Elektronen-transportierende Schicht mindestens ein Phenanthrolin-Derivat enthält.

16. OLED nach Anspruch 15, **dadurch gekennzeichnet, dass** die Elektronen-transportierende Schicht mindestens ein Phenanthrolin-Derivat und mindestens einen Alkalimetall-Hydroxychinolat-Komplex enthält.

17. Vorrichtung ausgewählt aus der Gruppe bestehend aus Beleuchtungselementen, stationären Bildschirmen und mobilen Bildschirmen, enthaltend wenigstens eine OLED gemäß einem der Ansprüche 8 bis 11 oder 13 bis 16.

18. Verwendung eines heteroleptischen Komplexes nach einem der Ansprüche 1 bis 6 in OLEDs.

19. Verwendung nach Anspruch 18, **dadurch gekennzeichnet, dass** die heteroleptischen Komplexe als Emitter, Matrixmaterial, Ladungstransportmaterial und/oder Ladungsblocker eingesetzt werden.

## Claims

1. A heteroleptic complex of the general formula (I) 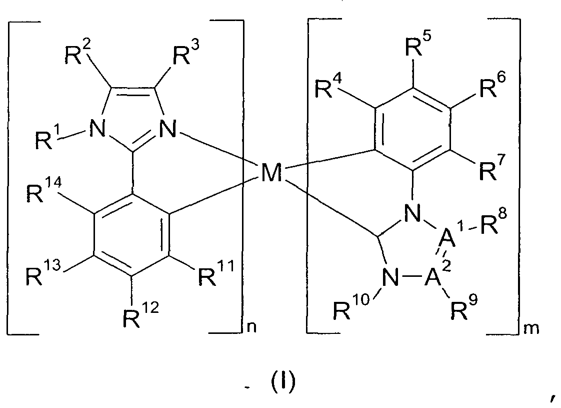 in which M, A¹, A², n, m, R¹, R², R³, R⁴, R⁵, R⁶, R⁷, R⁸, R⁹, R¹⁰, R¹¹, R¹², R¹³ and R¹⁴ are each defined as follows:
M is Ir,
A¹, A² is C,
n, m are each independently 1 or 2, where the sum of n and m is 3,
R¹ is a linear or branched alkyl radical having 1 to 20 carbon atoms, substituted or unsubstituted aryl radical having 6 to 30 carbon atoms, substituted or unsubstituted heteroaryl radical having 5 to 18 carbon atoms and/or heteroatoms,
R², R³ are each independently hydrogen, linear or branched alkyl radical having 1 to 20 carbon atoms, substituted or unsubstituted aryl.radical having 6 to 30 carbon atoms, substituted or unsubstituted heteroaryl radical having 5 to 18 carbon atoms and/or heteroatoms,
R⁴, R⁵, R⁶, R⁷ are each hydrogen
and
R⁴ and R⁵ or R⁵ and R⁶ or R⁶ and R⁷ together form a cycle of the general formula (IIa) or (IIb) 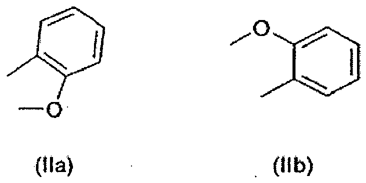
R⁸, R⁹ are each hydrogen,
R¹⁰ is a linear or branched alkyl radical having 1 to 20 carbon atoms, substituted or unsubstituted aryl radical having 6 to 30 carbon atoms, and
R¹¹, R¹², R¹³, R¹⁴ are each independently hydrogen or linear or branched alkyl radical having 1 to 20 carbon atoms,
and/or
R¹ and R¹⁴ together form a saturated or unsaturated, linear or branched bridge optionally comprising heteroatoms, aromatic units, heteroaromatic units and/or functional groups and having a total of 1 to 30 carbon atoms and/or heteroatoms, to which a substituted or unsubstituted, five- to eight-membered ring comprising carbon atoms and/or heteroatoms, preferably a six-membered aromatic ring, is optionally fused,
and/or
R⁷ and R⁸ together form a saturated or unsaturated, linear or branched bridge optionally comprising heteroatoms, aromatic units, heteroaromatic units and/or functional groups and having a total of 1 to 30 carbon atoms and/or heteroatoms, to which a substituted or unsubstituted, five- to eight-membered ring comprising carbon atoms and/or heteroatoms, preferably a six-membered aromatic ring, is optionally fused.

2. A heteroleptic complex of the general formula (I) 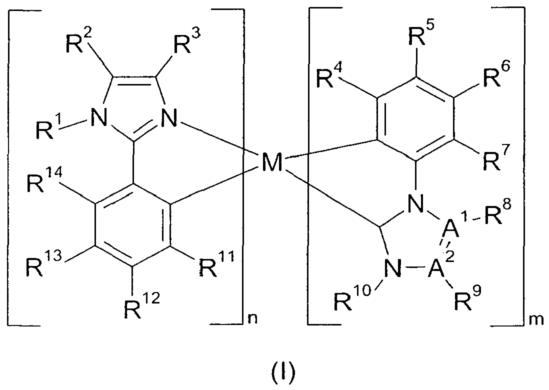 in which M, A¹, A², n, m, R¹, R², R³, R⁴, R⁵, R⁶, R⁷, R⁸, R⁹, R¹⁰, R¹¹, R¹², R¹³ and R¹⁴ are each defined as follows:
M is Ir,
A¹ = N, and A² = C,
n, m are each independently 1 or 2, where the sum of n and m is 3,
R¹ is a linear or branched alkyl radical having 1 to 20 carbon atoms, substituted or unsubstituted aryl radical having 6 to 30 carbon atoms, substituted or unsubstituted heteroaryl radical having 5 to 18 carbon atoms and/or heteroatoms,
R², R³ are each independently hydrogen, linear or branched alkyl radical having 1 to 20 carbon atoms, substituted or unsubstituted aryl radical having 6 to 30 carbon atoms, substituted or unsubstituted heteroaryl radical having 5 to 18 carbon atoms and/or heteroatoms,
R⁴, R⁵ R⁶, R⁷ are each hydrogen
or
R⁴ and R⁵ or R⁵ and R⁶ or R⁶ and R⁷ together form a saturated, unsaturated or aromatic ring optionally interrupted by at least one heteroatom and having a total of 5 to 30 carbon atoms and/or heteroatoms,
R⁸ is a free electron pair,
R⁹ is hydrogen, linear or branched alkyl radical having 1 to 20 carbon atoms, substituted or unsubstituted aryl radical having 6 to 30 carbon atoms, substituted or unsubstituted heteroaryl radical having 5 to 18 carbon atoms and/or heteroatoms,
R¹⁰ linear or branched alkyl radical having 1 to 20 carbon atoms, substituted or unsubstituted aryl radical having 6 to 30 carbon atoms, and
R¹¹, R¹² R¹³, R¹⁴ hydrogen or linear or branched alkyl radical having 1-20 carbon atoms
and/or
R¹ and R¹⁴ together form a saturated or unsaturated, linear or branched bridge optionally comprising heteroatoms, aromatic units, heteroaromatic units and/or functional groups and having a total of 1 to 30 carbon atoms and/or heteroatoms, to which a substituted or unsubstituted, five- to eight-membered ring comprising carbon atoms and/or heteroatoms, preferably a six-membered aromatic ring, is optionally fused.

3. A heteroleptic complex according to claim 1 or 2, wherein R¹ is an aryl radical which has 6 to 30 carbon atoms and is substituted in the ortho,ortho' positions in each case by a linear or branched alkyl radical having 1 to 10 carbon atoms.

4. A heteroleptic complex according to any of claims 1 to 3, wherein R¹ and R¹⁴ together form a saturated or unsaturated, linear or branched bridge optionally comprising heteroatoms, aromatic units, heteroaromatic units and/or functional groups and having a total of 1 to 30 carbon atoms and/or heteroatoms, to which a substituted or unsubstituted, five- to eight-membered ring comprising carbon atoms and/or heteroatoms, preferably a six-membered aromatic ring, is optionally fused.

5. A heteroleptic complex according to claim 2 or 3, wherein R⁴ and R⁵, R⁵ and R⁶ or R⁶ and R⁷ together form a cycle of the general formula (IIa) or (IIb)

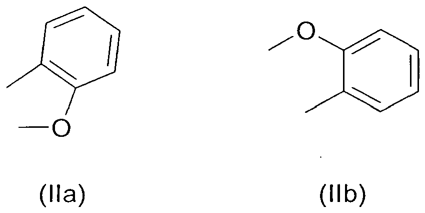

6. A heteroleptic complex according to any of claims 1 to 5 with the specified definitions of M, A¹, A², n, m, R¹, R², R³, R⁴, R⁵, R⁶, R⁷, R⁸, R⁹, R¹⁰, R¹¹, R¹², R¹³ and R¹⁴, which has one of the following configurations IIIa, IIIb, IVa or IVb: 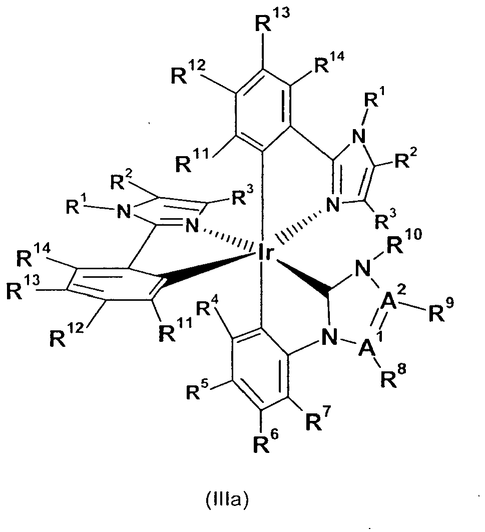 or 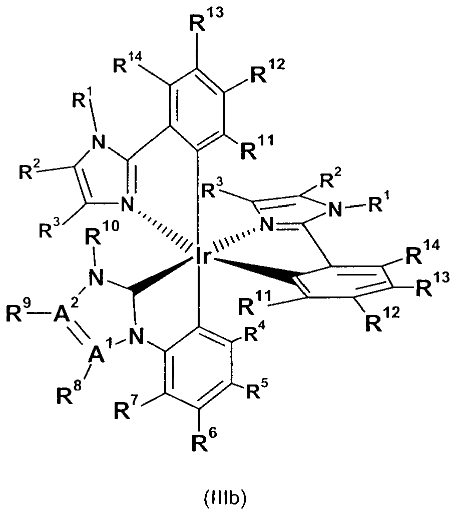 or 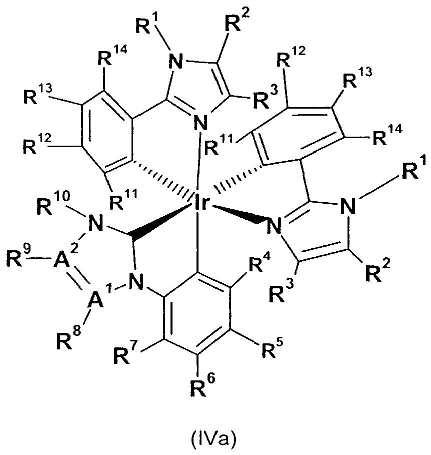 or

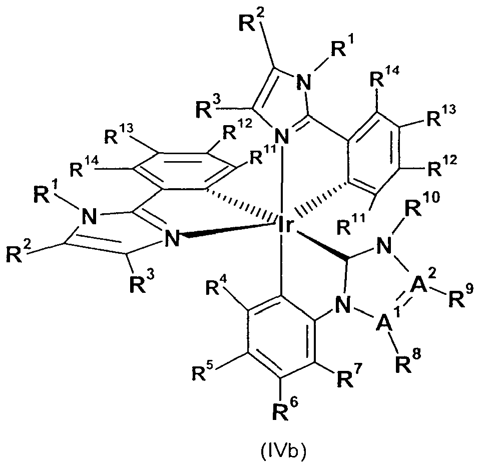

7. A process for preparing a heteroleptic complex according to any of claims 1 to 6 by
contacting at least one precursor compound comprising the metal M and the at least one ligand which, in the complexes of the general formula (I), is attached to M via noncarbene bonds with at least one ligand which, in the complexes of the general formula (I), is attached to M via at least one carbene bond, or the ligand precursor thereof, for example a corresponding imidazolium salt,
or
by contacting at least one precursor compound comprising the metal M and a ligand which, in the complexes of the general formula (I), is bonded to M via at least one carbene bond with at least one ligand which, in the complexes of the general formula (I), is attached to M via noncarbene bonds.

8. An OLED comprising at least one heteroleptic complex according to any of claims 1 to 6.

9. An OLED comprising a heteroleptic complex according to any of claims 1 to 6, and at least one compound of the formula (X) 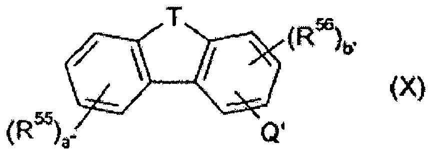 in which
T is NR⁵⁷, S, O or PR⁵⁷, preferably S or O, more preferably O;
R⁵⁷ is aryl, heteroaryl, alkyl, cycloalkyl or heterocycloalkyl;
Q' is -NR⁵⁸R⁵⁹, -P(O)R⁶⁰R⁶¹, -PR⁶²R⁶³, -S(O)₂R⁶⁴, -S(O)R⁶⁵, -SR⁶⁶ or -OR⁶⁷, preferably -NR⁵⁸R⁵⁹, more preferably 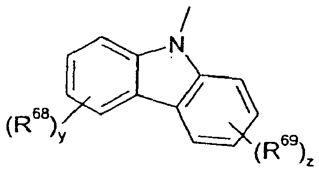 in which
R⁶⁸, R⁶⁹ are each independently alkyl, cycloalkyl, heterocycloalkyl, aryl or heteroaryl; preferably methyl, carbazolyl, dibenzofuryl or dibenzothienyl;
y, z are each independently 0, 1, 2, 3 or 4, preferably 0 or 1;
R⁵⁵, R⁵⁶ are each independently alkyl, cycloalkyl, heterocycloalkyl, aryl, heteroaryl, SiR⁷⁰R⁷¹R⁷², a Q' group or a group having donor or acceptor action;
a'' is 0, 1, 2, 3 or 4;
b' is 0, 1, 2 or 3;
R⁵⁸, R⁵⁹ together with the nitrogen atom form a cyclic radical which has 3 to 10 ring atoms and may be unsubstituted or substituted by one or more substituents selected from alkyl, cycloalkyl, heterocycloalkyl, aryl, heteroaryl and a group having donor or acceptor action and/or may be fused to one or more further cyclic radicals having 3 to 10 ring atoms, where the fused radicals may be unsubstituted or substituted by one or more substituents selected from alkyl, cycloalkyl, heterocycloalkyl, aryl, heteroaryl and a group having donor or acceptor action;
R⁷⁰, R⁷¹, R⁷², R⁶⁰, R⁶¹, R⁶², R⁶³, R⁶⁴, R⁶⁵, R⁶⁶,R⁶⁷ are each independently aryl, heteroaryl, alkyl, cycloalkyl or heterocycloalkyl,
or
two units of the general formula (X) are bridged to one another via a linear or branched, saturated or unsaturated bridge optionally interrupted by at least one heteroatom, via a bond or via O.

10. The OLED according to claim 9, comprising at least one compound of the formula (XI) or (XI*) 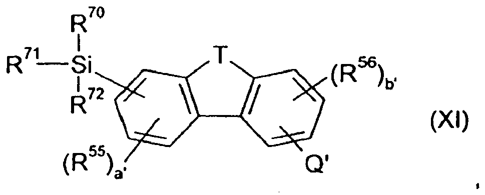 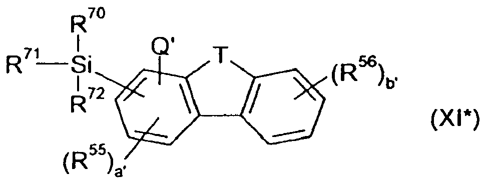 in which
T is NR⁵⁷, S, O or PR⁵⁷;
R⁵⁷ is aryl, heteroaryl, alkyl, cycloalkyl or heterocycloalkyl;
Q' is -NR⁵⁸R⁵⁹, -P(O)R⁶⁰R⁶¹, -PR⁶²R⁶³, -S(O)₂R⁶⁴, -S(O)R⁶⁵, -SR⁶⁶ or -OR⁶⁷;
R⁷⁰, R⁷¹, R⁷² are each independently aryl, heteroaryl, alkyl, cycloalkyl, heterocycloalkyl, where at least one of the R⁷⁰, R⁷¹, R⁷² radicals comprises at least two carbon atoms, or OR⁷³;
R⁵⁵, R⁵⁶ are each independently alkyl, cycloalkyl, heterocycloalkyl, aryl, heteroaryl, a Q group or a group having donor or acceptor action;
a', b' for the compound of the formula (XI) : are each independently 0, 1, 2, 3; for the compound of the formula (XI*), a' is 0, 1, 2 and b' is 0, 1, 2, 3, 4;
R⁵⁸, R⁵⁹ together with the nitrogen atom form a cyclic radical which has 3 to 10 ring atoms and may be unsubstituted or substituted by one or more substituents selected from alkyl, cycloalkyl, heterocycloalkyl, aryl, heteroaryl and a group having donor or acceptor action and/or may be fused to one or more further cyclic radicals having 3 to 10 ring atoms, where the fused radicals may be unsubstituted or substituted by one or more substituents selected from alkyl, cycloalkyl, heterocycloalkyl, aryl, heteroaryl and a group having donor or acceptor action;
R⁷³ is independently SiR⁷⁴R⁷⁵R⁷⁶, aryl, heteroaryl, alkyl, cycloalkyl or heterocycloalkyl, optionally substituted by an OR⁷⁷ group,
R⁷⁷ is independently SiR⁷⁴R⁷⁵R⁷⁶, aryl, heteroaryl, alkyl, cycloalkyl or heterocycloalkyl,
R⁶⁰, R⁶¹, R⁶², R⁶³, R⁶⁴, R⁶⁵, R⁶⁶, R⁶⁷, R⁷⁴, R⁷⁵, R⁷⁶ are each independently aryl, heteroaryl, alkyl, cycloalkyl or heterocycloalkyl,
or
two units of the general formulae (XI) and/or (XI*) are bridged to one another via a linear or branched, saturated or unsaturated bridge optionally interrupted by at least one heteroatom or via O, where this bridge in the general formulae (XI) and/or (XI*) is attached to the silicon atoms in place of R⁷¹ in each case.

11. The OLED according to claim 10, wherein R⁷⁰ and/or R⁷¹ and/or R⁷² in the compounds of the general formulae (XI) or (XI*) are aromatic units of the general formulae (XIi) and/or (XIi*) 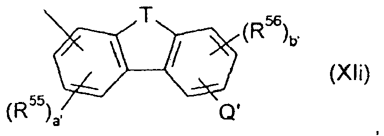 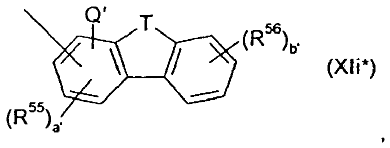 where R⁵⁵, R⁵⁶, Q', T, a' and b' are each as defined in claim 12.

12. A light-emitting layer comprising at least one heteroleptic complex according to any of claims 1 to 6.

13. An OLED comprising a light-emitting layer according to claim 12.

14. The OLED according to any of claims 8 to 11 or 13, which comprises an electron-transporting layer comprising at least two different materials, of which at least one material is electron-conductive.

15. The OLED according to claim 14, wherein the electron-transporting layer comprises at least one phenanthroline derivative.

16. The OLED according to claim 15, wherein the electron-transporting layer comprises at least one phenanthroline derivative and at least one alkali metal hydroxyquinolate complex.

17. A device selected from the group consisting of illuminating elements, stationary visual display units and mobile visual display units, comprising at least one OLED according to any of claims 8 to 11 or 13 to 16.

18. The use of a heteroleptic complex according to any of claims 1 to 6 in OLEDs.

19. The use according to claim 18, wherein the heteroleptic complexes are used as emitter, matrix material, charge transport material and/or charge blocker.

## Revendications

1. Complexes hétéroleptiques de formule générale (I) 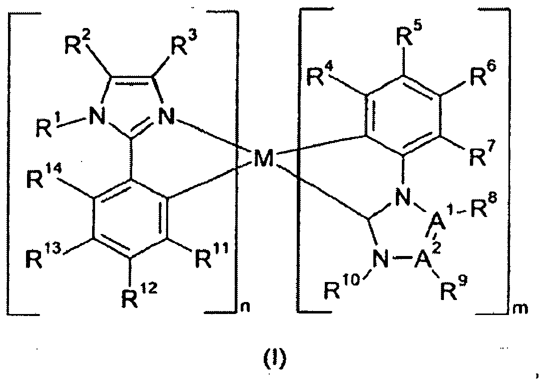 dans laquelle M, A¹, A², n, m, R¹, R², R³, R⁴, R⁵, R⁶, R⁷, R⁸, R⁹, R¹⁰, R¹¹, R¹², R¹³ et R¹⁴ ont les significations suivantes :
M Ir,
A¹, A² C,
n, m indépendamment l'un de l'autre 1 ou 2, la somme de n et m étant de 3,
R¹ radical alkyle linéaire ou ramifié de 1 à 20 atomes de carbone, radical aryle substitué ou non substitué de 6 à 30 atomes de carbone, radical hétéroaryle substitué ou non substitué de 5 à 18 atomes de carbone et/ou hétéroatomes,
R², R³ indépendamment l'un de l'autre hydrogène,
radical alkyle linéaire ou ramifié de 1 à 20 atomes de carbone, radical aryle substitué ou non substitué de 6 à 30 atomes de carbone, radical hétéroaryle substitué ou non substitué de 5 à 18 atomes de carbone et/ou hétéroatomes,
R⁴, R⁵
R⁶, R⁷ hydrogène
et
R⁴ et R⁵ ou R⁵ et R⁶ ou R⁶ et R⁷ forment ensemble un
cycle de formule générale (IIa) ou (IIb) 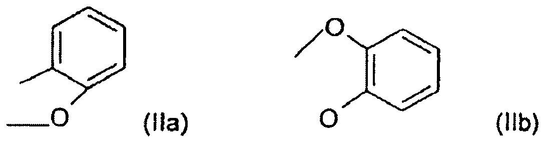
R⁸, R⁹ hydrogène,
R¹⁰ radical alkyle linéaire ou ramifié de 1 à 20 atomes de carbone, radical aryle substitué ou non substitué de 6 à 30 atomes de carbone, et
R¹¹, R¹²
R¹³, R¹⁴ indépendamment les uns des autres hydrogène ou
radical alkyle linéaire ou ramifié de 1 à 20 atomes de carbone,
et/ou
R¹ et R¹⁴ forment ensemble un pont saturé ou insaturé,
linéaire ou ramifié, contenant éventuellement des hétéroatomes, des unités aromatiques, des unités hétéroaromatiques et/ou des groupes fonctionnels, contenant au total 1 à 30 atomes de carbone et/ou hétéroatomes, auquel un cycle substitué ou non substitué, de cinq à huit éléments, contenant des atomes de carbone et/ou des hétéroatomes, de préférence un cycle aromatique à six éléments, est éventuellement annelé,
et/ou
R⁷ et R⁸ forment ensemble un pont saturé ou insaturé, linéaire ou ramifié, contenant éventuellement des hétéroatomes, des unités aromatiques, des unités hétéroaromatiques et/ou des groupes fonctionnels, contenant au total 1 à 30 atomes de carbone et/ou hétéroatomes, auquel un cycle substitué ou non substitué, de cinq à huit éléments, contenant des atomes de carbone et/ou des hétéroatomes, de préférence un cycle aromatique à six éléments, est éventuellement annelé.

2. Complexes hétéroleptiques de formule générale (I) 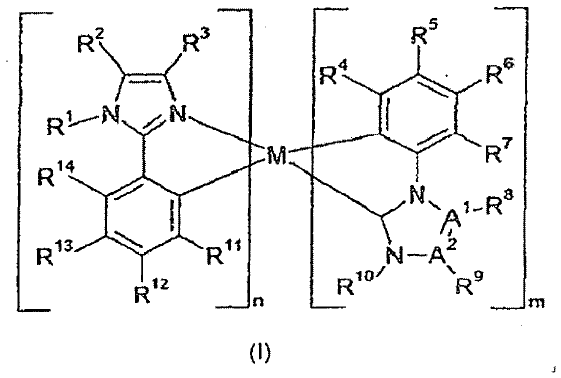 dans laquelle M, A¹, A², n, m, R¹, R², R³, R⁴, R⁵, R⁶, R⁷, R⁸, R⁹, R¹⁰, R¹¹, R¹², R¹³ et R¹⁴ ont les significations suivantes :
M Ir,
A¹ = N et A² = C,
n, m indépendamment l'un de l'autre 1 ou 2, la somme de n et m étant de 3,
R¹ radical alkyle linéaire ou ramifié de 1 à 20 atomes de carbone, radical aryle substitué ou non substitué de 6 à 30 atomes de carbone, radical hétéroaryle substitué ou non substitué de 5 à 18 atomes de carbone et/ou hétéroatomes,
R², R³ indépendamment l'un de l'autre hydrogène, radical alkyle linéaire ou ramifié de 1 à 20 atomes de carbone, radical aryle substitué ou non substitué de 6 à 30 atomes de carbone, radical hétéroaryle substitué ou non substitué de 5 à 18 atomes de carbone et/ou hétéroatomes,
R⁴, R⁵
R⁶, R⁷ hydrogène
ou
R⁴ et R⁵ ou R⁵ et R⁶ ou R⁶ et R⁷ forment ensemble un cycle saturé, insaturé ou aromatique, éventuellement interrompu par au moins un hétéroatome, contenant au total 5 à 30 atomes de carbone et/ou hétéroatomes,
R⁸ paire d'électron libre,
R⁹ hydrogène, radical alkyle linéaire ou ramifié de 1 à 20 atomes de carbone, radical aryle substitué ou non substitué de 6 à 30 atomes de carbone, radical hétéroaryle substitué ou non substitué de 5 à 18 atomes de carbone et/ou hétéroatomes,
R¹⁰ radical alkyle linéaire ou ramifié de 1 à 20 atomes de carbone, radical aryle substitué ou non substitué de 6 à 30 atomes de carbone, et
R¹¹, R¹²
R¹³, R¹⁴ hydrogène ou radical alkyle linéaire ou ramifié de 1 à 20 atomes de carbone,
et/ou
R¹ et R¹⁴ forment ensemble un pont saturé ou insaturé, linéaire ou ramifié, contenant éventuellement des hétéroatomes, des unités aromatiques, des unités hétéroaromatiques et/ou des groupes fonctionnels, contenant au total 1 à 30 atomes de carbone et/ou hétéroatomes, auquel un cycle substitué ou non substitué, de cinq à huit éléments, contenant des atomes de carbone et/ou des hétéroatomes, de préférence un cycle aromatique à six éléments, est éventuellement annelé.

3. Complexe hétéroleptique selon la revendication 1 ou 2, **caractérisé en ce que** R¹ est un radical aryle de 6 à 30 atomes de carbone, qui est substitué en position ortho,ortho' à chaque fois avec un radical alkyle linéaire ou ramifié de 1 à 10 atomes de carbone.

4. Complexe hétéroleptique selon l'une quelconque des revendications 1 à 3, **caractérisé en ce que** R¹ et R¹⁴ forment ensemble un pont saturé ou insaturé, linéaire ou ramifié, contenant éventuellement des hétéroatomes, des unités aromatiques, des unités hétéroaromatiques et/ou des groupes fonctionnels, contenant au total 1 à 30 atomes de carbone et/ou hétéroatomes, auquel un cycle substitué ou non substitué, de cinq à huit éléments, contenant des atomes de carbone et/ou des hétéroatomes, de préférence un cycle aromatique à six éléments, est éventuellement annelé.

5. Complexe hétéroleptique selon la revendication 2 ou 3, **caractérisé en ce que** R⁴ et R⁵, R⁵ et R⁶ ou R⁶ et R⁷ forment ensemble un cycle de formule générale (IIa) ou (IIb)

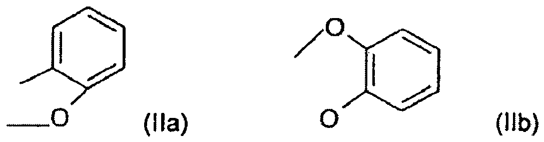

6. Complexe hétéroleptique selon l'une quelconque des revendications 1 à 5, ayant les significations indiquées pour M, A¹, A², n, m, R¹, R², R³, R⁴, R⁵, R⁶, R⁷, R⁸, R⁹, R¹⁰, R¹¹, R¹², R¹³ et R¹⁴, **caractérisé en ce qu'**il présente une des configurations IIIa, IIIb, IVa ou IVb suivantes : 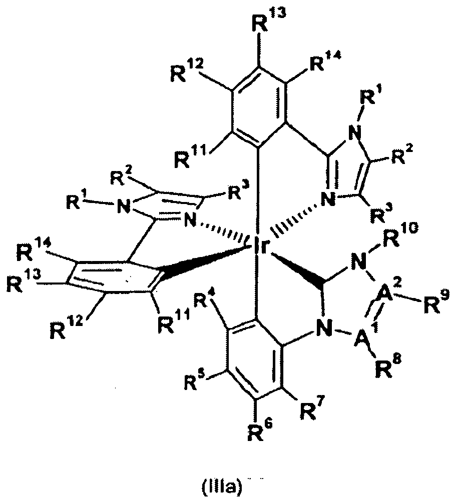 ou 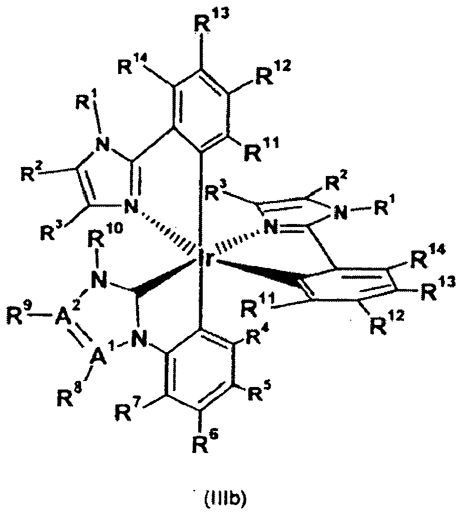 ou 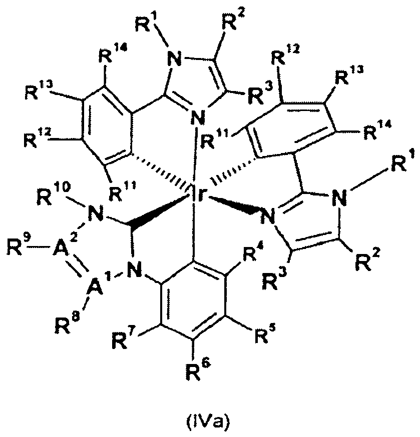 ou

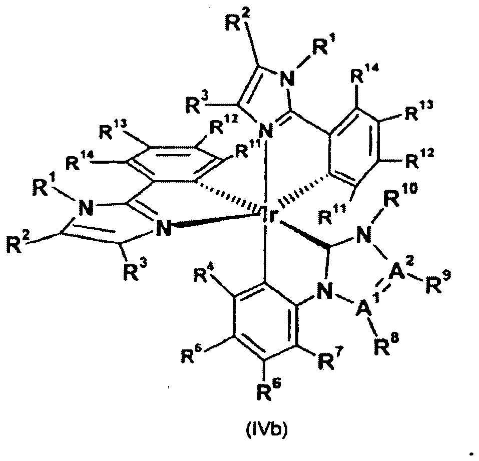

7. Procédé de fabrication d'un complexe hétéroleptique selon l'une quelconque des revendications 1 à 6, par
mise en contact d'au moins un composé précurseur, contenant le métal M et ledit au moins un ligand, qui dans les complexes de formule générale (I) est relié à M par des liaisons non-carbène, avec au moins un ligand qui dans les complexes de formule générale (I) est relié à M par au moins une liaison carbène, ou son précurseur de ligand tel que p. ex. un sel d'imidazolium correspondant,
ou
mise en contact d'au moins un composé précurseur, contenant le métal M et un ligand, qui dans les complexes de formule générale (I) est relié à M par au moins une liaison carbène, avec au moins un ligand qui dans les complexes de formule générale (I) est relié à M par des liaisons non-carbène.

8. OLED, contenant au moins un complexe hétéroleptique selon l'une quelconque des revendications 1 à 6.

9. OLED, contenant au moins un complexe hétéroleptique selon l'une quelconque des revendications 1 à 6, ainsi qu' au moins un composé de formule (X) 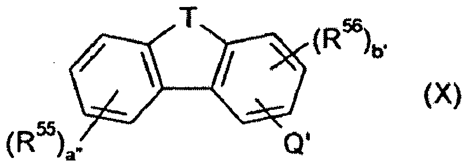 dans laquelle
T signifie NR⁵⁷, S, O ou PR⁵⁷, de préférence S ou O, de manière particulièrement préférée O ;
R⁵⁷ signifie aryle, hétéroaryle, alkyle, cycloalkyle ou hétérocycloalkyle ;
Q' signifie -NR⁵⁸R⁵⁹, -P(O)R⁶⁰R⁶¹, -PR⁶²R⁶³, -S(O)₂R⁶⁴, - S(O)R⁶⁵, -SR⁶⁶ ou -OR⁶⁷, de préférence -NR⁵⁸R⁵⁹ ; de manière particulièrement préférée 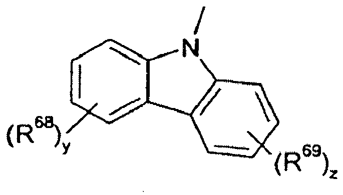
R⁶⁸, R⁶⁹ signifiant indépendamment l'un de l'autre alkyle, cycloalkyle, hétérocycloalkyle, aryle ou hétéroaryle ; de préférence méthyle, carbazolyle, dibenzofuryle ou dibenzothiényle ;
y, z signifiant indépendamment l'un de l'autre 0, 1, 2, 3 ou 4, de préférence 0 ou 1 ;
R⁵⁵, R⁵⁶ signifient indépendamment l'un de l'autre alkyle, cycloalkyle, hétérocycloalkyle, aryle, hétéroaryle, SiR⁷⁰R⁷¹R⁷², un groupe Q' ou un groupe à effet donneur ou accepteur ;
a'' signifie 0, 1, 2, 3 ou 4 ;
b' signifie 0, 1, 2 ou 3 ;
R⁵⁸, R⁵⁹ forment ensemble avec l'atome N un radical cyclique de 3 à 10 atomes de cycle, qui peut être non substitué ou substitué avec un ou plusieurs substituants choisis parmi alkyle, cycloalkyle, hétérocycloalkyle, aryle, hétéroaryle et un groupe à effet donneur ou accepteur, et/ou qui peut être annelé avec un ou plusieurs radicaux cycliques supplémentaires de 3 à 10 atomes de cycle, les radicaux annelés pouvant être non substitués ou substitués avec un ou plusieurs substituants choisis parmi alkyle, cycloalkyle, hétérocycloalkyle, aryle, hétéroaryle et un groupe à effet donneur ou accepteur ;
R⁷⁰, R⁷¹, R⁷², R⁶⁰, R⁶¹, R⁶², R⁶³, R⁶⁴, R⁶⁵, R⁶⁶, R⁶⁷ signifient indépendamment les uns des autres aryle, hétéroaryle, alkyle, cycloalkyle ou hétérocycloalkyle,
ou
deux unités de formule générale (X) sont pontées l'une avec l'autre par un pont linéaire ou ramifié, saturé ou insaturé, éventuellement interrompu par au moins un hétéroatome, par une liaison ou par O.

10. OLED selon la revendication 9, contenant au moins un composé de formule (XI) ou (XI*) 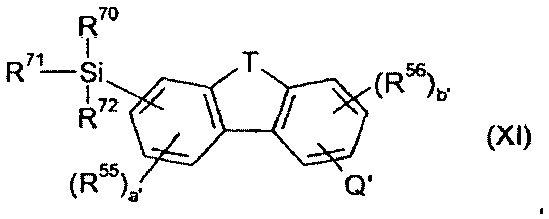 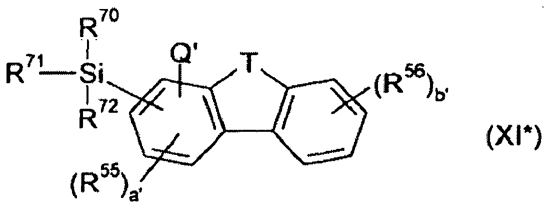 dans lesquelles
T signifie NR⁵⁷, S, O ou PR⁵⁷ ;
R⁵⁷ signifie aryle, hétéroaryle, alkyle, cycloalkyle ou hétérocycloalkyle ;
Q' signifie -NR⁵⁸R⁵⁹, P(O)R⁶⁰R⁶¹, PR⁶²R⁶³, -S(O)₂R⁶⁴,-S(O)R⁶⁵, -SR⁶⁶ ou -OR⁶⁷ ;
R⁷⁰, R⁷¹, R⁷² signifient indépendamment les uns des autres aryle, hétéroaryle, alkyle, cycloalkyle, hétérocycloalkyle, au moins un des radicaux R⁷⁰, R⁷¹, R⁷² contenant au moins deux atomes de carbone, ou OR⁷³,
R⁵⁵, R⁵⁶ signifient indépendamment l'un de l'autre alkyle, cycloalkyle, hétérocycloalkyle, aryle, hétéroaryle, un groupe Q ou un groupe à effet donneur ou accepteur ;
a', b' signifient pour le composé de formule (XI) : indépendamment l'un de l'autre 0, 1, 2, 3 ; pour le composé de formule (XI*), a' signifie 0, 1, 2 et b' signifie 0, 1, 2, 3, 4 ;
R⁵⁸, R⁵⁹ forment ensemble avec l'atome N un radical cyclique de 3 à 10 atomes de cycle, qui peut être non substitué ou substitué avec un ou plusieurs substituants choisis parmi alkyle, cycloalkyle, hétérocycloalkyle, aryle, hétéroaryle et un groupe à effet donneur ou accepteur, et/ou qui peut être annelé avec un ou plusieurs radicaux cycliques supplémentaires de 3 à 10 atomes de cycle, les radicaux annelés pouvant être non substitués ou substitués avec un ou plusieurs substituants choisis parmi alkyle, cycloalkyle, hétérocycloalkyle, aryle, hétéroaryle et un groupe à effet donneur ou accepteur ;
R⁷³ indépendamment les uns des autres SiR⁷⁴R⁷⁵R⁷⁶, aryle, hétéroaryle, alkyle, cycloalkyle ou hétérocycloalkyle, éventuellement substitué avec un groupe OR⁷⁷,
R⁷⁷ indépendamment les uns des autres SiR⁷⁴R⁷⁵R⁷⁶, aryle, hétéroaryle, alkyle, cycloalkyle ou hétérocycloalkyle,
R⁶⁰, R⁶¹, R⁶², R⁶³, R⁶⁴, R⁶⁵, R⁶⁶, R⁶⁷, R⁷⁴, R⁷⁵, R⁷⁶ signifient indépendamment les uns des autres aryle, hétéroaryle, alkyle, cycloalkyle ou hétérocycloalkyle
ou
deux unités de formule générale (XI) et/ou (XI*) sont pontées l'une avec l'autre par un pont linéaire ou ramifié, saturé ou insaturé, éventuellement interrompu par au moins un hétéroatome ou par O, ce pont étant à chaque fois- relié aux atomes Si au lieu de R⁷¹ dans les formules générales (XI) et/ou (XI*).

11. OLED selon la revendication 10, **caractérisée en ce que**, dans les composés de formule générale (XI) ou (XI*), R⁷⁰ et/ou R⁷¹ et/ou R⁷² signifient des unités aromatiques de formule générale (XIi) et/ou (XIi*) 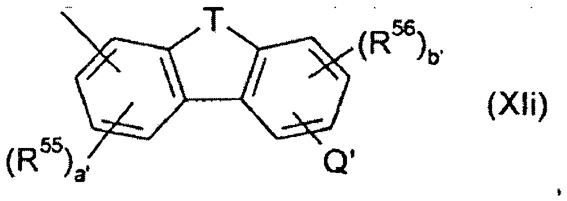 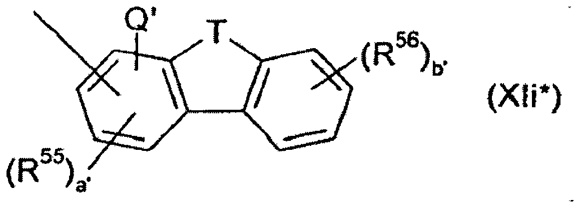 dans lesquelles R⁵⁵, R⁵⁶, Q', T, a' et b' ont les mêmes significations que dans la revendication 12.

12. Couche électroluminescente, contenant au moins un complexe hétéroleptique selon l'une quelconque des revendications 1 à 6.

13. OLED, contenant une couche électroluminescente selon la revendication 12.

14. OLED selon l'une quelconque des revendications 8 à 11 ou 13, **caractérisée en ce qu'**elle contient une couche de transport d'électrons contenant au moins deux matériaux différents, parmi lesquels au moins un matériau est conducteur d'électrons.

15. OLED selon la revendication 14, **caractérisée en ce que** la couche de transport d'électrons contient au moins un dérivé de phénanthroline.

16. OLED selon la revendication 15, **caractérisée en ce que** la couche de transport d'électrons contient au moins un dérivé de phénanthroline et au moins un complexe métal alcalin-hydroxyquinolate.

17. Dispositif choisi dans le groupe constitué par les éléments d'éclairage, les écrans stationnaires et les écrans mobiles, contenant au moins une OLED selon l'une quelconque des revendications 8 à 11 ou 13 à 16.

18. Utilisation d'un complexe hétéroleptique selon l'une quelconque des revendications 1 à 6 dans des OLED.

19. Utilisation selon la revendication 18, **caractérisée en ce que** les complexes hétéroleptiques sont utilisés en tant qu'émetteur, matériau de matrice, matériau de transport de charges et/ou bloqueur de charges.
